# EUROPEAN PATENT SPECIFICATION

(11) **EP 4 106 027 B1**
(45) Date of publication and mention of the grant of the patent: **31.12.2025**
(21) Application number: 21180349.9
(22) Date of filing: 18.06.2021
(51) Int. Cl.: H10K 50/155, H10K 50/15, H10K 71/30, H10K 85/60

(54) **ACTIVE-MATRIX OLED DISPLAY**
OLED-ANZEIGE MIT AKTIVER MATRIX
ÉCRAN DELO À MATRICE ACTIVE

(43) Date of publication of application: 21.12.2022
(73) Proprietor: Novaled GmbH, 01099 Dresden (DE)
(72) Inventor: Langguth, Oliver, 01099 Dresden (DE); Rosenow, Thomas, 01099 Dresden (DE); Runge, Steffen, 01099 Dresden (DE); Schulze, Benjamin, 01099 Dresden (DE); Nüllen, Max, 01099 Dresden (DE); Wudarczyk, Jakob, 01099 Dresden (DE)
(74) Representative: Michalski Hüttermann & Partner Patentanwälte mbB

(56) References cited:
- EP-A1- 3 364 476
- US-A1- 2005 121 667
- US-A1- 2017 222 170
- US-A1- 2017 373 251

## Description

### Technical Field

The present invention relates to an active OLED display having a plurality of OLED pixels, and a method for manufacturing at least one common layer.

### Background Art

Since 1987, when low operating voltages have been demonstrated by Tang et al. (C. W. Tang et al. Appl. Phys. Lett. 51 (12) 913 (1987)), organic light-emitting diodes have been promising candidates for the realization of large-area displays. They consist of a sequence of thin (typically 1 nm to 1 µm) layers of organic materials, which can be deposited, for example, by thermal vacuum evaporation or solution processing, followed by formation of the electrical contacts through metallic layers. Organic electrical devices offer a great variety of electronic or optoelectronic components, such as diodes, light-emitting diodes, photodiodes and thin film transistors (TFT), which, in terms of properties, compete with established components based on inorganic materials.

US 2017/222170 A1 refers to an active OLED display, comprising a plurality of OLED pixels, each of the OLED pixels comprising an anode, a cathode, and a stack of organic layers, wherein the stack of organic layers is provided between and in contact with the cathode and the anode and comprises an electron transport layer, a hole transport layer, and a light emitting layer provided between the hole transport layer and the electron transport layer, and a driving circuit configured to separately driving the pixels of the plurality of OLED pixels, wherein, for the plurality of OLED pixels, a common hole transport layer is formed by the hole transport layers provided in the stack of organic layers of the plurality of OLED pixels, the common hole transport layer comprising a hole transport matrix material and at least one electrical p-dopant, and the electrical conductivity of the hole transport material being lower than 1×10⁻³ S·m⁻¹ and higher than 1×10⁻⁸ S·m⁻¹.

EP 3364 476 A1 refers to a display device comprising - a plurality of OLED pixels comprising at least two OLED pixels, the OLED pixels comprising an anode, a cathode, and a stack of organic layers, wherein the stack of organic layers - is arranged between and in contact with the cathode and the anode, and - comprises a first electron transport layer, a first hole transport layer, and a first light emitting layer provided between the first hole transport layer and the first electron transport layer, and - a driving circuit configured to separately driving the pixels of the plurality of OLED pixels, wherein, for the plurality of OLED pixels, the first hole transport layer is provided in the stack of organic layers as a common hole transport layer shared by the plurality of OLED pixels, and the first hole transport layer comprises (i) at least one first hole transport matrix compound consisting of covalently bound atoms and (ii) at least one electrical p-dopant selected from metal salts and from electrically neutral metal complexes comprising a metal cation and at least one anion and/or at least one anionic ligand consisting of at least 4 covalently bound atoms, wherein the metal cation of the electrical p-dopant is selected from alkali metals; alkaline earth metals, Pb, Mn, Fe, Co, Ni, Zn, Cd; rare earth metals in oxidation state (II) or (III); Al, Ga, In; and from Sn, Ti, Zr, Hf, V, Nb, Ta, Cr, Mo and W in oxidation state (IV) or less, a method for preparing the display device and a chemical compound for use therein.

In the case of organic light-emitting diodes (OLEDs), light is produced and emitted by the light-emitting diode through the injection of charge carriers (electrons from one side, holes from another side) from the contacts into adjacent organic layers as a result of an externally applied voltage, subsequent formation of excitons (electron-hole pairs) in an active zone, and radiative recombination of these excitons.

The advantage of such organic components over conventional inorganic components (based on inorganic semiconductors such as silicon or gallium arsenide) is the option to produce large-area elements, e.g. large display elements (visual displays, screens) or lamps (for lighting applications). Organic materials, compared to inorganic materials, are relatively inexpensive (less expenditure of material and energy). Moreover, these materials, because of their low processing temperature compared to inorganic materials, can be deposited on flexible substrates, thereby opening up a whole series of new applications in display and illuminating engineering. The basic construction of such a component includes an arrangement of one or more of the following layers: Carrier substrate; hole-injecting (positive contact) base electrode which is usually transparent; hole-injecting layer (HIL); hole-transporting layer (HTL); light-emitting layer (EL); electron-transporting layer (ETL); electron-injecting layer (EIL); electron- injecting (negative contact) cover electrode, usually a metal with low work function; and encapsulation, to exclude ambient influences.

While the foregoing represents the most typical case, often several layers may be (with the exception of HTL and ETL) omitted, or else one layer may combine several properties.

The use of doped charge-carrier transport layers (p-doping of the HTL by admixture of acceptor-like molecules, n-doping of the ETL by admixture of donor-like molecules) is described in document US 5,093,698. Doping in this sense means that the admixture of doping substances into the layer increases the equilibrium charge-carrier concentration in this layer, compared to the pure layers of one of the two substances concerned, which results in improved electrical conductivity and better charge-carrier injection from the adjacent contact layers into this mixed layer. The transport of charge carriers still takes place on the matrix molecules. According to US 5,093,698, the doped layers are used as injection layers at the interface to the contact materials, the light-emitting layer being found in between (or, when only one doped layer is used, next to the other contact). Equilibrium charge-carrier density, increased by doping, and associated band bending, facilitate charge-carrier injection. The energy levels of the organic layers (HOMO = highest occupied molecular orbital or highest energetic valence band energy; LUMO = lowest unoccupied molecular orbital or lowest energetic conduction band energy), according to US 5,093,698, should be obtained so that electrons in the ETL as well as holes in the HTL can be injected into the EL (emitting layer) without further barriers, which requires very high ionization energy of the HTL material and very low electron affinity of the ETL material.

With respect to active OLED displays, so-called crosstalk between pixels of the display has been a major problem. Pixel or colour crosstalk refers to photons of one colour generated by a pixel falsely mixing with photons of another colour scattered from a close pixel. For example, documents GB 2 492 400 A and WO 2002 / 015292 A2 provide measures for reducing colourcrosstalk in OLED devices. In addition, or as an alternative aspect, electrical crosstalk may occur. In this case, for example, a driving current applied to one of the pixels may cause light emission from another pixel close to the pixel for which the driving current is provided. Both will have a negative impact on the performance of the display device, (see Yamazaki et al., A. (2013), 33.2: Spatial Resolution Characteristics of Organic Light-emitting Diode Displays: A comparative Analysis of MTF for Handheld and Workstation Formats. SID Symposium Digest of Technical Papers, 44: 419-422. doi: 10.1002/j.2168-0159.2013.tb06236.x).

In a typical commercial active-matrix OLED display, electrical pixel cross talk may be caused by the application of redox p-doping in a hole transport layer (HTL) which is shared by more OLED pixels (in the sense that the shared HTL is electrically connected to anodes of a plurality of pixels present in the display). The use of redox p-dopants which increase charge carrier density by creation of new charge carriers (holes) by transfer of an electron from a molecule of the doped matrix to a dopant molecule is beneficial for low-operating voltage, high operational stability and high production yield. On the other hand, redox p-doping increases electrical conductivity of hole transport layers from less than 10⁻⁸ S/cm without p-dopant, usually from less than 10⁻¹⁰ S/cm, to more than 10⁻⁶ S/cm (typically, with concentrations of the p- dopant in the range between 1 and 5 wt.%). Therefore, redox-doped HTL is usually responsible for any electrical pixel cross talk in active matrix displays comprising a HTL shared by plurality of pixels. The ETL, if n-doped with redox n-dopants, might also show similarly high conductivity as the redox-doped HTL, however, due to display layout with a common cathode, the ETL does not cause electrical pixel cross talk.

### Disclosure

lt is an object to provide improved technologies for active-matrix OLED displays, in particular, cross talk between neighbor pixels of the active OLED display shall be reduced.

In one aspect, an active-matrix OLED display is provided, comprising a plurality of OLED pixels, wherein each pixel itself comprises a stack of organic layers and each layer of the stack of organic layers can form a common semiconductor layer, wherein at least a first OLED pixel and a second OLED pixel comprising
- an anode layer,
- a common cathode layer,
- at least one emission layer, which is optional a common emission layer,
- at least a stack of organic layers, wherein the stack of organic layers is arranged between the anode layer and cathode layer, comprising
- a plurality of semiconductor layers, and the plurality of semiconductor layers comprising at least two or more common semiconductor layers, wherein the plurality of semiconductor layers comprising
   - at least a common first semiconductor layer comprises at least one organic p-dopant,
   - at least a common second semiconductor layer,
   - a common third semiconductor layer,
   - a common semiconductor layer extends over all pixels of the plurality of pixels or extends over at least two pixels of the plurality of pixels in the OLED display,
   - wherein the common first semiconductor layer is a common hole injection layer,
   - wherein the common second semiconductor layer is a common hole transport layer,
   - wherein the common third semiconductor layer is a common electron blocking layer,
   - wherein the common hole injection layer is in direct contact with the common hole transport layer,
   - wherein the common electron blocking layer is in direct contact to the common hole transport layer,
- wherein the common second semiconductor layer has a layer thickness of ≥15 nm to ≤230 nm,
- wherein the common third semiconductor layer has a layer thickness of 1 nm to 20 nm,
and
wherein the common first semiconductor comprises at least one organic p-dopant, the common second semiconductor layer and the common third semiconductor layer have together a sheet resistance of ≥ 50 giga ohms per square, wherein the sheet resistance Rs is measured by transmission line method.

A property of organic semi-conducting devices is their conductivity. By using a hole injection material, the electrical conductivity of a layer of an organic semi-conducting device can be significantly increased. The sheet resistance is for example determined by the so called "transmission line method". At this, a voltage is applied to the thin layer and the current flowing through the layer is measured. The sheet resistance, respectively the electrical conductivity, results by considering the geometry of the contacts and the thickness of the layer of the sample.

The sheet resistance is determined by the transmission line method.

According to embodiment an active-matrix OLED display is provided, comprising a plurality of OLED pixels, wherein each pixel itself comprises a stack of organic layers and each layer of the stack of organic layers can form a common semiconductor layer, wherein at least a first OLED pixel and a second OLED pixel comprising
- an anode layer,
- a common cathode layer,
- at least one emission layer, which is optional a common emission layer,
- at least a stack of organic layers, wherein the stack of organic layers is arranged between the anode layer and cathode layer, comprising
- a plurality of semiconductor layers, and the plurality of semiconductor layers comprising at least two or more common semiconductor layers, wherein the plurality of semiconductor layers comprising
   - at least a common first semiconductor layer comprises at least one organic p-dopant,
   - at least a common second semiconductor layer,
   - a common semiconductor layer extends over all pixels of the plurality of pixels or extends over at least two pixels of the plurality of pixels in the OLED display, and
wherein the common first semiconductor comprises at least one organic p-dopant and the common second semiconductor layer have together a sheet resistance of ≥ 50 giga ohms per square, wherein the sheet resistance is determined by transmission line method.

### Transmission line method

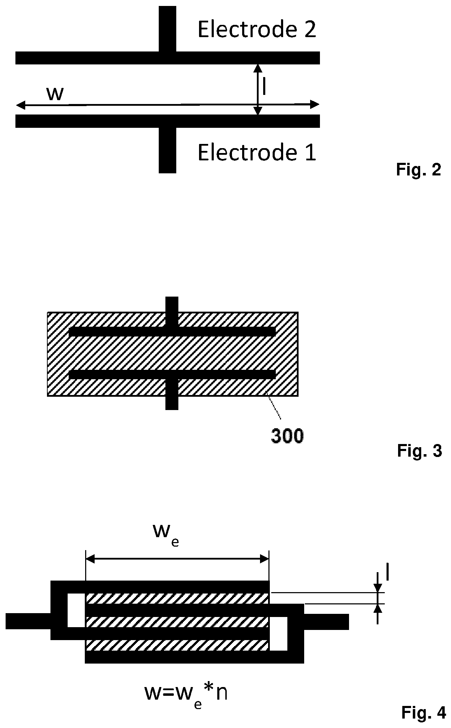

Sheet resistance Rs is measured for a given deposited layer stack on a test element group (see Figure 3) consisting of test elements called channel providing two highly conductive electrodes with gap "l" between each other and a width "w" of each (see Figure 2). To improve noise level large "w" may be used and electrodes formed in interdigitated finger structure for reduced area requirement (see Figure 4). At least three of such channels with different channel length "l" are needed for reliable Rs calculation.

The measurement is done in following way:
First voltage is swept between -5V to +5V with step size smaller than 1V and current is measured. Using a linear fit with current values on x-axis and voltage values on y-axis slope of the fit gives channel resistance "R". This procedure is repeated for each channel "n", resulting in an "Rn" for channel "n" with gap "ln" and width "w". For Rs calculation width "w" must be constant over all channels. Fit quality index R² must be larger than 0.9 for a reliable resistance value.

In the second step resistance "Rn" is plotted over channel with gap "ln" and linear fitted. Slope of this fit multiplied with channel width "w" gives sheet resistance Rs for deposited layer stack. This calculation removes influence of contact- and series resistance from measurement setup. Electrode gap should be close to target application gap, for example 20 µm, 40 µm, 60 µm. Channel width for low conductive layers might be 100000 µm.

The measurement is done on glass substrates (Corning Eagle XG) with ITO electrodes. After wet cleaning with water based tenside solution and drying by blowing with nitrogen followed by 200°C 120 minutes baking in nitrogen atmosphere substrates are conditioned with nitrogen plasma. After organic layer deposition before electrical measurement samples are encapsulated using encapsulation glass lids including a desiccant.

A common layer refers to layers deposited onto the complete display area through one large mask opening in one processing step and/or layers consisting of several overlapping areas deposited in several consecutive steps, even if the overlapping layers consists of different materials.

According to one embodiment the common first semiconductor comprises at least one organic p-dopant. According to one embodiment the common first semiconductor comprises at least one organic p-dopant, wherein the common first semiconductor is a hole injection layer.

### Organic p-dopant

In the present specification, when a definition is not otherwise provided, "organic p-dopant" refers to a organic compound capable of facilitating hole injection, i.e. positive charges injected from an anode preferably into an organic layer in particular a hole transport layer, and wherein said organic compound is capable of reducing the operational voltage at a certain current density if present.

The organic p-dopant may provide a hole injection from anodes into hole transport matrices, without substantially increasing the concentration of free charge carriers above the level which corresponds to conductivities observed in a neat matrix or may capable of increasing the density of positive charge carriers in a hole transport material or hole transport layer, when added to a semiconductor. The organic p-dopant can be used alone within a layer or in conjunction with a hole transport material or hole transport layer.

According to one embodiment of the active-matrix OLED display, the organic p-dopant may be selected from the group comprising a substituted or unsubstituted 3-radialene, a substituted or unsubstituted quinone, a substituted or unsubstituted quinoid, and a substituted or unsubstituted aromatic compound that comprises condensed rings, and more preferred the organic p-dopant is selected from substituted or unsubstituted 3-radialene compounds. Preferably, the organic p-dopant is an organic redox p-dopant.

The 3-radialene compound may be represented by Formula (1): 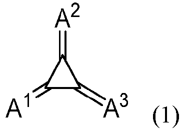 wherein A¹, A² and A³ are independently selected from Formula (2): 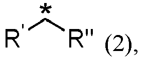 wherein "*" is the binding position of A¹, A² and A³ to the double bond of formula (1),
- R': is independently selected from the group comprising substituted or unsubstituted aryl, substituted or unsubstituted heteroaryl, substituted or unsubstituted alkyl, and preferably substituted or unsubstituted C₆ to C₂₄ aryl, substituted or unsubstituted C₂ to C₂₀ heteroaryl, substituted or unsubstituted C₁ to C₈ alkyl;
wherein the substituent on R' is independently selected from the group comprising electron-withdrawing group, CN, halogen, Cl, F, partially fluorinated or perfluorinated alkyl, partially fluorinated or perfluorinated alkoxy, and preferably partially fluorinated or perfluorinated C₁ to C₁₀ alkyl, partially fluorinated or perfluorinated C₁ to C₆ alkoxy, and more preferred CF₃, OCF₃, D or H;
- R'': is selected from the group comprising an electron-withdrawing group, preferably CN, substituted or unsubstituted alkyl, substituted or unsubstituted heteroaryl, substituted or unsubstituted aryl, perfluorinated alkyl, further preferred substituted or unsubstituted C₁ to C₈ alkyl, substituted or unsubstituted C₂ to C₂₀ heteroaryl, substituted or unsubstituted C₆ to C₂₄ aryl, perfluorinated C₁ to C₈ alkyl, and more preferred CF₃, NO₂ or F;
wherein the substituent on R'' is independently selected from the group comprising electron-withdrawing group, CN, halogen, Cl, F, partially fluorinated or perfluorinated alkyl, partially fluorinated or perfluorinated alkoxy, and preferably partially fluorinated or perfluorinated C₁ to C₁₀ alkyl, partially fluorinated or perfluorinated C₁ to C₆ alkoxy, and more preferred CF₃, OCF₃, D or H;
   wherein R' and R'' together optional form a substituted or unsubstituted carbocycle or substituted or unsubstituted heterocycle, preferably substituted or unsubstituted heterocycle;
wherein the substituents are independently selected from the group comprising electron-withdrawing group, F, CN, perfluorinated C₁ to C₈ alkyl, substituted or unsubstituted C₆ to C₁₈ aryl, substituted or unsubstituted C₂ to C₁₈ heteroaryl, substituted or unsubstituted C₃ to C₁₈ carbocyclene, substituted or unsubstituted C₃ to C₁₈ carbocyclidene, substituted or unsubstituted C₁ to C₈ alkylene, substituted or unsubstituted C₁ to C₈ alkylidene;
   wherein the substituents are selected from the group comprising an electron-withdrawing group, halogen, F, Cl, CN, perfluorinated alkyl, perfluorinated C₁ to C₈ alkyl, CF₃, partially fluorinated or perfluorinated alkylaryl, partially fluorinated or perfluorinated C₆ to C₁₈ alkylaryl.

According to one embodiment the substituents R' can be independently selected from the group comprising substituted or unsubstituted C₆ to C₂₄ aryl, substituted or unsubstituted C₂ to C₂₀ heteroaryl. According to one embodiment the substituents R'' can be selected from the group comprising an electron-withdrawing group, preferably R'' is independently selected from the group comprising CN, CF₃, NO₂, or F, and more preferred R'' is CN.

According to another embodiment wherein
- R': is independently selected from the group comprising substituted or unsubstituted C₆ to C₂₄ aryl, substituted or unsubstituted C₂ to C₂₀ heteroaryl;
- R": is an electron-withdrawing group, preferably R'' is independently selected from the group comprising CN, CF₃, NO₂, or F, and more preferred R'' is CN.

According to another embodiment wherein
- R': is independently selected from the group comprising substituted or unsubstituted C₆ to C₁₈ aryl, substituted or unsubstituted C₂ to C₁₈ heteroaryl;
- R": is independently selected from the group comprising CN, CF₃, NO₂, or F, and more preferred R" is CN. According to another embodiment wherein
- R': is independently selected from the group comprising substituted or unsubstituted C₆ to C₁₂ aryl, substituted or unsubstituted C₂ to C₁₂ heteroaryl;
- R": is independently selected from the group comprising CN, CF₃ or F, and more preferred R'' is CN.

According to another embodiment, wherein A¹, A² and A³ are selected A¹=A²≠A³, or A¹≠A² and A¹≠A³ and A² = A³.

According to another embodiment, wherein A¹, A² and A³ are selected from Formulae (3) or (4): 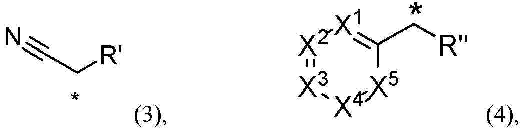 wherein
X¹ is selected from CR¹ or N;
X² is selected from CR² or N;
X³ is selected from CR³ or N;
X⁴ is selected from CR⁴ or N;
X⁵ is selected from CR⁵ or N;
R¹, R², R³, R⁴, and R⁵ are independently selected from a group comprising electron-withdrawing group, CN, halogen, Cl, F, partially fluorinated or perfluorinated alkyl, partially fluorinated or perfluorinated C₁ to C₁₀ alkyl, preferably CF₃, partially fluorinated or perfluorinated alkoxy, partially fluorinated or perfluorinated C₁ to C₆ alkoxy, D or H;
wherein at least two of X¹ to X⁵ are independently selected from CR¹ to CR⁵; and wherein "*"on Formulae (3) and (4) is the binding position of A¹, A² and A³ to the double bond of formula (1).

According to another embodiment, wherein A¹ is selected from Formulae (3) or (4): 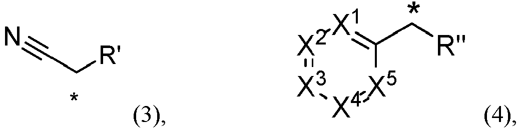 wherein
X¹ is selected from CR¹ or N;
X² is selected from CR² or N;
X³ is selected from CR³ or N;
X⁴ is selected from CR⁴ or N;
X⁵ is selected from CR⁵ or N;
R¹, R², R³, R⁴, and R⁵ are independently selected from a group comprising electron-withdrawing group, CN, halogen, Cl, F, partially fluorinated or perfluorinated alkyl, partially fluorinated or perfluorinated C₁ to C₁₀ alkyl, preferably CF₃, partially fluorinated or perfluorinated alkoxy, partially fluorinated or perfluorinated C₁ to C₆ alkoxy, D or H;
wherein at least two of X¹ to X⁵ are independently selected from CR¹ to CR⁵; and
wherein "*"on Formulae (3) and (4) is the binding position of A¹ to the double bond of formula (1).

According to another embodiment wherein A¹ may be selected from a group comprising of D1 toD210: 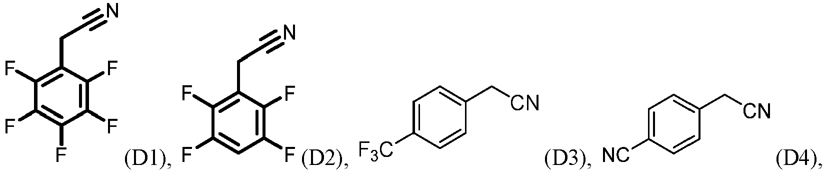 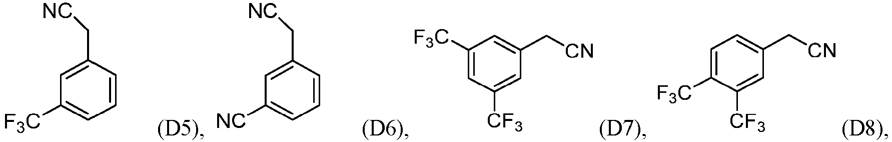 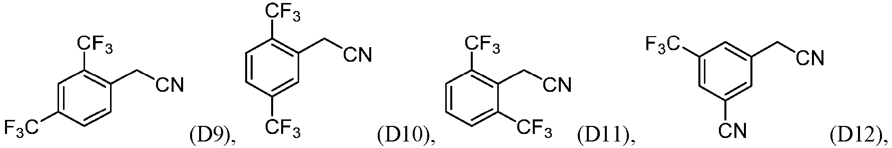 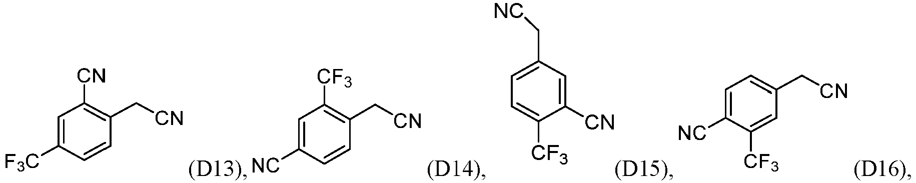 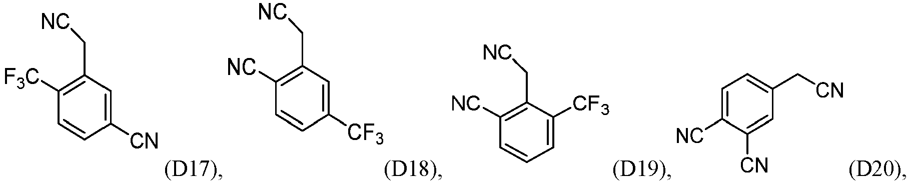 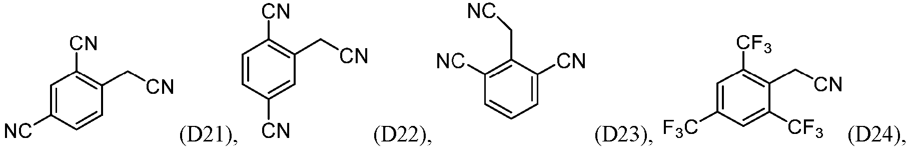 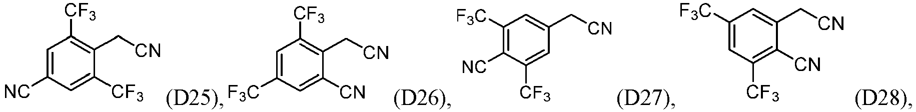 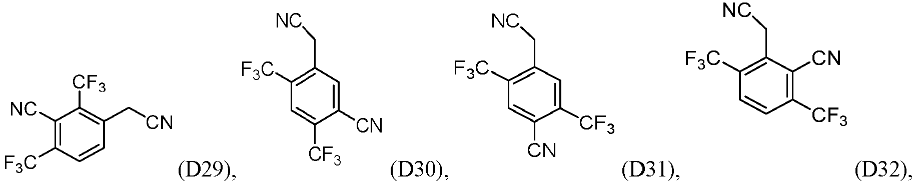 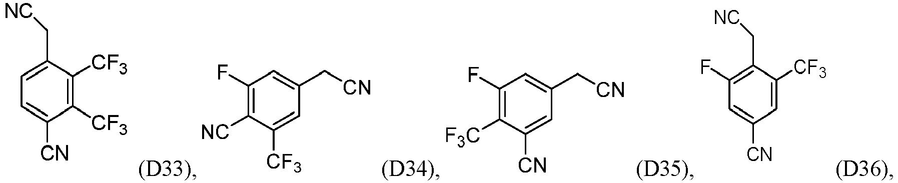 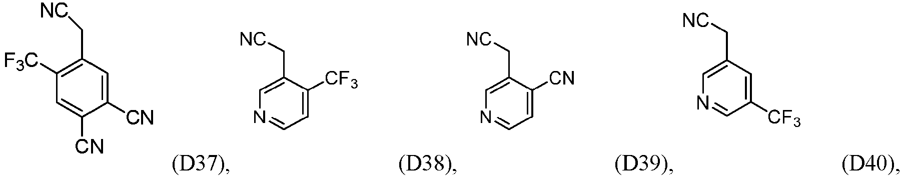 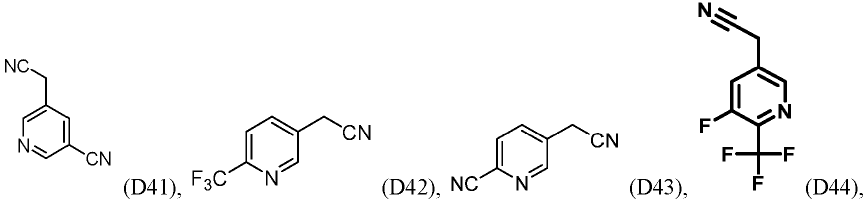 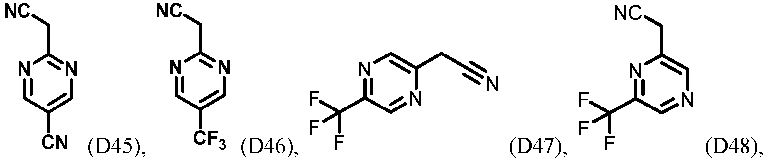 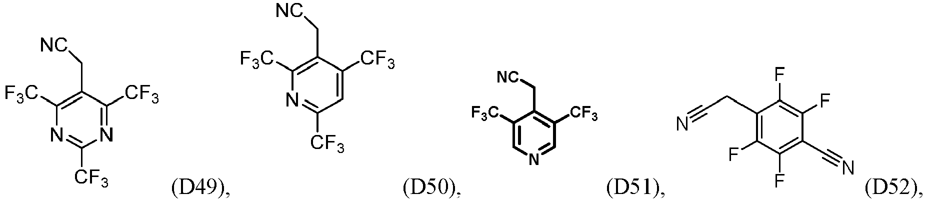 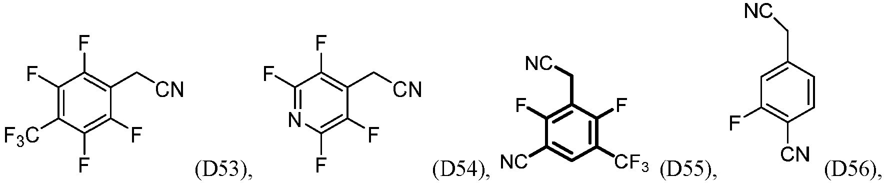 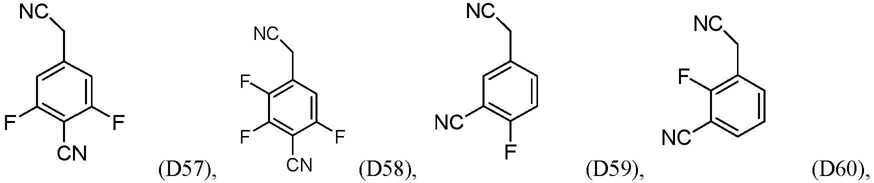 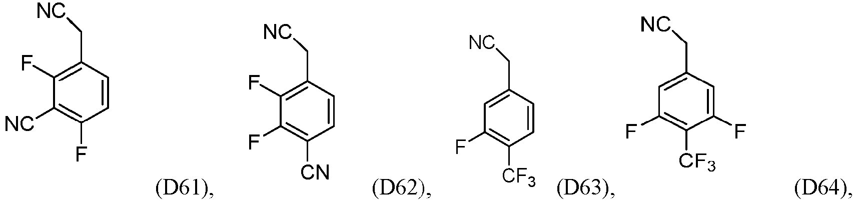 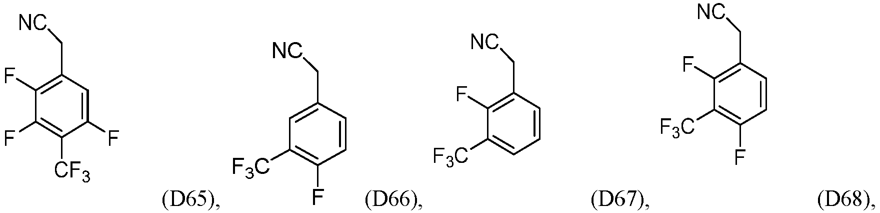 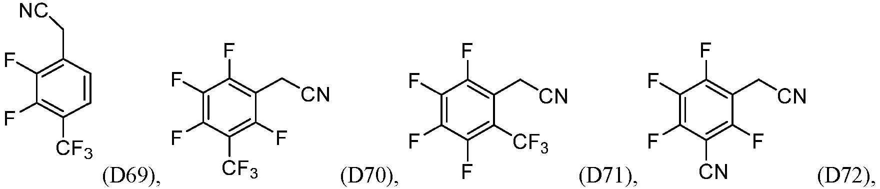 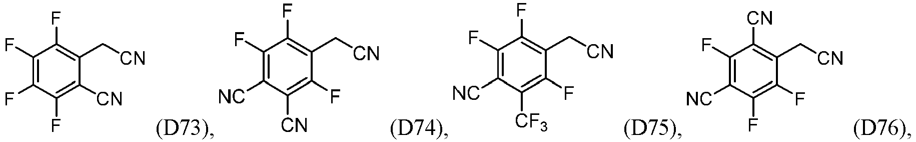 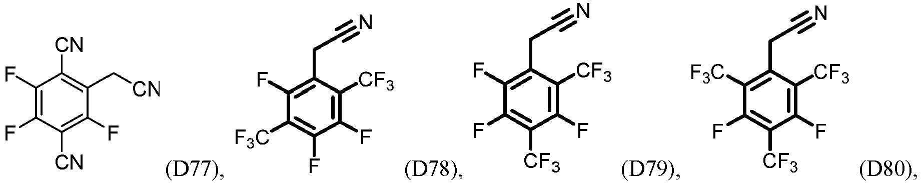 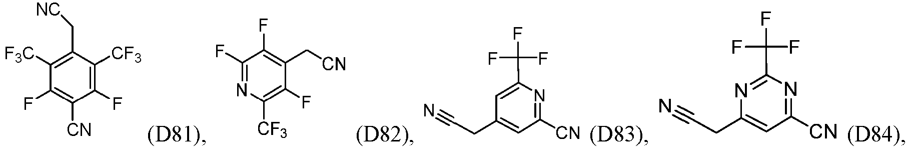 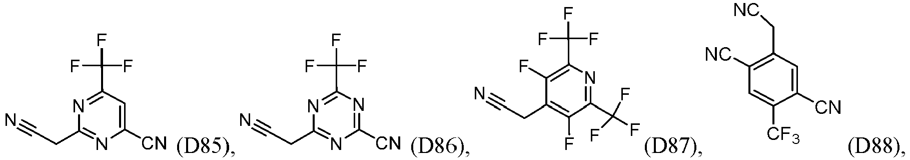 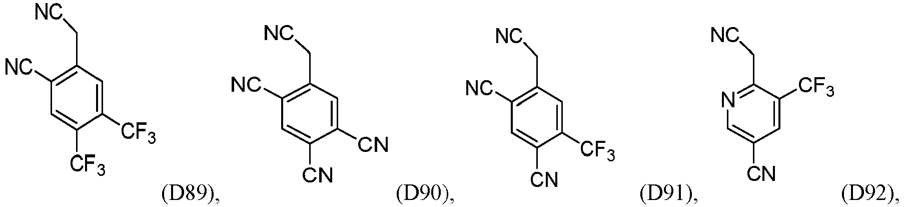 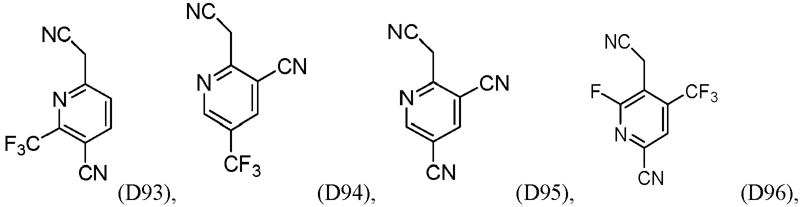 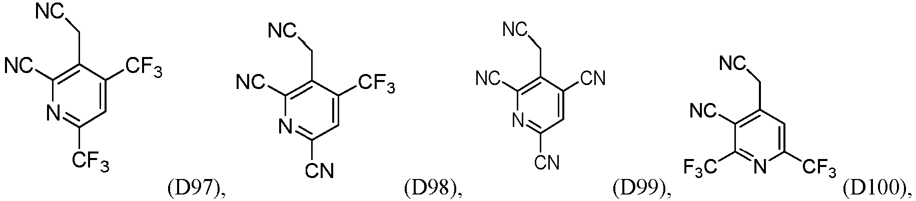 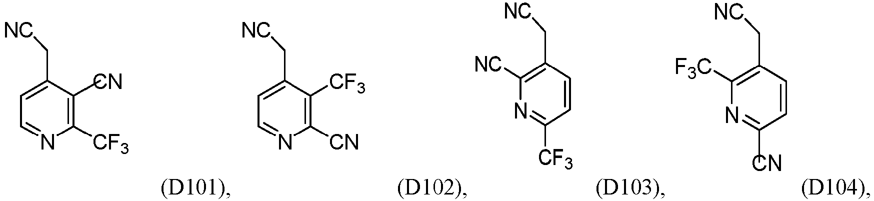 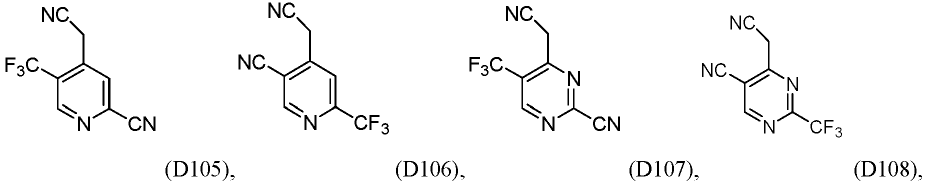 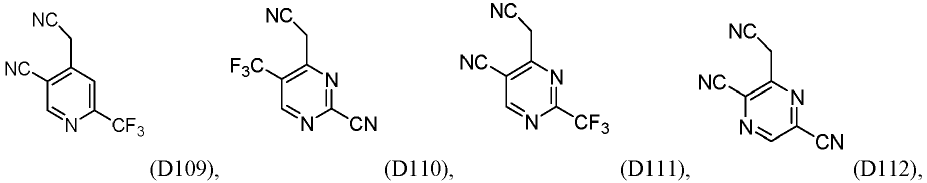 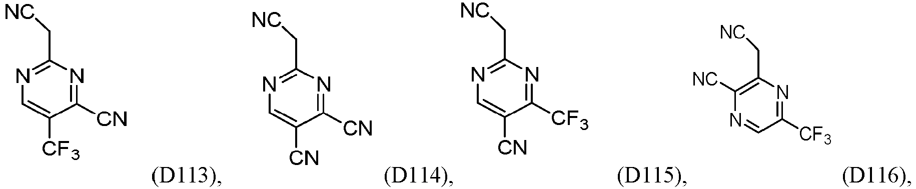 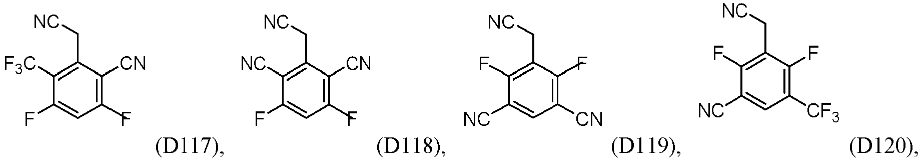 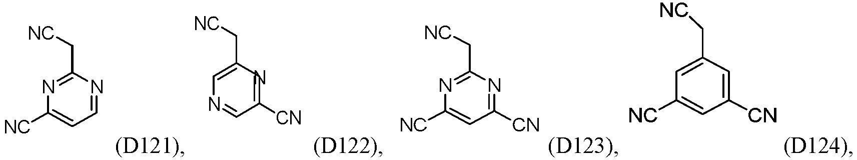 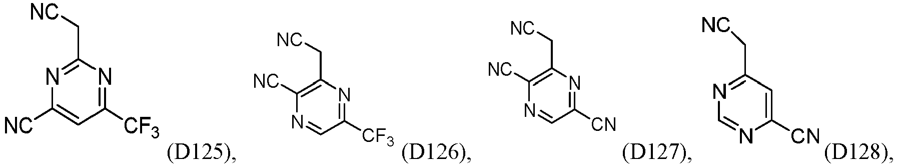 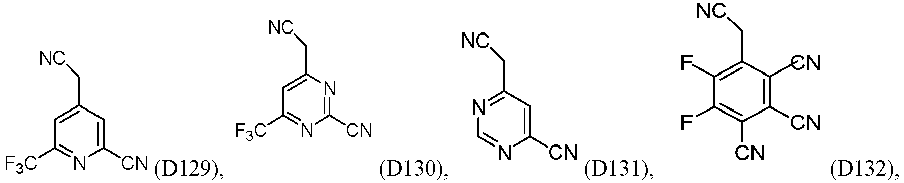 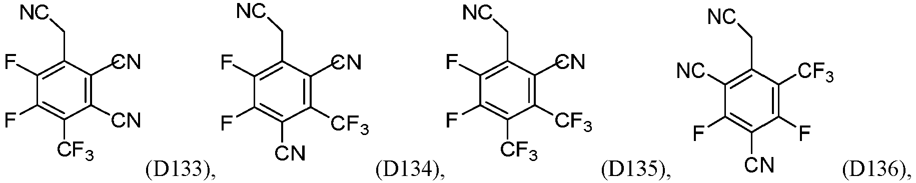 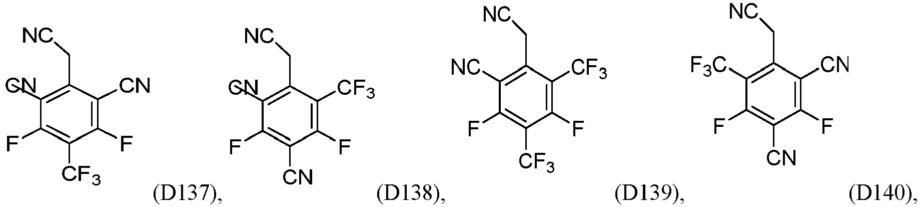 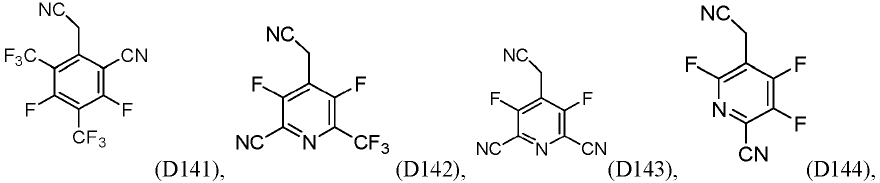 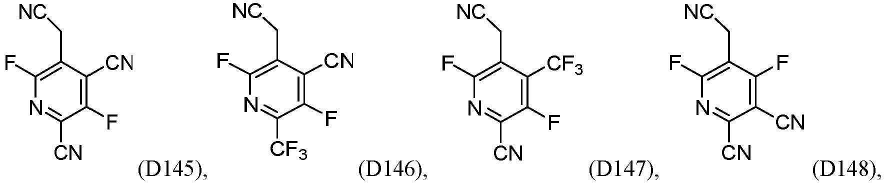 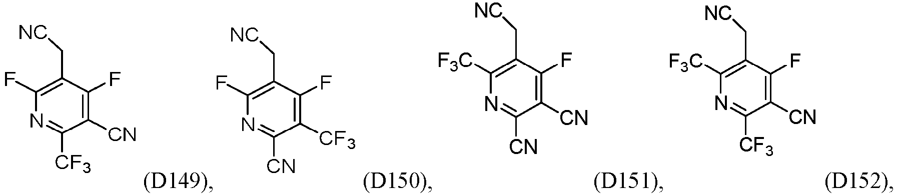 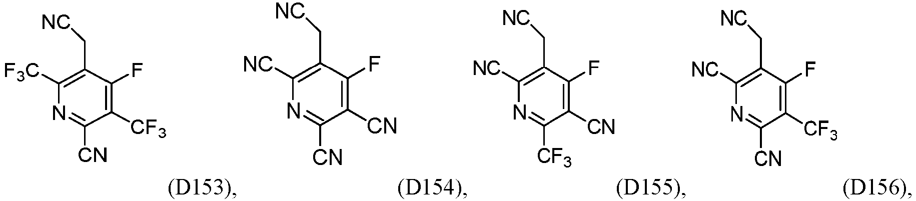 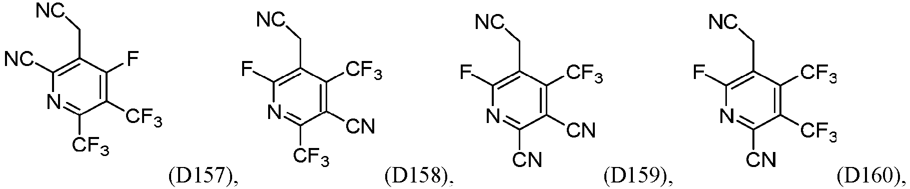 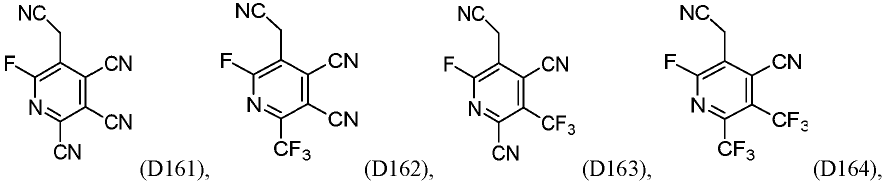 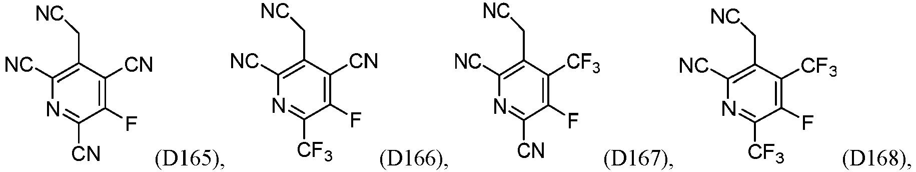 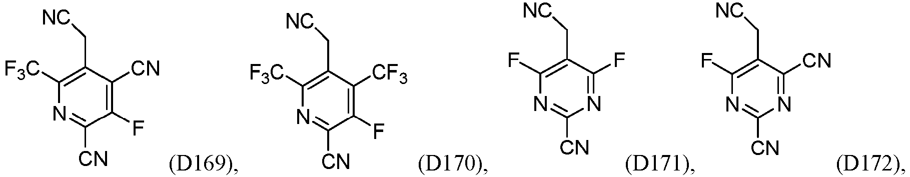 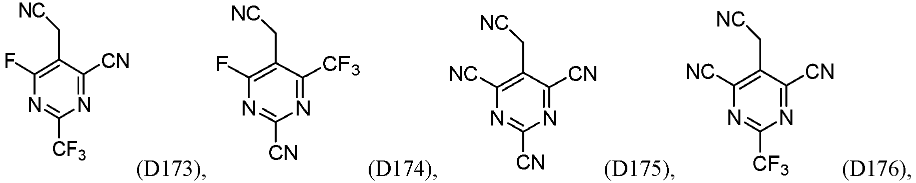 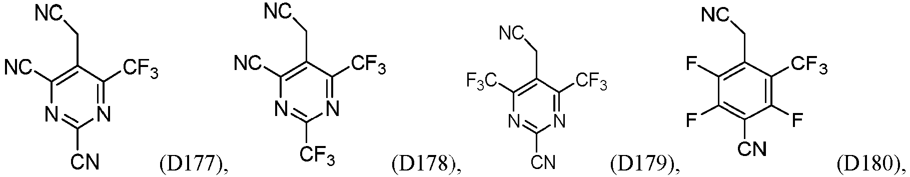 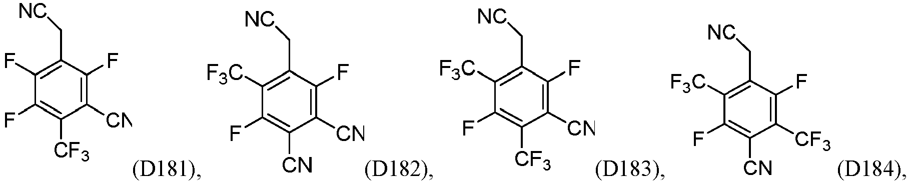 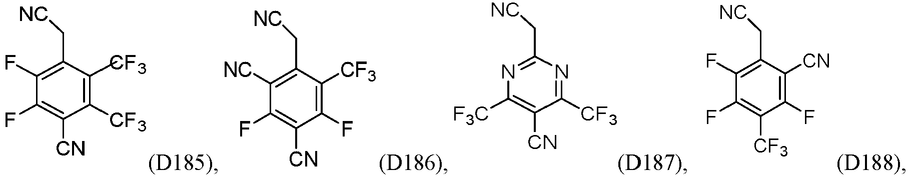 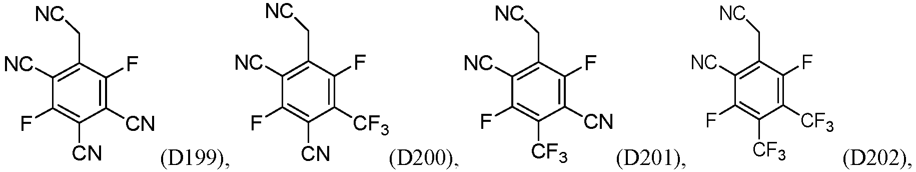 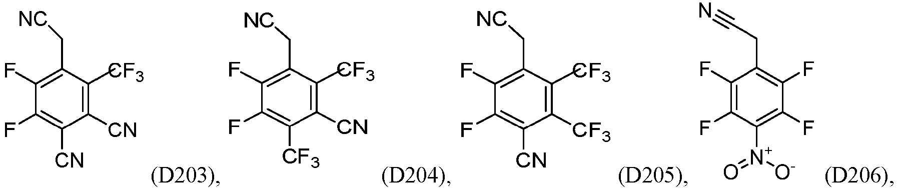 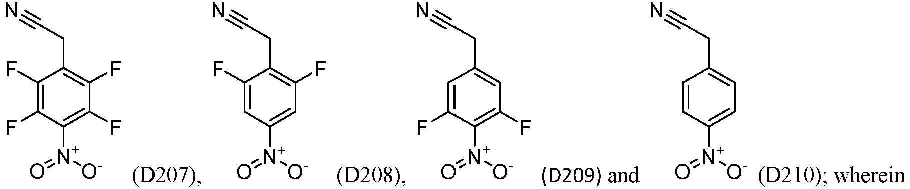 "*" of the substituent 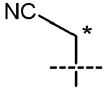 on the groups D1 to D210 indicates the binding position of A¹ to the double bond of formula (1).

According to another embodiment, wherein A¹, A² and/or A³ may be selected from a group comprising of D1 to D210.

According to another embodiment, wherein the quinone of the organic p-dopant has the Formula (5) and the quinoid of the organic p-dopant has the Formula (6), 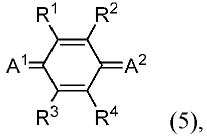 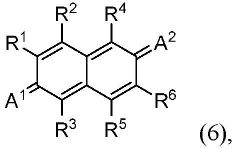 wherein
A¹ and A² are independently selected from formula (7): 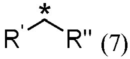 or NR‴, wherein "*" is the binding position of A¹ and A² to the double bond of formula (5) and formula (6):
- R': is selected from an electron-withdrawing group, substituted or unsubstituted alkyl, substituted or unsubstituted heteroaryl, substituted or unsubstituted aryl, perfluorinated alkyl, preferably substituted or unsubstituted C₁ to C₈ alkyl, substituted or unsubstituted C₂ to C₂₀ heteroaryl, substituted or unsubstituted C₆ to C₂₄ aryl, perfluorinated C₁ to C₈ alkyl, CF₃, NO₂, F, CN,
wherein the substituent on R' are independently selected from a group comprising D, H, electron-withdrawing group, CN, halogen, Cl, F, partially fluorinated or perfluorinated alkyl, partially fluorinated or perfluorinated C₁ to C₁₀ alkyl, CF₃, partially fluorinated or perfluorinated alkoxy, partially fluorinated or perfluorinated C₁ to C₆ alkoxy, and more preferred CN, CF₃, OCF₃, D or H;
- R'': an electron-withdrawing group, substituted or unsubstituted alkyl, substituted or unsubstituted heteroaryl, substituted or unsubstituted aryl, perfluorinated alkyl, preferably substituted or unsubstituted C₁ to C₈ alkyl, substituted or unsubstituted C₂ to C₂₀ heteroaryl, substituted or unsubstituted C₆ to C₂₄ aryl, perfluorinated C₁ to C₈ alkyl, CF₃, NO₂, F, CN,
wherein the substituent on R" are independently selected from a group comprising electron-withdrawing group, CN, halogen, Cl, F, partially fluorinated or perfluorinated alkyl, partially fluorinated or perfluorinated C₁ to C₁₀ alkyl, CF₃, partially fluorinated or perfluorinated alkoxy, partially fluorinated or perfluorinated C₁ to C₆ alkoxy and more preferred CN, CF₃, OCF₃, D or H;
wherein R' and R'' together optional form a substituted or unsubstituted cycle, and wherein the substituted or unsubstituted cycle can be substituted or unsubstituted carbocyclic or substituted or unsubstituted heterocyclic, preferably substituted or unsubstituted heterocyclic;
- R‴: is selected from a bond, substituted or unsubstituted C₁ to C₁₈ alkyl, substituted or unsubstituted C₆ to C₂₄ aryl, substituted or unsubstituted C₆ to C₂₄ heteroaryl, CN,
wherein the substituent on R‴ is independently selected from a group comprising substituted or unsubstituted C₆ to C₂₄ aryl, electron-withdrawing group, CN, F, CF₃, perfluorinated C₁ to C₈ alkyl;
- R¹, R², R³, and R⁴: are independently selected from a group comprising electron-withdrawing group, halogen, substituted or unsubstituted alkyl, partially fluorinated or perfluorinated alkyl, substituted or unsubstituted aryl, substituted or unsubstituted heteroaryl, substituted alkoxy, partially fluorinated or perfluorinated alkoxy, partially fluorinated or perfluorinated alkylaryl, O, S, substituted or unsubstituted N, preferably F, Cl, CN, substituted or unsubstituted C₁ to C₈ alkyl, partially fluorinated or perfluorinated C₁ to C₈ alkyl, CF₃, substituted or unsubstituted C₆ to C₂₄ aryl, substituted or unsubstituted C₂ to C₂₀ heteroaryl, substituted or unsubstituted C₁ to C₈ alkoxy, partially fluorinated or perfluorinated C₁ to C₈ alkoxy, OCF₃, substituted or unsubstituted C₁ to C₈ alkyl, CF₃, partially fluorinated or perfluorinated C₆ to C₂₄ alkylaryl,
wherein the substituent on R¹, R², R³, and R⁴ are independently selected from a group comprising an electron-withdrawing group, substituted or unsubstituted alkyl, substituted or unsubstituted heteroaryl, substituted or unsubstituted aryl, perfluorinated alkyl, preferably CN, substituted or unsubstituted C₁ to C₈ alkyl, substituted or unsubstituted C₂ to C₂₀ heteroaryl, substituted or unsubstituted C₆ to C₂₄ aryl, perfluorinated C₁ to C₈ alkyl, CF₃, NO₂, F;

wherein R¹ and R² together, or R³ and R⁴ together optional form independently from each other a substituted or unsubstituted carbocycle or substituted or unsubstituted heterocycle, preferably substituted or unsubstituted heterocycle;
   wherein the substituents are independently selected from a group comprising an electron-withdrawing group, F, CN, perfluorinated C₁ to C₈ alkyl preferably, perfluorinated C₁ to C₈ alkoxy preferably OCF₃; substituted or unsubstituted C₆ to C₁₈ aryl, substituted or unsubstituted C₂ to C₁₈ heteroaryl, substituted or unsubstituted carbocyclene, substituted or unsubstituted carbocyclidene, substituted or unsubstituted alkylene, substituted or unsubstituted alkylidene;
   wherein the substituents are independently selected from a group comprising an electron-withdrawing group halogen, F, Cl, CN, perfluorinated alkyl, CF₃, partially fluorinated or perfluorinated alkylaryl, partially fluorinated or perfluorinated C₆ to C₁₈ alkylaryl, perfluorinated C₁ to C₈ alkoxy preferably OCF₃;
wherein A¹ and R³ together and A² and R together optional independently from each other form a substituted or unsubstituted heterocyclic ring;
   wherein the substituents are independently selected from a group comprising substituted or unsubstituted C₆ to C₁₈ aryl, substituted or unsubstituted carbocyclene, substituted or unsubstituted carbocyclidene, substituted or unsubstituted alkylene, substituted or unsubstituted alkylidene;
   wherein the substituents are independently selected from a group comprising electron-withdrawing group halogen, F, Cl, CN, perfluorinated alkyl, CF₃, partially fluorinated or perfluorinated alkylaryl, partially fluorinated or perfluorinated C₆ to C₁₈ alkylaryl.

According to another embodiment, wherein A¹, A² and/or A³ are independently selected from a group D1 to D8: 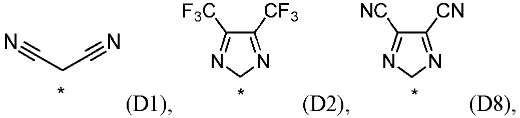 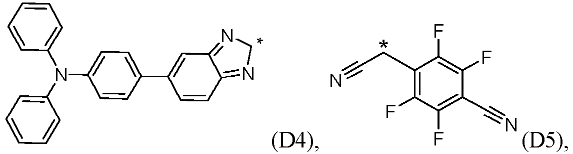 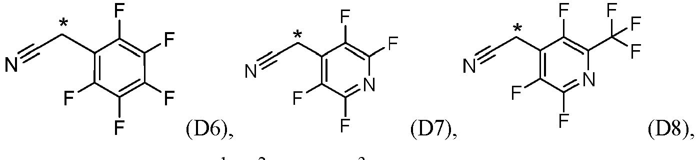 wherein
"*" is the binding position of A¹, A² and/or A³ to the double bond of formula (1), to the double bond of formula (5) and to the double bond of formula (6).

According to another embodiment, wherein A¹ and A² are independently selected from a group D1 to D8: 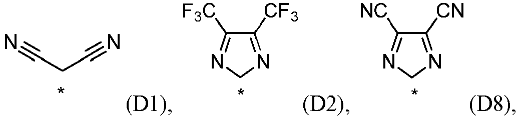 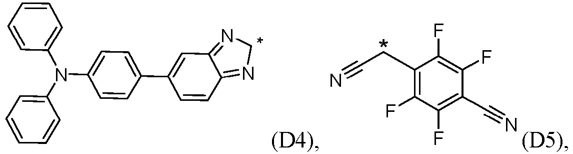 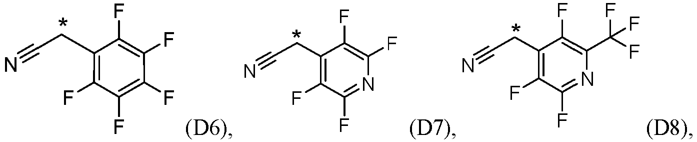 wherein
"*" is the binding position of A¹ and A² to the double bond of formula (1), to the double bond of formula (5) and to the double bond of formula (6).

According to another embodiment, wherein A¹, A² and/or A³ are selected from Formulae (8) to (13): 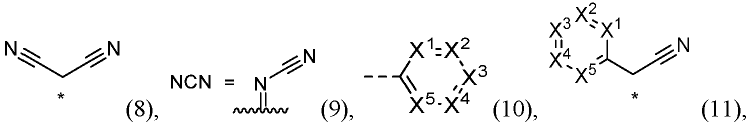 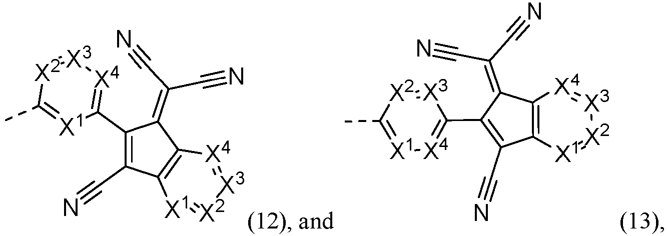 wherein
X¹ is selected from CR¹ or N;
X² is selected from CR² or N;
X³ is selected from CR³ or N;
X⁴ is selected from CR⁴ or N;
X⁵ is selected from CR⁵ or N;
   wherein one of R¹, R², R³, R⁴, and R⁵ are independently selected from electron-withdrawing group, halogen, partially fluorinated or perfluorinated alkyl, partially fluorinated or perfluorinated alkoxy, D or H, preferably CN, Cl, F, partially fluorinated or perfluorinated C₁ to C₁₀ alkyl, CF₃, partially fluorinated or perfluorinated C₁ to C₆ alkoxy;
wherein at least two of X¹ to X⁵ are independently selected from CR¹ to CR⁵.

According to another embodiment, wherein A1 and A2 is selected from Formulae (8) to (13): 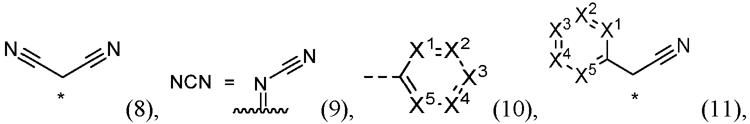 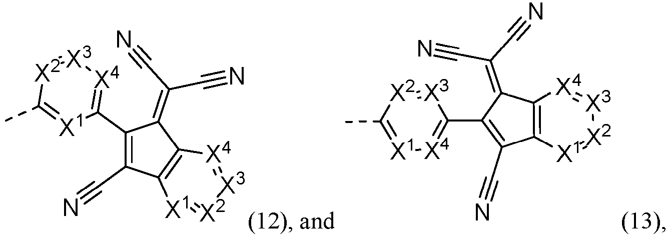 wherein
X¹ is selected from CR¹ or N;
X² is selected from CR² or N;
X³ is selected from CR³ or N;
X⁴ is selected from CR⁴ or N;
X⁵ is selected from CR⁵ or N;
   wherein one of R¹, R², R³, R⁴, and R⁵ are independently selected from electron-withdrawing group, halogen, partially fluorinated or perfluorinated alkyl, partially fluorinated or perfluorinated alkoxy, D or H, preferably CN, Cl, F, partially fluorinated or perfluorinated C₁ to C₁₀ alkyl, CF₃, partially fluorinated or perfluorinated C₁ to C₆ alkoxy;
wherein at least two of X¹ to X⁵ are independently selected from CR¹ to CR⁵.

According to another embodiment, wherein the compounds of p-dopants comprising quinone or quinoid have the following structure E1 to E11:

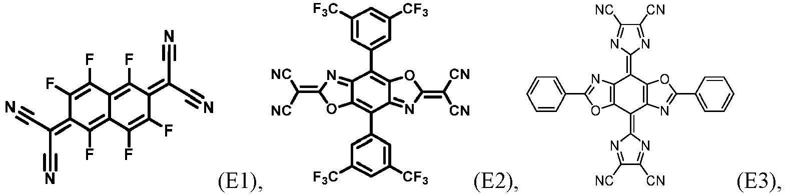

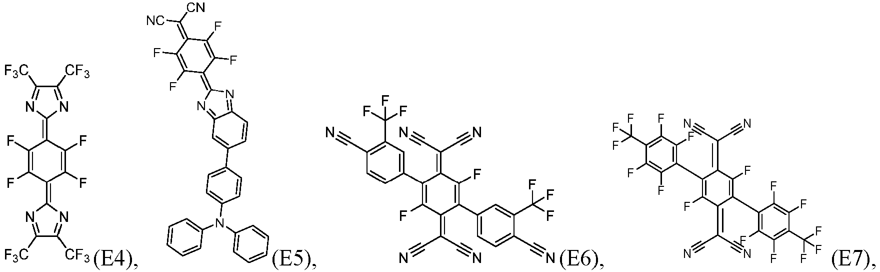

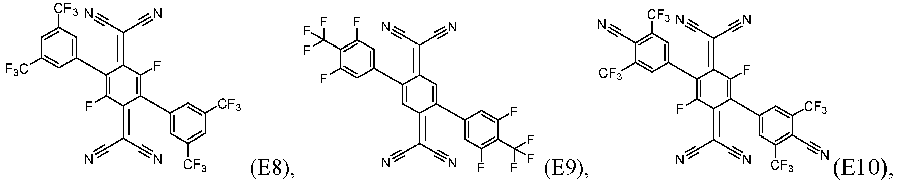

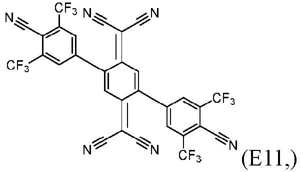

According to another embodiment, wherein the substituted or unsubstituted aromatic compound that comprises condensed rings can be represented by Formulae (14a), (14b), (14c), (14d), (14e) and Formula (15): 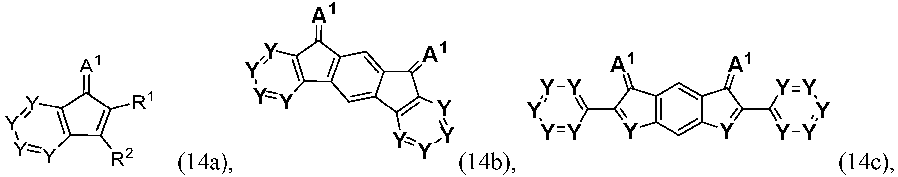 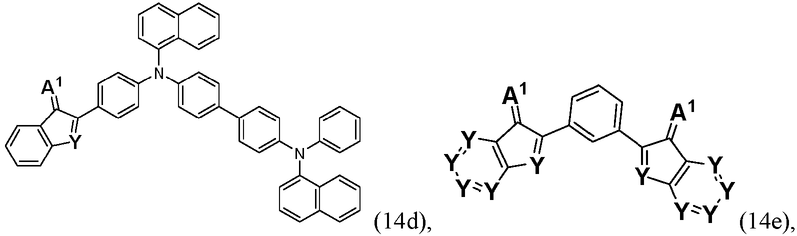 wherein A¹ is selected from 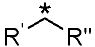 or NR''', wherein "*" is the binding position of A¹ to the double bond of formula (14), wherein
- R': is selected from an electron-withdrawing group, substituted or unsubstituted alkyl, substituted or unsubstituted heteroaryl, substituted or unsubstituted C₂ to C₂₀ heteroaryl, substituted or unsubstituted aryl, substituted or unsubstituted C₆ to C₂₄ aryl, perfluorinated alkyl, most preferably substituted or unsubstituted C₁ to C₈ alkyl, CN, substituted or unsubstituted C₂ to C₂₀ heteroaryl, substituted or unsubstituted C6 to C₂₄ aryl, C₁ to C₈ alkyl, perfluorinated C₁ to C₈ alkyl, CF₃, NO₂, F,
wherein the substituent on R' are independently selected from a group comprising electron-withdrawing group, CN, halogen, Cl, F, partially fluorinated or perfluorinated alkyl, partially fluorinated or perfluorinated C₁ to C₁₀ alkyl, CF₃, partially fluorinated or perfluorinated alkoxy, partially fluorinated or perfluorinated C₁ to C₆ alkoxy, most preferably OCF₃, D or H;
- R'': is selected from an electron-withdrawing group, substituted or unsubstituted alkyl, substituted or unsubstituted heteroaryl, substituted or unsubstituted C₂ to C₂₀ heteroaryl, substituted or unsubstituted aryl, substituted or unsubstituted C₆ to C₂₄ aryl, perfluorinated alkyl, most preferably substituted or unsubstituted C₁ to C₈ alkyl, CN, substituted or unsubstituted C₂ to C₂₀ heteroaryl, substituted or unsubstituted C6 to C₂₄ aryl, C₁ to C₈ alkyl, perfluorinated C₁ to C₈ alkyl, CF₃, NO₂, F,
wherein the substituent on R" are independently selected from a group comprising electron-withdrawing group, CN, halogen, Cl, F, partially fluorinated or perfluorinated alkyl, partially fluorinated or perfluorinated C₁ to C₁₀ alkyl, CF₃, partially fluorinated or perfluorinated alkoxy, partially fluorinated or perfluorinated C₁ to C₆ alkoxy most preferably OCF₃, D or H;
- R‴: is selected from a bond, substituted or unsubstituted C₁ to C₁₈ alkyl, substituted or unsubstituted C₆ to C₂₄ aryl, substituted or unsubstituted C₆ to C₂₄ heteroaryl, CN,
wherein the substituent on R‴ is independently selected from a group comprising substituted or unsubstituted C₆ to C₂₄ aryl, electron-withdrawing group, CN, F, CF₃, perfluorinated C₁ to C₈ alkyl;
- R¹ and R²: are independently selected from a group comprising electron-withdrawing group, halogen, F, Cl, CN, substituted alkyl, substituted C₁ to C₈ alkyl, partially fluorinated or perfluorinated C₁ to C₈ alkyl, preferably CF₃, substituted or unsubstituted aryl, substituted or unsubstituted C₆ to C₂₄ aryl, substituted or unsubstituted heteroaryl, substituted or unsubstituted C₂ to C₂₀ heteroaryl, substituted C₁ to C₈ alkoxy, partially fluorinated or perfluorinated C₁ to C₈ alkoxy, preferably OCF₃, partially fluorinated or perfluorinated alkylaryl, partially fluorinated or perfluorinated C₆ to C₂₄ alkylaryl, O, S, N;
wherein the substituent on R¹ and R² are independently selected from a group comprising an electron-withdrawing group preferably CN, substituted or unsubstituted alkyl, substituted or unsubstituted C₁ to C₈ alkyl, substituted or unsubstituted heteroaryl, substituted or unsubstituted C₂ to C₂₀ heteroaryl, substituted or unsubstituted aryl, substituted or unsubstituted C₆ to C₂₄ aryl, perfluorinated alkyl, perfluorinated C₁ to C₈ alkyl, most preferably CF₃, NO₂, F;

wherein R¹ and R² together optional form a substituted or unsubstituted carbocycle or substituted or unsubstituted heterocycle, preferably substituted or unsubstituted carbocycle;
   wherein the substituents on the cycle are selected from a group comprising electron-withdrawing group, F, CN, perfluorinated C₁ to C₈ alkyl preferably, perfluorinated C₁ to C₈ alkoxy, OCF₃; substituted or unsubstituted C₆ to C₁₈ aryl, substituted or unsubstituted C₂ to C₁₈ heteroaryl, substituted or unsubstituted carbocyclene, substituted or unsubstituted carbocyclidene, substituted or unsubstituted alkylene, substituted or unsubstituted alkylidene;
   wherein the substituents are selected from a group comprising an electron-withdrawing group halogen, F, Cl, CN, perfluorinated alkyl, perfluorinated C₁ to C₈ alkyl, CF₃, partially fluorinated or perfluorinated alkylaryl, partially fluorinated or perfluorinated C₆ to C₁₈ alkylaryl, perfluorinated C₁ to C₈ alkoxy, OCF₃;
Y is independently selected from each other from N or CR^{a},
R^{a} is independently selected from a group comprising H, D, electron-withdrawing group, CN, substituted or unsubstituted C₁ to C₈ alkyl, perfluorinated C₁ to C₈ alkyl, CF₃, perfluorinated C₁ to C₈ alkoxy, OCF₃;
   wherein the substituents on R^{a} are independently selected from a group comprising electron-withdrawing group, CN, halogen, Cl, F, partially fluorinated or perfluorinated alkyl, partially fluorinated or perfluorinated C₁ to C₁₀ alkyl, CF₃, partially fluorinated or perfluorinated alkoxy, partially fluorinated or perfluorinated C₁ to C₆ alkoxy most preferably OCF₃, D or H;
wherein two R^{a} optional form a substituted or unsubstituted carbocycle or substituted or unsubstituted heterocycle, preferably substituted or unsubstituted carbocycle;
   wherein the substituents on the cycle independently selected from a group comprising electron-withdrawing group, F, CN, perfluorinated C₁ to C₈ alkyl preferably, perfluorinated C₁ to C₈ alkoxy, OCF₃; substituted or unsubstituted C₆ to C₁₈ aryl, substituted or unsubstituted C₂ to C₁₈ heteroaryl, substituted or unsubstituted carbocyclene, substituted or unsubstituted carbocyclidene, substituted or unsubstituted alkylene, substituted or unsubstituted alkylidene;
wherein two Y optional form a substituted or unsubstituted carbocycle or substituted or unsubstituted heterocycle, preferably substituted or unsubstituted carbocycle;
   wherein the substituents on the cycle can be electron-withdrawing group, F, CN, perfluorinated C₁ to C₈ alkyl preferably, perfluorinated C₁ to C₈ alkoxy, OCF₃; substituted or unsubstituted C₆ to C₁₈ aryl, substituted or unsubstituted C₂ to C₁₈ heteroaryl, substituted or unsubstituted carbocyclene, substituted or unsubstituted carbocyclidene, substituted or unsubstituted alkylene, substituted or unsubstituted alkylidene; 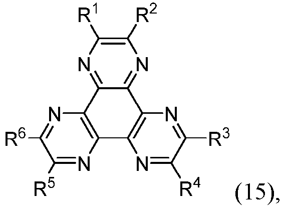 wherein
R¹, R², R³, R⁴, R⁵, and R⁶ are independently selected from a group comprising H, F, CN, CF₃, and NO₂, wherein at least one of R¹, R², R³, R⁴, R⁵, and R⁶ is F, CN, CF₃, or NO₂.

According to another embodiment, wherein the substituted or unsubstituted aromatic compound that comprises condensed rings having a structure of G1 to G4: 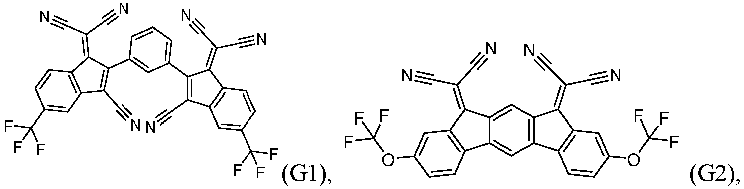 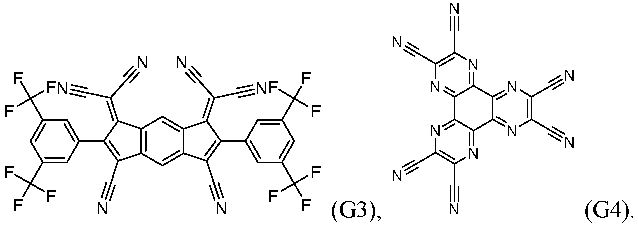 And

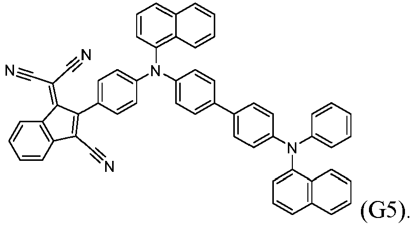

According to another embodiment, wherein at least one R¹ and R² are independently selected from a group comprising CN, OCF₃, CF₃, F, perfluorinated C₁ to C₈ alkyl, substituted C₆ to C₂₄ aryl, wherein the substituent is F, CF₃, CN, substituted C₁ to C₈ alkylene.

According to one embodiment of the invention, the organic p-dopant is non-emissive. In the context of the present specification the term "essentially non-emissive" or "non-emissive" means that the contribution of the organic p-dopant to the visible emission spectrum from an organic electronic device, preferably OLED or display device, is less than 10 %, preferably less than 5 % relative to the visible emission spectrum. The visible emission spectrum is an emission spectrum with a wavelength of about ≥ 380 nm to about ≤ 780 nm.

### Active-matrix OLED display

The active-matrix OLED display is defined in the appended claims.

According to another embodiment of the active-matrix OLED display, wherein the common first hole injection layer and the common hole transport layer have together a sheet resistance selected from ≥ 100 giga ohms per square, ≥ 200 giga ohms per square, ≥ 300 giga ohms per square, ≥ 400 giga ohms per square, ≥ 500 giga ohms per square, ≥ 1000 giga ohms per square, ≥ 2500 giga ohms per square, ≥ 5000 giga ohms per square, ≥ 10000 giga ohms per square, ≥ 20000 giga ohms per square, ≥ 30000 giga ohms per square, ≥ 40000 giga ohms per square, or ≥ 50000 giga ohms per square.

According to another embodiment of the active-matrix OLED display, wherein the common first semiconductor layer has a layer thickness ≥ 1 nm and ≤ 100 nm, preferably ≥ 2 nm and ≤ 50 nm, more preferably ≥ 3 nm and ≤ 40 nm, more preferably ≥ 4 nm and ≤ 30 nm, more preferably ≥ 5 nm and ≤ 20 nm, more preferably ≥ 6 nm and ≤ 15 nm, more preferably ≥ 8 nm and ≤ 10 nm.

According to another embodiment of the active-matrix OLED display, wherein the common second semiconductor layer comprises a compound having energies of their highest occupied molecular orbitals, expressed in the absolute scale referring to vacuum energy level being zero, calculated using the hybrid functional B3LYP with a Gaussian 6-31G* basis set as implemented in the program package TURBOMOLE V6.5, in the range from < -4.27 eV to ≥ -6.0 eV, < -4.3 eV to ≥-5.5 eV, preferably <-4.5 eV to >-5.4 eV, more preferably from -<-4.6 eV to ≥-5.3 eV.

According to another embodiment of the active-matrix OLED display, wherein the electron blocking layer comprises a compound having energies of their highest occupied molecular orbitals, expressed in the absolute scale referring to vacuum energy level being zero, calculated using the hybrid functional B3LYP with a Gaussian 6-31G* basis set as implemented in the program package TURBOMOLE V6.5, in the range from in the range from < -4.7 eV to ≥ -6.0 eV, < -4.8 eV to ≥-5.5 eV, preferably <-4.9 eV to ≥-5.4 eV, more preferably from -<-5.0 eV to ≥-5.3 eV.

According to another embodiment of the active-matrix OLED display, wherein at least one anode layer comprises a first anode sub-layer and a second anode sub-layer, wherein the first anode sub-layer comprises a first metal having a work function in the range of ≥ 4 and ≤ 6 eV, and the second anode sub-layer comprises a transparent conductive oxide; and the second anode sub-layer is arranged closer to the common hole injection layer.

According to another embodiment of the active-matrix OLED display, wherein the active-matrix OLED display comprises a driving circuit configured to separately driving the pixels of the plurality of organic-light emitting diode pixels.

According to another embodiment of the active-matrix OLED display, wherein the common first semiconductor layer is shared by the plurality of OLED pixels and/or the common second semiconductor layer is shared by the plurality of OLED pixels, preferably all common semiconductor layers are shared by the plurality of OLED pixels.

According to another embodiment of the active-matrix OLED display, wherein every individual pixel may have its own anode that may not touch anodes of other individual pixels.

### Semiconductor layer

According to one embodiment the at least two common semiconductor layers comprising the organic semiconductor layers, and preferably the at least two common semiconductor layers are non-emissive.

In the context of the present specification the term "essentially non-emissive" or "non-emissive" means that the contribution of the common semiconductor layers to the visible emission spectrum from an organic electronic device, preferably OLED or display device, is less than 10%, preferably less than 5 % relative to the visible emission spectrum. The visible emission spectrum is an emission spectrum with a wavelength of about ≥ 380 nm to about ≤ 780 nm.

According to one embodiment of the invention, at least one common semiconductor layer, preferably the common first semiconductor layer, may be layer is arranged and/or provided adjacent to the anode, wherein the anode is not formed as a common layer.

According to one embodiment of the invention, the common first semiconductor layer, is in direct contact with the anode, wherein the anode is not formed as a common layer. Every individual pixel may have its own anode that may not touch anodes of other individual pixels.

According to one embodiment of the invention, wherein the at least common first semiconductor layer of the at least two common semiconductor layers is a common hole-injection layer.

According to one embodiment of the invention, wherein the at least common first semiconductor layer that is a common hole-injection layer, comprises at least one organic p-dopant.

### Matrix compound

According to one embodiment, wherein a semiconductor layer may comprise at least one matrix compound, wherein the at least one matrix compound is a non-polymeric compound, preferably the matrix compound is a covalent matrix compound or a substantially covalent matrix compound.

Preferably at least one common semiconductor layer comprising a covalent matrix compound or substantially covalent matrix compound.

The hole injection layer may comprise in addition to the hole injection material at least one matrix covalent matrix compound and/or or at least one substantially covalent matrix compound.

Preferred examples of covalent matrix compounds are organic compounds, consisting predominantly from covalently bound C, H, O, N, S, which may optionally comprise also covalently bound B, P, As, Se. Organometallic compounds comprising covalent bonds carbon-metal, metal complexes comprising organic ligands and metal salts of organic acids are further examples of organic compounds that may serve as organic covalent matrix compound or substantially covalent matrix compounds.

In one embodiment, wherein the covalent matrix compound or substantially covalent matrix compound lacks metal atoms and majority of its skeletal atoms is selected from C, O, S, N. Alternatively, the covalent matrix compound or substantially covalent matrix compound lacks metal atoms and majority of its skeletal atoms is selected from C and N.

According to one embodiment, the substantially covalent matrix compound may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

In one embodiment, wherein the HOMO level of the covalent matrix compound or substantially covalent matrix compound may be more negative than the HOMO level of N2,N2,N2',N2',N7,N7,N7',N7'-octakis(4-methoxyphenyl)-9,9'-spirobi[fluorene]-2,2',7,7'-tetraamine (CAS 207739-72-8) when determined under the same conditions.

In one embodiment, wherein the calculated HOMO level of the covalent matrix compound or substantially covalent matrix compound may be more negative than -4.27 eV, preferably more negative than -4.3 eV, alternatively more negative than -4.5 eV, alternatively more negative than -4.6 eV, alternatively more negative than -4.65 eV.

According to another aspect , the semiconductor layer further comprises a covalent matrix compound or substantially covalent matrix compound with an oxidation potential more positive than - 0.2 V and more negative than 1.22 V, when measured by cyclic voltammetry in dichloromethane vs. Fc/Fc+, preferably more positive than - 0.18 V and more negative than 1.12 V. Under these conditions the oxidation potential of spiro-MeO-TAD (CAS 207739-72-8) is - 0.07 V.

In one embodiment, wherein the HOMO level of the covalent matrix compound or substantially covalent matrix compound may be more negative than the HOMO level of N2,N2,N2',N2',N7,N7,N7',N7'-octakis(4-methoxyphenyl)-9,9'-spirobi[fluorene]-2,2',7,7'-tetraamine (CAS 207739-72-8) and more positive than the HOMO level of N4,N4‴-di(naphthalen-1-yl)-N4,N4‴-diphenyl-[1,1':4',1":4",1‴-quaterphenyl]-4,4‴-diamine when determined under the same conditions.

In one embodiment, wherein the covalent matrix compound or substantially covalent matrix compound may be free of alkoxy groups.

In one embodiment, the HOMO level of the covalent matrix compound or substantially covalent matrix compound expressed in the absolute scale referring to vacuum energy level being zero, when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, may be selected in the range of < -4.27 eV and ≥ -5.3eV, alternatively in the range of < -4.3 eV and ≥ -5.3 eV, alternatively in the range of < -4.5 eV and ≥ -5.3eV, alternatively in the range of < -4.6 eV and ≥ -5.3 eV.

In one embodiment, wherein the calculated HOMO level of the covalent matrix compound or substantially covalent matrix compound expressed in the absolute scale referring to vacuum energy level being zero, when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase may be selected in the range of < -4.27 eV and > -4.84 eV, alternatively in the range of < -4.3 eV and > -4.84 eV, alternatively in the range of < - 4.5 eV and > -4.84 eV, alternatively in the range of < -4.5 eV and > -4.84 eV, alternatively in the range of < -4.6 eV and > -4.84 eV.

In one embodiment, wherein the calculated HOMO level of the covalent matrix compound or substantially covalent matrix compound expressed in the absolute scale referring to vacuum energy level being zero, when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase may be selected in the range of < -4.27 eV and > -4.8 eV, alternatively in the range of < -4.3 eV and > -4.8 eV, alternatively in the range of < -4.5 eV and > -4.8 eV, alternatively in the range of < -4.5 eV and > -4.8 eV, alternatively in the range of < -4.6 eV and > -4.8 eV, alternatively in the range of < -4.65 eV and > -4.8 eV.

Preferably, the covalent matrix compound or substantially covalent matrix compound comprises at least one arylamine compound, alternatively a diarylamine compound, alternatively a triarylamine compound. According to an embodiment of the organic electronic device, wherein the common hole injection layer and/or common hole transport layer may comprise a diarylamine compound, alternatively a triarylamine compound.

According to an embodiment of the organic electronic device, wherein the common hole injection layer and/or common hole transport layer may comprise a compound of formula (2) or formula (3): 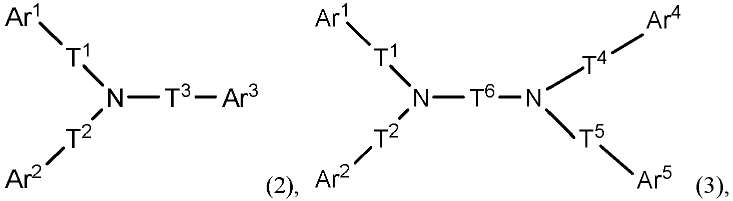 wherein
- T¹, T², T³, T⁴ and T⁵: are independently selected from a single bond, phenylene, biphenylene, terphenylene or naphthenylene, preferably a single bond or phenylene;
- T⁶: is selected from substituted or unsubstituted phenylene, biphenylene, terphenylene or naphthenylene, wherein the substituent on phenylene is selected from C₆ to C₁₈ aryl, C₃ to C₁₈ heteroaryl, phenyl, biphenyl, carbazole, phenyl carbazole, preferably biphenyl or 9-phenyl carbazole;
- Ar¹, Ar², Ar³, Ar⁴ and Ar⁵: are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted 9,9'-spirobi[fluorene] with at least one fused aromatic ring, substituted or unsubstituted spiro[fluorene-9,9'-xanthene], a substituted or unsubstituted aromatic fused ring system comprising two aromatic 6-member rings and two aromatic 5-member rings, wherein at least one 5-member ring comprises a hetero atom, a substituted or unsubstituted aromatic fused ring system comprising two aromatic 6-member rings and two aromatic 5-member rings, wherein at least one 5-member ring comprises an O atom, or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, substituted or unsubstituted fluorene with an annelated substituted or unsubstituted hetero or non-hetero ring system comprising 2 to 6 substituted or unsubstituted 5-, 6- or 7-member rings, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein the substituents of Ar¹, Ar², Ar³, Ar⁴ and Ar⁵ are selected the same or different from the group comprising H, D, F, C(=O)R², CN, Si(R²)₃, P(=O)(R²)₂, OR², S(=O)R², S(=O)₂R², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R² is selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl.

Preferably, if not otherwise defined the substituents of Ar¹, Ar², Ar³, Ar⁴ and Ar⁵ are selected the same or different from the group comprising H, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, alkoxy groups having 1 to 6 carbon atoms, C₆ to C₁₈ aryl, C₃ to C₁₈ heteroaryl, a fused ring system comprising 2 to 4 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle; more preferred the substituents are selected the same or different from the group consisting of H, straight-chain alkyl having 1 to 4 carbon atoms, branched alkyl having 1 to 4 carbon atoms, cyclic alkyl having 3 to 4 carbon atoms and/or phenyl.

Thereby, the compound of formula (2) or (3) may have a rate onset temperature suitable for mass production.

According to an embodiment of the organic electronic device, wherein covalent matrix compound or substantially covalent matrix compound, preferably the matrix compound of the common hole injection layer or common hole transport layer may comprise a compound of formula (2) or formula (3): 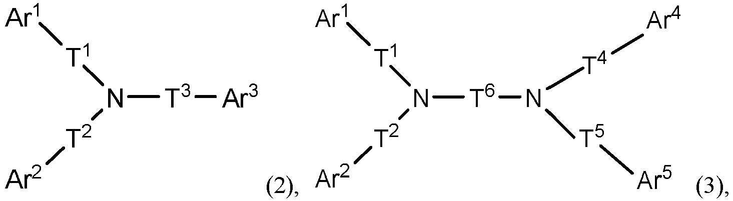 wherein
- T¹, T², T³, T⁴ and T⁵: may be independently selected from a single bond, phenylene, biphenylene, terphenylene or naphthenylene, preferably a single bond or phenylene;
- T⁶: is phenylene, biphenylene, terphenylene or naphthenylene;
- Ar¹, Ar², Ar³, Ar⁴ and Ar⁵: may be independently selected from unsubstituted C₆ to C₂₀ aryl, or unsubstituted C₃ to C₂₀ heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,f]azepine, unsubstituted 9,9'-spirobi[fluorene], unsubstituted spiro[fluorene-9,9'-xanthene], or a unsubstituted aromatic fused ring system comprising at least three unsubstituted aromatic rings selected from the group comprising unsubstituted non-hetero, unsubstituted hetero 5-member rings, unsubstituted 6-member rings and/or unsubstituted 7-member rings, unsubstituted fluorene, or a fused ring system comprising 2 to 6 unsubstituted 5- to 7-member rings and the rings are selected from the group comprising (i) unsaturated 5- to 7-member ring of a heterocycle, (2) 5- to 6-member of an aromatic heterocycle, (3) unsaturated 5- to 7-member ring of a non-heterocycle, and (iv) 6-member ring of an aromatic non-heterocycle.

According to an embodiment of the organic electronic device, wherein covalent matrix compound or substantially covalent matrix compound, preferably of the covalent matrix compound or substantially covalent matrix compound of common hole injection layer or common hole transport layer may comprise a compound of formula (2) or formula (3): 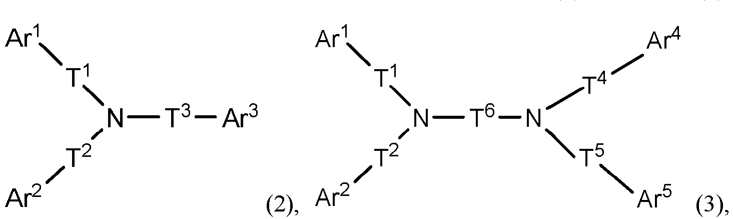 wherein
- T¹, T², T³, T⁴ and T⁵: may be independently selected from a single bond, phenylene, biphenylene, terphenylene or naphthenylene, preferably a single bond or phenylene;
- T⁶: is phenylene, biphenylene, terphenylene or naphthenylene;
- Ar¹, Ar², Ar³, Ar⁴ and Ar⁵: may be independently selected from unsubstituted C₆ to C₂₀ aryl, or unsubstituted C₃ to C₂₀ heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,f]azepine, unsubstituted 9,9'-spirobi[fluorene], unsubstituted spiro[fluorene-9,9'-xanthene].

Thereby, the compound of formula (2) or (3) may have a rate onset temperature suitable for mass production.

According to an embodiment wherein T¹, T², T³, T⁴ and T⁵ may be independently selected from a single bond, phenylene, biphenylene or terphenylene. According to an embodiment wherein T¹, T², T³, T⁴ and T⁵ may be independently selected from phenylene, biphenylene or terphenylene and one of T¹, T², T³, T⁴ and T⁵ are a single bond. According to an embodiment wherein T¹, T², T³, T⁴ and T⁵ may be independently selected from phenylene or biphenylene and one of T¹, T², T³, T⁴ and T⁵ are a single bond. According to an embodiment wherein T¹, T², T³, T⁴ and T⁵ may be independently selected from phenylene or biphenylene and two of T¹, T², T³, T⁴ and T⁵ are a single bond.

According to an embodiment wherein T¹, T², T³, T⁴ and T⁵*,* or T¹, T² and T³ may be independently selected from phenylene and one of T¹, T², T³, T⁴ and T⁵*,* or T¹, T² and T³ are a single bond. According to an embodiment wherein T¹, T², T³, T⁴ and T⁵*,* or T¹, T² and T³ may be independently selected from phenylene and two of T¹, T², T³, T⁴ and T⁵*,* or T¹, T² and T³ are a single bond.

According to an embodiment wherein T⁶ may be phenylene, biphenylene, terphenylene. According to an embodiment wherein T⁶ may be phenylene. According to an embodiment wherein T⁶ may be biphenylene. According to an embodiment wherein T⁶ may be terphenylene.

According to an embodiment wherein Ar¹, Ar², Ar³, Ar⁴ and Ar⁵ may be independently selected from D1 to D16: 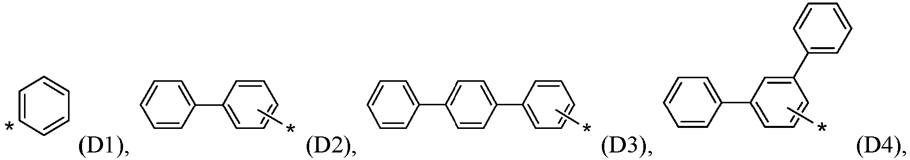 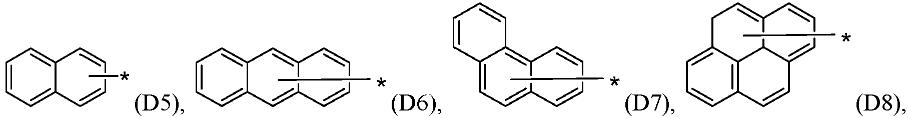 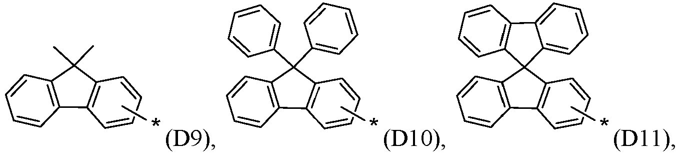 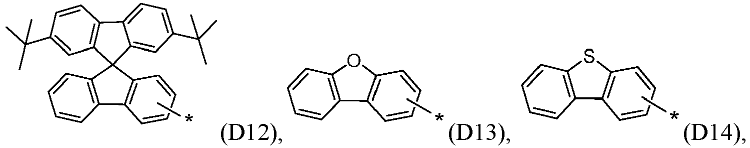 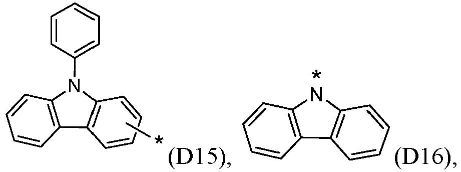 wherein the asterix "*" denotes the binding position.

According to an embodiment, wherein Ar¹, Ar², Ar³, Ar⁴ and Ar⁵ may be independently selected from D1 to D15; alternatively selected from D1 to D10 and D13 to D15.

According to an embodiment, wherein Ar¹, Ar², Ar³, Ar⁴ and Ar⁵ may be independently selected from the group consisting of D1, D2, D5, D7, D9, D10, D13 to D16.

The rate onset temperature may be in a range particularly suited to mass production, when Ar¹, Ar², Ar³, Ar⁴ and Ar⁵ are selected in this range.

The "covalent matrix compound of formula (2) or formula (3) " may be used for a common hole injection layer and/or may be used as matrix compound for a common hole transport compound.

According to one embodiment the covalent matrix compound of formula (2) or formula (3) may comprise at least ≥ 1 to ≤ 6 substituted or unsubstituted aromatic fused ring systems comprising heteroaromatic rings.

According to one embodiment the covalent matrix compound of formula (2) or formula (3) may comprise at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings.

According to one embodiment the covalent matrix compound of formula (2) or formula (3) may comprise at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings, and at least ≥ 1 to ≤ 3 substituted or unsubstituted unsaturated 5- to 7-member ring of a heterocycle, further preferred 3 or 4 substituted or unsubstituted aromatic fused ring systems comprising heteroaromatic rings and optional at least ≥ 1 to ≤ 3 substituted or unsubstituted unsaturated 5- to 7-member ring of a heterocycle, and additional preferred wherein the aromatic fused ring systems comprising heteroaromatic rings are unsubstituted and optional at least ≥ 1 to ≤ 3 unsubstituted unsaturated 5- to 7-member ring of a heterocycle.

According to one embodiment the covalent matrix compound of formula (2) or formula (3) may comprise at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems.

According to one embodiment the covalent matrix compound of formula (2) or formula (3) may comprise at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings.

According to one embodiment the covalent matrix compound of formula (2) or formula (3) may comprise at least ≥ 1 to ≤ 3 or 2 substituted or unsubstituted unsaturated 5- to 7-member ring of a heterocycle.

According to one embodiment the covalent matrix compound of formula (2) or formula (3) may comprise at least ≥ 1 to ≤ 3 or 2 substituted or unsubstituted unsaturated 7-member ring of a heterocycle.

According to one embodiment substituted or unsubstituted aromatic fused ring systems of the covalent matrix compound or substantially covalent matrix compound of formula (2) or formula (3) may comprise at least ≥ 1 to ≤ 3 or 2 substituted or unsubstituted unsaturated 5- to 7-member ring of a heterocycle.

According to one embodiment the substituted or unsubstituted aromatic fused ring systems of the covalent matrix compound or substantially covalent matrix compound of formula (2) or formula (3) may comprise at least ≥ 1 to ≤ 3 or 2 substituted or unsubstituted unsaturated 7-member ring of a heterocycle.

According to one embodiment the covalent matrix compound of formula (2) or formula (3) may comprise at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, and wherein the aromatic fused ring system comprises substituted or unsubstituted unsaturated 5- to 7-member ring of a heterocycle.

According to one embodiment the covalent matrix compound of formula (2) or formula (3) may comprise at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings, and wherein the aromatic fused ring system comprises substituted or unsubstituted unsaturated 5- to 7-member ring of a heterocycle.

According to one embodiment the covalent matrix compound of formula (2) or formula (3) may comprise at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, and wherein the aromatic fused ring system comprises at least ≥ 1 to ≤ 3 or 2 substituted or unsubstituted unsaturated 5- to 7-member ring of a heterocycle.

According to one embodiment the covalent matrix compound of formula (2) or formula (3) may comprise at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings, and wherein the aromatic fused ring system comprises at least ≥ 1 to ≤ 3 or 2 substituted or unsubstituted unsaturated 5- to 7-member ring of a heterocycle.

According to one embodiment the covalent matrix compound of formula (2) or formula (3) may comprise:
- a substituted or unsubstituted aromatic fused ring system with at least ≥ 2 to ≤ 6, preferably ≥ 3 to ≤ 5, or 4 fused aromatic rings selected from the group comprising substituted or unsubstituted non-hetero aromatic rings, substituted or unsubstituted hetero 5-member rings, substituted or unsubstituted 6-member rings and/or substituted or unsubstituted unsaturated 5-to 7- member ring of a heterocycle; or
- an unsubstituted aromatic fused ring system with at least ≥ 2 to ≤ 6, preferably ≥ 3 to ≤ 5, or 4 fused aromatic rings selected from the group comprising unsubstituted non-hetero aromatic rings, unsubstituted hetero 5-member rings, unsubstituted 6-member rings and/or unsubstituted unsaturated 5- to 7-member ring of a heterocycle.

It should be noted here that the wording "aromatic fused ring system" may include at least one aromatic ring and at least one substituted or unsubstituted unsaturated 5- to 7- member ring. It should be noted here that the substituted or unsubstituted unsaturated 5- to 7- member ring may not be an aromatic ring.

According to one embodiment the covalent matrix compound of formula (2) or formula (3) may comprise at least at least ≥ 1 to ≤ 6, preferably ≥ 2 to ≤ 5, or further preferred 3 or 4 of the substituted or unsubstituted aromatic fused ring systems with:
- at least one unsaturated 5-member ring, and/or
- at least one unsaturated 6-member ring, and/or
- at least one unsaturated 7-member ring; wherein preferably at least one unsaturated 5- and/or at least one unsaturated 7-member ring comprises at least 1 to 3, preferably 1 hetero-atom.

According to one embodiment the covalent matrix compound of formula (2) or formula (3) may comprise at least at least ≥ 1 to ≤ 6, preferably ≥ 2 to ≤ 5, or further preferred 3 or 4 of the substituted or unsubstituted aromatic fused ring systems with:
- at least one aromatic 5-member ring, and/or
- at least one aromatic 6-member ring, and/or
- at least one aromatic 7-member ring; wherein preferably at least one aromatic 5- and/or at least one aromatic 7-member ring comprises at least 1 to 3, preferably 1 hetero-atom;
wherein the substituted or unsubstituted aromatic fused ring system comprises at least ≥ 1 to ≤ 3 or 2 substituted or unsubstituted unsaturated 5- to 7-member ring of a heterocycle.

According to one embodiment the covalent matrix compound of formula (2) or formula (3) may comprise :
- at least ≥ 6 to ≤ 12, preferably ≥ 7 to ≤ 11, further preferred ≥ 8 to ≤ 10 or 9 aromatic rings; and/or
- at least ≥ 4 to ≤ 11, preferably ≥ 5 to ≤ 10, further preferred ≥ 6 to ≤ 9 or in addition preferred 7 or 8 non-hetero aromatic rings, preferably the non-hetero aromatic rings are aromatic C₆ rings; and/or
- at least ≥ 1 to ≤ 4, preferably 2 or 3 aromatic 5-member-rings, preferably hetero aromatic 5-member-rings; and/or
- at least 1 or 2 unsaturated 5- to 7-member-ring of a heterocycle, preferably at least 1 or 2 unsaturated 7-member-ring of a heterocycle;
- at least ≥ 6 to ≤ 12, preferably ≥ 7 to ≤ 11, further preferred ≥ 8 to ≤ 10 or 9 aromatic rings, wherein therefrom
   at least ≥ 4 to ≤ 11, preferably ≥ 5 to ≤ 10, further preferred ≥ 6 to ≤ 9 or in addition preferred 7 or 8 are non-hetero aromatic rings, and
   at least ≥ 1 to ≤ 4, preferably 2 or 3 aromatic rings are hetero aromatic rings, wherein the total number of non-hetero aromatic rings and hetero aromatic rings in total does not exceed 12 aromatic rings; and/or
- at least ≥ 6 to ≤ 12, preferably ≥ 7 to ≤ 11, further preferred ≥ 8 to ≤ 10 or 9 aromatic rings, wherein therefrom
   at least ≥ 4 to ≤ 11, preferably ≥ 5 to ≤ 10, further preferred ≥ 6 to ≤ 9 or in addition preferred 7 or 8 are non-hetero aromatic rings, and
   at least ≥ 1 to ≤ 4, preferably 2 or 3 aromatic rings are hetero aromatic rings, wherein the total number of non-hetero aromatic rings and hetero aromatic rings in total does not exceed 12 aromatic rings; and
      the common hole injection layer or common hole transport layer according to formula I comprises at least ≥ 1 to ≤ 4, preferably 2 or 3 aromatic 5-member-rings, preferably hetero aromatic 5-member-rings, and/or
      the compound according to formula (I) comprises at least 1 or 2 unsaturated 5- to 7-member-ring of a heterocycle, preferably at least 1 or 2 unsaturated 7-member-ring of a heterocycle.

According to one embodiment the covalent matrix compound of formula (2) or formula (3) may comprise a hetero-atom, which may be selected from the group comprising O, S, N, B or P, preferably the hetero-atom may be selected from the group comprising O, S or N.

According to one embodiment the covalent matrix compound of formula (2) or formula (3) may comprise at least at least ≥ 1 to ≤ 6, preferably ≥ 2 to ≤ 5, or further preferred 3 or 4 of the substituted or unsubstituted aromatic fused ring systems with:
- at least one aromatic 5-member ring, and/or
- at least one aromatic 6-member ring, and/or
- at least one aromatic 7-member ring; wherein preferably at least one aromatic 5- and/or at least one aromatic 7-member ring comprises at least 1 to 3, preferably 1 hetero-atom;
   wherein the substituted or unsubstituted aromatic fused ring system optional comprises at least ≥ 1 to ≤ 3 or 2 substituted or unsubstituted unsaturated 5- to 7-member ring of a heterocycle; and wherein the substituted or unsubstituted aromatic fused ring system comprises a hetero-atom, which may be selected from the group comprising O, S, N, B, P or Si, preferably the hetero-atom may be selected from the group comprising O, S or N.

According to one embodiment the matrix covalent compound of formula (2) or formula (3) may be free of hetero-atoms which are not part of an aromatic ring and/or part of an unsaturated 7-member-ring, preferably the compound according to formula (I) may be free on N-atoms except N-atoms which are part of an aromatic ring or are part of an unsaturated 7-member-ring.

According to one embodiment, wherein the covalent matrix compound according to formula (I) comprises at least one naphthyl group, carbazole group, dibenzofurane group, dibenzothiophene group and/or substituted fluorenyl group, wherein the substituents are independently selected from methyl, phenyl or fluorenyl.

According to an embodiment of the electronic device, wherein the covalent matrix compound or substantially covalent matrix compound are selected from F1 to F21:

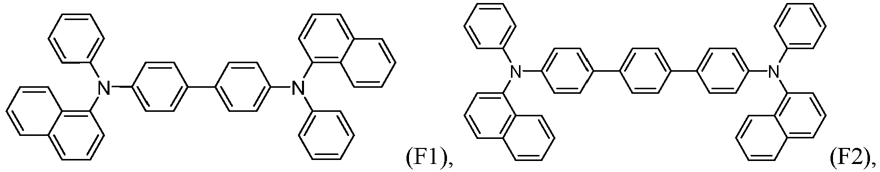

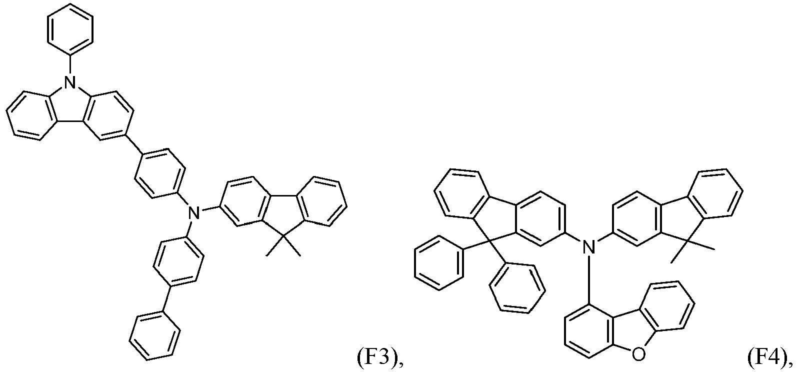

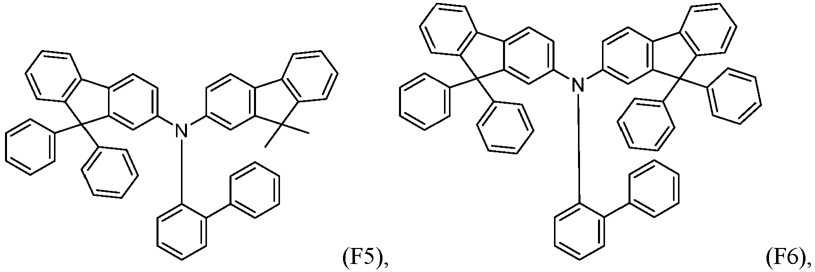

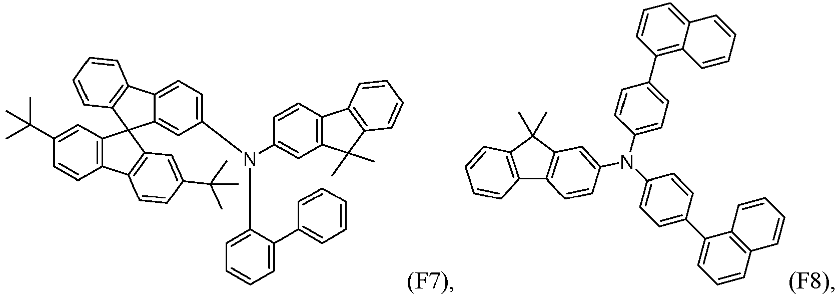

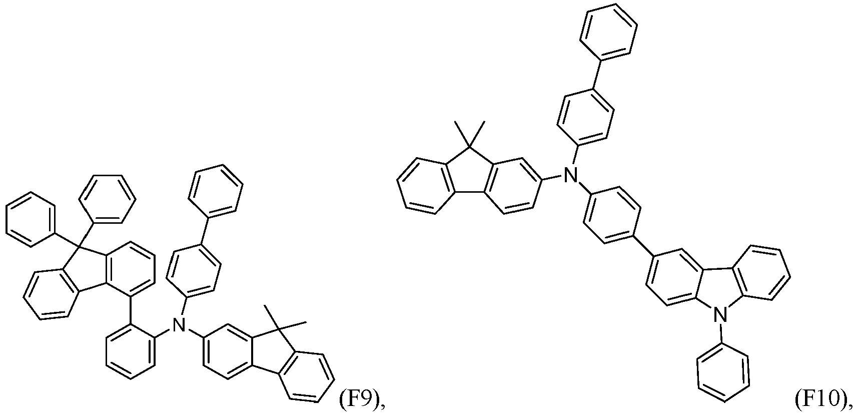

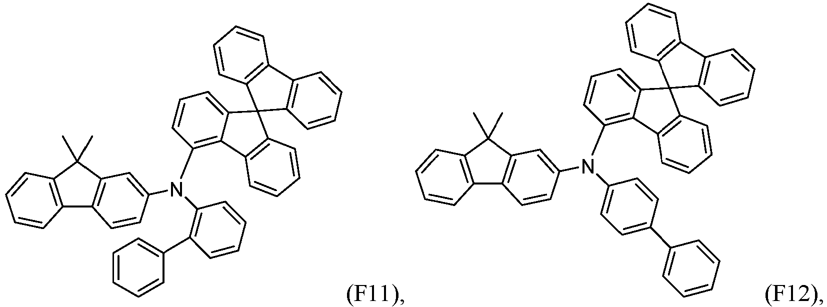

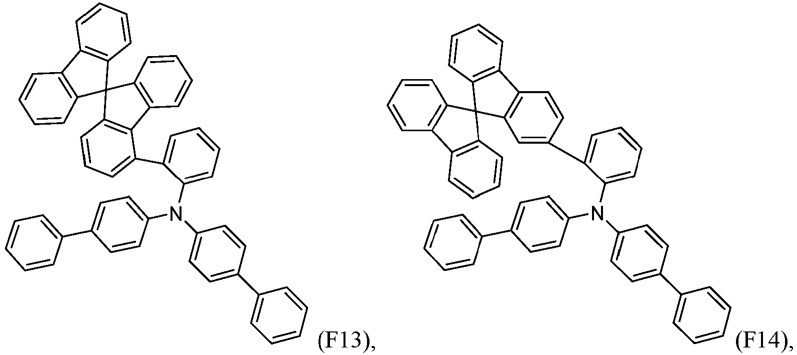

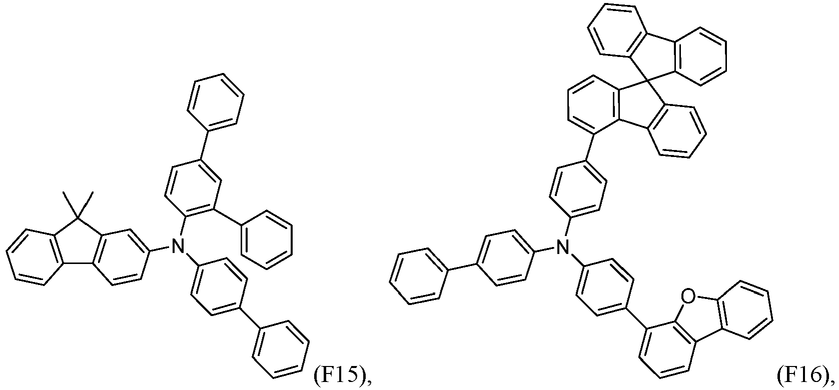

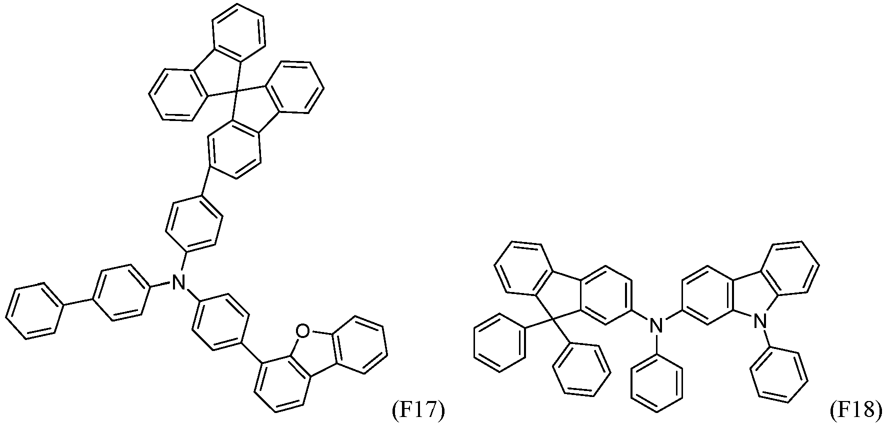

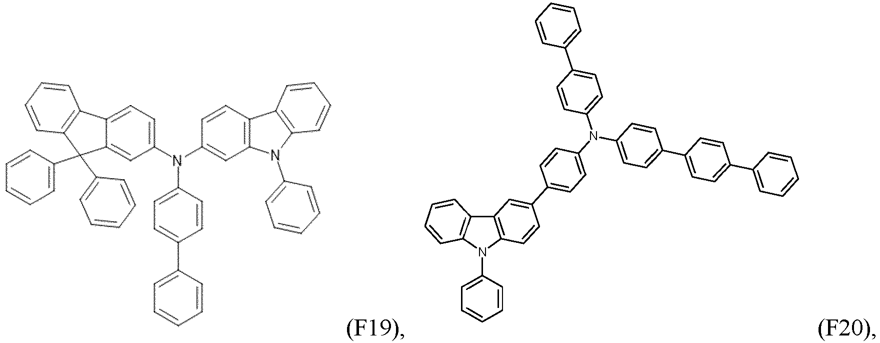

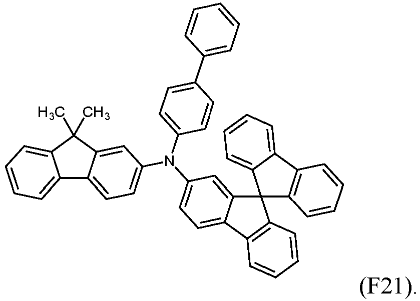

Matrix compounds may be suitable used in an electron-blocking layer selected from F22 to F25:

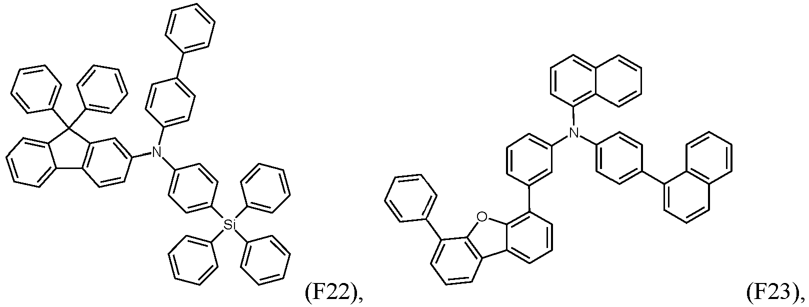

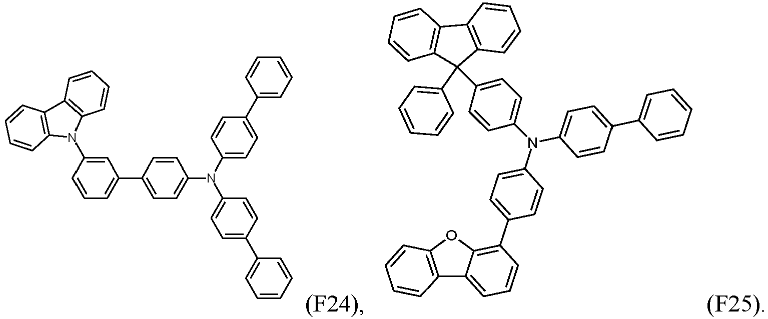

The covalent matrix compound of the hole injection layer may be free of HTM014, HTM081, HTM163, HTM222, EL-301, HTM226, HTM355, HTM133, HTM334, HTM604 and EL-22T. The abbreviations denote the manufacturers' names, for example, of Merck or Lumtec.

According to a furthermore preferred embodiment the covalent matrix compound or substantially covalent matrix compound has the Formula (T-1) to (T-6) as shown in Table 1.

**Table 1**

| Name | Chemical Formula | Calculated HOMO (eV) |
|---|---|---|
| N,N'-Bis-(3-methylphenyl)-N,N'-bis-(phenyl)-benzidine (T-1) | 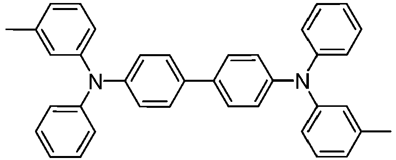 | -4.69 |
| Biphenyl-4-yl(9,9-diphenyl-9H-fluoren-2-yl)-[4-(9-phenyl-9H-carbazol-3-yl)phenyl]-amine (T-2) | 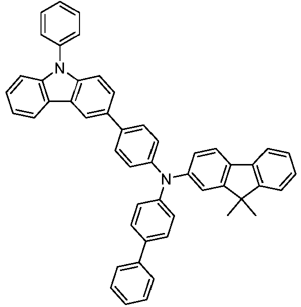 | -4.69 |
| N,N'-Bis(naphthalen-1-yl)-N,N'-bis(phenyl)-benzidine (T-3) | 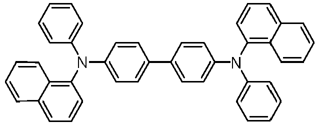 | -4.72 |
| N4,N4,N4',N4'-tetra(biphenyl-4-yl)biphenyl-4,4'-diamine (T-4) | 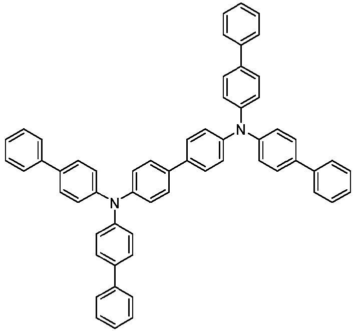 | -4.73 |
| N4,N4"-di(naphthalen-1-yl)-N4,N4"-diphenyl-[1,1':4',1"-terphenyl]-4,4"-diamine (T-5) | 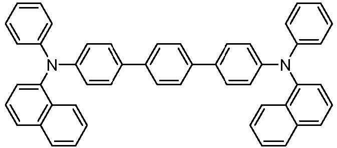 | -4.81 |
| 9,9-dimethyl-N,N-bis(4-(naphthalen-1-yl)phenyl)-9H-fluoren-2-amine (T-6) | 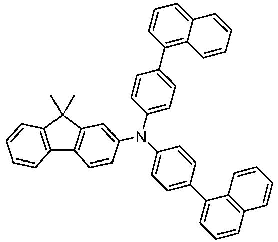 | -4.84 |

According to another aspect, the at least common first semiconductor layer, preferably a common HIL, and /or the common second semiconductor layer, preferably an HTL, may comprises a covalent matrix compound or substantially covalent matrix compound and may comprise at least about ≥ 0.1 wt.-% to about ≤ 50 wt.-%, preferably about ≥ 1 wt.-% to about ≤ 25 wt.-%, and more preferred about ≥ 2 wt.-% to about ≤ 15 wt.-%, of a covalent matrix compound or substantially covalent matrix compound, preferably of formula (2) or formula (3).

According to one embodiment, wherein the common semiconductor layer is arranged between the anode layer and the light emitting layer, preferably the common semiconductor layer is a common hole injection layer, or the common semiconductor layers are a common hole injection layer and a common hole transport layer.

### Further layers

In accordance with the invention, the organic light-emitting diode may comprise, besides the layers already mentioned above, further layers or common layers. Exemplary embodiments of respective layers or common layers are described in the following.

### Substrate

The substrate may be any substrate that is commonly used in manufacturing of electronic devices, preferably organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

### Anode electrode

Every individual pixel may have its own anode that may not touch anodes of other individual pixels.

The anode electrode also named anode layer may be formed by depositing or sputtering a material that is used to form the anode electrode. The anode or anode layer is not formed as a common anode layer. The material used to form the anode electrode may be a high work-function material, so as to facilitate hole injection. The anode material may also be selected from a low work function material (i.e. aluminum). The anode electrode may be a transparent or reflective electrode. Transparent conductive oxides, preferably indium tin oxide (ITO), indium zinc oxide (IZO), tin-dioxide (SnO2), aluminum zinc oxide (AlZO) and zinc oxide (ZnO), may be used to form the anode electrode. The anode electrode may also be formed using metals, typically silver (Ag), gold (Au), or metal alloys.

According to one embodiment, wherein the anode layer may comprise a first anode sub-layer comprising or consisting of Ag or Au, a second anode-sub-layer comprising or consisting of ITO or IZO and optionally a third anode sub-layer comprising or consisting of ITO or IZO. Preferably the first anode sub-layer may comprise or consists of Ag, the second anode-sublayer may comprise or consists of ITO and the third anode sub-layer may comprise or consists of ITO. Preferably, the transparent conductive oxide in the second and third anode sub-layer may be selected the same.

According to one embodiment, wherein the anode layer may comprise a first anode sub-layer comprising Ag or Au having a thickness of 100 to 150 nm, a second anode-sub-layer comprising ITO or IZO having a thickness of 3 to 20 nm and a third anode sub-layer comprising ITO or IZO having a thickness of 3 to 20 nm.

### Anode sub-layer

The anode layer may comprise a first anode sub-layer and a second anode sub-layer, wherein the first anode sub-layer comprises a first metal having a work function in the range of ≥ 4 and ≤ 6 eV, and the second anode sub-layer comprises a transparent conductive oxide (TCO).

Every individual pixel may have its own anode that may not touch anodes of other individual pixels. The anode sub-layers are not formed as a common layer.

According to one embodiment the anode layer comprises a first anode sub-layer and a second anode sub-layer and optional a third anode sub layer, wherein the first anode sub-layer comprises a first metal having a work function in the range of ≥ 4 and ≤ 6 eV, and the second anode sub-layer comprises a transparent conductive oxide (TCO); wherein the hole injection layer is arranged between the first light emitting layer and the anode layer, the first anode sub-layer is arranged closer to the substrate, and the second anode sub-layer is arranged closer to the common hole injection layer.

### First anode sub-layer

According to one embodiment, wherein the first metal of the first anode sub-layer may have a work function in the range of ≥ 4.2 and ≤ 6 eV. The first metal may be selected from a metal or a metal alloy.

According to one embodiment, wherein the first metal of the first anode sub-layer may be selected from the group comprising Ag, Mg, Al, Cr, Pt, Au, Pd, Ni, Nd, Ir, preferably Ag, Au or Al, and more preferred Ag.

The first anode sub-layer may have a thickness in the range of 5 to 200 nm, alternatively 8 to 180 nm, alternatively 8 to 150 nm, alternatively 100 to 150 nm.

The first anode sub-layer may be formed by depositing the first metal via vacuum thermal evaporation.

It is to be understood that the first anode layer is not part of the substrate.

### Second anode sub-layer

According to one embodiment, wherein the transparent conductive oxide may be selected from the group comprising indium tin oxide (ITO) or indium zinc oxide (IZO), more preferred indium tin oxide (ITO). preferably ITO or IZO.

The first anode sub-layer may have a thickness in the range of 3 to 200 nm, alternatively 3 to 180 nm, alternatively 3 to 150 nm, alternatively 3 to 20 nm.

The second anode sub-layer may be formed by sputtering of the transparent conductive oxide.

### Third anode sub-layer

According to one embodiment the anode layer of the organic light-emitting diode may comprise at least three anode sub-layers of a first anode sub-layer, a second anode sub-layer and third anode sub-layer. According to one embodiment the anode layer of the organic light-emitting diode may comprise in addition to the first and second anode sub-layers a third anode sub-layer, wherein the third anode sub-layer comprises a transparent conductive oxide, wherein the third anode sub-layer may be arranged between the substrate and the first anode sub-layer.

The third anode sub-layer may have a thickness in the range of 3 to 200 nm, alternatively 3 to 180 nm, alternatively 3 to 150 nm, alternatively 3 to 20 nm.

The third anode sub-layer may be formed by sputtering of the transparent conductive oxide.

It is to be understood that the third anode layer is not part of the substrate.

### Hole injection layer

The common hole injection layer (HIL), also named common first hole injection layer (HIL), is formed for the plurality of OLED pixels in the OLED display. In one embodiment, the common HIL extends over all pixels of the plurality of pixels or extends over at least two pixels of the plurality of pixels in the OLED display.

Every individual pixel may have its own anode that may not touch anodes of other individual pixels.

Further, the active OLED display has driving circuit configured to separately drive the individual pixels of the plurality of pixels provided in the OLED display. In one embodiment, a step of separately driving may comprise separate control of the driving current applied the individual pixels.

The common HIL comprises an organic p-dopant, wherein the organic p-dopant may comprise in addition a matrix compound of an organic compound. According to one embodiment the hole injection layer comprises a organic p-dopant and optional a matrix compound selected from an organic compound and/or a metal compound.

According to another embodiment the hole injection layer comprises in addition a matrix compound that can be an organic compound.

It is to be understood that the HIL material consists of one or more HIL compounds, whereas the term hole injection material is a broader term used throughout this application for all semiconducting materials comprising at least one hole injection material compound. The hole injection matrix material may consist of one or more organic compounds.

The LUMO energy level of the organic p-dopant, expressed in the absolute scale referring to vacuum energy level being zero, when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, may be selected from ≤ -3.5 eV, ≤ -3.6 eV, ≤ - 3.7 eV, ≤ -3.8 eV, ≤ -3.9 eV ≤ -4.0 eV ≤ -4.5 eV, ≤ -4.6 eV, ≤ -4.7 eV, ≤ -4.8 eV, ≤ -4.85 eV, and ≤ -4.9 eV.

The common hole injection layer may have a thickness ≥ 1 nm and ≤ 100 nm, preferably ≥ 2 nm and ≤ 50 nm, more preferably ≥ 3 nm and ≤ 40 nm, more preferably ≥ 4 nm and ≤ 30 nm, more preferably ≥ 5 nm and ≤ 20 nm, more preferably ≥ 6 nm and ≤ 15 nm, more preferably ≥ 8 nm and ≤ 10 nm.

The HIL is formed as a common HIL for the plurality of pixels or at least two pixels. The common HIL may extend over all pixels of the plurality of pixels or extends over at least two pixels of the plurality of pixels in the OLED display.

The hole injection layer (HIL) is formed as a common hole injection layer (HIL) on anode electrodes, wherein the anode electrode is not formed as a common anode electrode layer, for example by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the common HIL. In general, however, conditions for vacuum deposition may include a deposition temperature of 100° C to 500° C, a pressure of 10⁻⁸ to 10⁻³ Torr (1 Torr equals 133.322 Pa), and a deposition rate of 0.1 to 10 nm/sec.

When the common HIL is formed using spin coating or printing, coating conditions may vary according to the compound that is used to form the common HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

Examples of compounds that may be used to form the common HIL include a phthalocyanine compound, preferably copper phthalocyanine (CuPc), 4,4',4"-tris (3-methylphenylphenylamino) triphenylamine (m-MTDATA), TDATA, 2T-NATA, polyaniline/dodecyl benzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

The common HIL comprise or consist of p-type dopant and the p-type dopant may be selected from tetrafluoro-tetracyanoquinonedimethane (F4TCNQ), 2,2'-(perfluoronaphthalen-2,6-diylidene) dimalononitrile or 2,2',2"-(cyclopropane-1,2,3-triylidene)tris(2-(p-cyanotetrafluorophenyl)acetonitrile) but not limited hereto. The common HIL may be selected from a hole-transporting covalent matrix compound doped with a p-type dopant. Typical examples of known doped hole transport materials are: copper phthalocyanine (CuPc), which 59 HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; α-NPD (N,N'-Bis(naphthalen-1-yl)-N,N'-bis(phenyl)-benzidine) doped with F4TCNQ. α-NPD doped with 2,2'-(perfluoronaphthalen-2,6-diylidene) dimalononitrile. The p-type dopant concentrations can be selected from 1 to 20 wt.-%, more preferably from 3 wt.-% to 10 wt.-%.

According to one embodiment of the organic electronic device, wherein the common hole injection layer may comprise a common first hole injection sub-layer comprising the organic p-dopant and optional a metal compound and a common second hole injection sub-layer comprising the covalent matrix compound or substantially covalent matrix compound.

According to another embodiment of the organic electronic device, wherein the common hole injection layer may comprise a common first hole injection sub-layer comprising the organic p-dopant and optional a metal compound and a common second hole injection sub-layer comprising the covalent matrix compound or substantially covalent matrix compound, wherein the common first hole injection sub-layer is arranged closer to the anode layer comprising a first anode sub-layer and a second anode sub-layer and the common second hole injection sub-layer is arranged closer to the at least one light emitting layer.

According to one embodiment of the organic electronic device, wherein the common hole injection layer may comprise a common first hole injection sub-layer comprising the organic p-dopant and optional a metal compound and a common second hole injection sub-layer comprising a covalent matrix compound comprising of at least one arylamine compound, diarylamine compound, triarylamine compound, wherein the common first hole injection sub-layer is arranged closer to the anode layer and the common second hole injection sub-layer is arranged closer to the at least one light emitting layer.

According to one embodiment the hole injection layer material can be selected from a compound of formula H1 toH12:

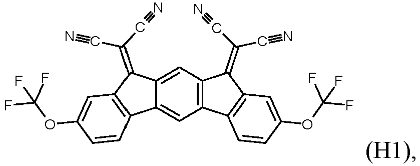

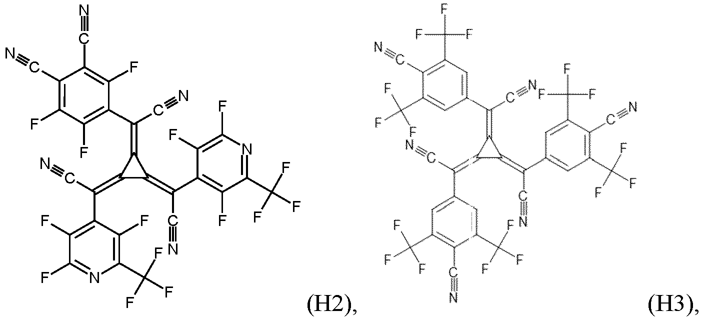

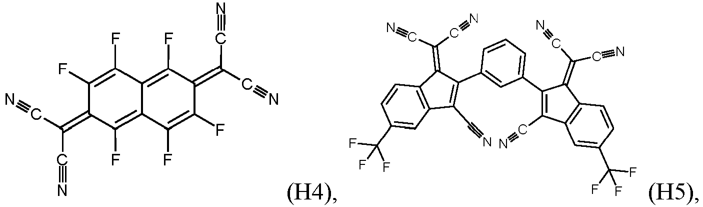

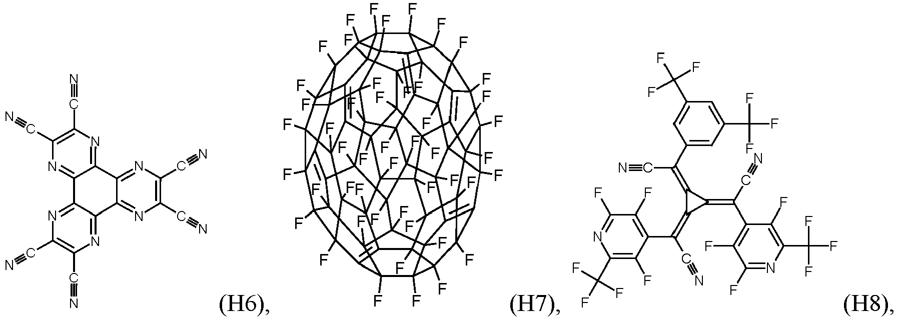

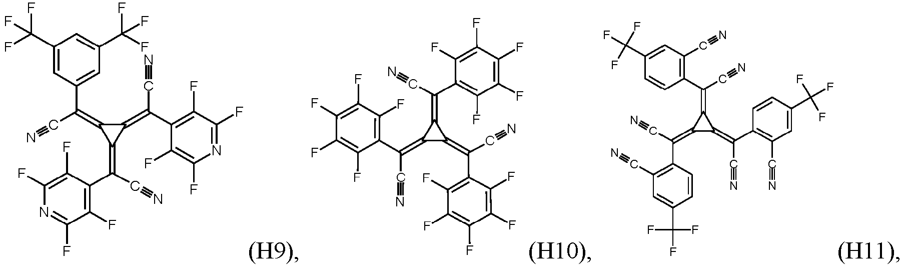

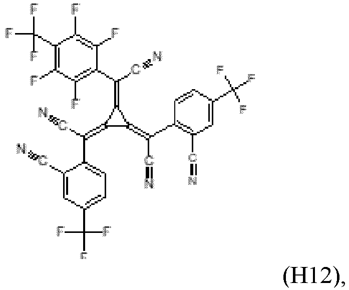

### Hole transport layer (HTL)

The HTL is formed as a common HTL for the plurality of pixels or at least two pixels. The common HTL may extend over all pixels of the plurality of pixels or extends over at least two pixels of the plurality of pixels in the OLED display.

A hole transport layer (HTL) may be formed on the common HIL by vacuum deposition, spin coating, slot-die coating, printing, casting, Langmuir-Blodgett (LB) deposition, or the like.

When the common hole transport layer (HTL) is formed by vacuum deposition or spin coating, the conditions for deposition and coating may be similar to those for the formation of the HIL. However, the conditions for the vacuum or solution deposition may vary, according to the compound that is used to form the hole transport layer (HTL) or common hole transport layer (HTL).

In one embodiment, wherein the organic light-emitting diode further comprises the common hole transport layer (HTL), wherein the hole transport layer (HTL) or common hole transport layer (HTL) is arranged between the common hole injection layer and the at least one emission layer.

In one embodiment, wherein the common hole transport layer (HTL) comprises a covalent matrix compound or substantially covalent matrix compound.

In one embodiment, wherein the at least one common hole injection layer and the common hole transport layer (HTL) comprise a covalent matrix compound or substantially covalent matrix compound, wherein the covalent matrix compound or substantially covalent matrix compound is selected the same in both layers.

The common hole transport layer (HTL) may be formed for the plurality of OLED pixels in the OLED display. Similarly, the cathode may be formed as a common cathode for the plurality of pixels or at least two pixels. The common cathode may extend over all pixels of the plurality of pixels or extends over at least two pixels of the plurality of pixels in the OLED display. Every individual pixel may have its own anode that may not touch anodes of other individual pixels. Further, the active OLED display has driving circuit configured to separately drive the individual pixels of the plurality of pixels provided in the OLED display. In one embodiment, a step of separately driving may comprise separate control of the driving current applied the individual pixels.

The common HTL can be made of a hole transport matrix (HTM) material doped with a hole injection material. The hole transport matrix material may be doped with more than one hole injection material. It is to be understood that the HTM material consists of one or more HTM com- pounds, whereas the term hole transport material is a broader term used throughout this application for all semiconducting materials comprising at least one HTM compound. The hole transport matrix material may consist of one or more organic compounds.

The HTM may comprise or consist of compounds having energies of their highest occupied molecular orbitals, expressed in the absolute scale referring to vacuum energy level being zero, in the range from calculated using the hybrid functional B3LYP with a Gaussian 6-31G* basis set as implemented in the program package TURBOMOLE V6.5, in the range from < -4.27 eV to ≥ -6.0 eV, < -4.3 eV to ≥-5.5 eV, preferably <-4.5 eV to ≥-5.4 eV, more preferably from -<-4.6 eV to ≥-5.3 eV. The anode may be made of a transparent conductive oxide (TCO), like indium tin oxide (ITO). Alternatively, the anode may be made of one or more thin metallic layers leading to a semitransparent anode. In another embodiment, the anode may be made of a thick metallic layer which is not transparent to visible light.

In one embodiment, the work function of the anode, expressed in the absolute scale referring to vacuum energy level being zero, may be less than 500 meV, less than 450 meV, less than 400 meV, less than 350 meV, or less than 300 meV above the highest LUMO energy level of compounds forming the hole injection material in the common hole injection layer.

Typical examples of known doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; α-NPD (N,N'-Bis(naphthalen-1-yl)-N,N'-bis(phenyl)-benzidine) doped with F4TCNQ. α-NPD doped with 2,2'-(perfluoronaphthalen-2,6-diylidene) dimalononitrile. The hole injection material concentrations can be selected from 1 to 20 wt.-%, more preferably from 3 wt.-% to 10 wt.-%.

### Electron blocking layer

The electron blocking layer (EBL) is a common electron blocking layer (EBL). The EBL may be formed as a common EBL for the plurality of pixels or at least two pixels. The common EBL may extend over all pixels of the plurality of pixels or extends over at least two pixels of the plurality of pixels in the OLED display.

The function of an electron blocking layer (EBL) is to prevent electrons from being transferred from a light emitting layer to the hole transport layer and thereby confine electrons to the light emitting layer. The EBL is in direct contact with the common HTL and the EML. The electron blocking layer may be a non-doped layer (or in other words, it may be free of a hole injection material) made of an organic hole transport matrix material. The composition of the organic hole transport matrix material of the common hole transport layer may be the same as the composition of the organic hole transport matrix material of the electron blocking layer. In another embodiment of the invention, the composition of both hole transport matrix materials may be different.

Thereby, efficiency, operating voltage and/or lifetime may be improved. Typically, the electron blocking layer comprises a triarylamine compound. The triarylamine compound may have a LUMO level closer to vacuum level than the LUMO level of the hole transport layer. Each compound forming the electron blocking layer may have a HOMO level, expressed in the absolute scale referring to vacuum energy level being zero, higher than a HOMO level of any compound forming the hole transport matrix material of the common hole transport layer. The electron blocking layer may have a HOMO level that is further away from vacuum level compared to the HOMO level of the hole transport layer.

The organic matrix material of the electron blocking layer may have a hole mobility which is equal to or higher than the hole mobility of the matrix material of the hole transport layer. The hole transport matrix (HTM) material of the common HTL and/or of the EBL may be selected from compounds comprising a conjugated system of delocalized electrons, the conjugated system comprising lone electron pairs of at least two tertiary amine nitrogen atoms.

If the electron blocking layer has a high triplet level, it may also be described as triplet control layer. The function of the triplet control layer is to reduce quenching of triplets if a phosphorescent green or blue light emitting layer is used. Thereby, higher efficiency of light emission from a phosphorescent light emitting layer can be achieved. The triplet control layer is selected from triarylamine compounds with a triplet level above the triplet level of the phosphorescent emitter in the adjacent light emitting layer. Suitable compounds for the triplet control layer, in particular the triarylamine compounds, are described in EP 2 722 908 A1.

The thickness of the electron blocking layer may be selected between 2 and 20 nm. The EBL may have a layer thickness of more than 30 nm, more than 50 nm, more than 70 nm, more than 100 nm, or more than 110 nm. The thickness of the EBL may be less than 200 nm, less than 170 nm, less than 140 nm, or less than 130 nm. Compared to the EBL, the common HTL may be thinner by about one order of magnitude.

The electron blocking layer may comprise a compound, wherein the compound have energies of their highest occupied molecular orbitals, expressed in the absolute scale referring to vacuum energy level being zero, calculated using the hybrid functional B3LYP with a Gaussian 6-31G* basis set as implemented in the program package TURBOMOLE V6.5, in the range from < -4.7 eV to ≥ -6.0 eV, < -4.8 eV to ≥-5.5 eV, preferably <-4.9 eV to ≥-5.4 eV, more preferably from -<-5.0 eV to ≥-5.3 eV.

### Photoactive layer (PAL)

The photoactive layer converts an electrical current into photons or photons into an electrical current. The photoactive layer may be formed as a common photoactive layer or as separate layers, which are not a common photoactive layer. The PAL may be formed as a common PAL for the plurality of pixels or at least two pixels. The common PAL may extend over all pixels of the plurality of pixels or extends over at least two pixels of the plurality of pixels in the OLED display.

The PAL may be formed on the HTL by vacuum deposition, spin coating, slot-die coating, printing, casting, LB deposition, or the like. When the PAL is formed using vacuum deposition or spin coating, the conditions for deposition and coating may be similar to those for the formation of the HIL. However, the conditions for deposition and coating may vary, according to the compound that is used to form the PAL.

It may be provided that the photoactive layer does not comprise the organic p-dopant of the present invention.

### Light emitting layer (EML)

The EML layer may be formed as a common EML layer or as separate EML layers, which are not a common EML layer. For RGB displays it is preferred that the EML layer is formed as separate layers, which are not a common EML layer. The EML may be formed as a common EML for the plurality of pixels or at least two pixels. The common EML may extend over all pixels of the plurality of pixels or extends over at least two pixels of the plurality of pixels in the OLED display.

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

The common electron transport layer may comprise an organic electron transport matrix (ETM) material. Further, the common electron transport layer may comprise one or more n-dopants- Suitable compounds for the ETM contain aromatic or heteroaromatic structural moieties, as disclosed e.g. in documents EP 1 970 371 A1 or WO 2013/079217 A1.

It may be provided that the light emitting layer does not comprise the organic p-dopant as described in the present invention for use in HIL and/or HTL.

The light emitting layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters; however, fluorescent red emitter dopants could also be used.

Examples of phosphorescent green emitter dopants are Ir(ppy)3 (ppy = phenylpyridine), Ir(ppy)2(acac), Ir(mpyp)3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the light emitting layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

### Hole blocking layer (HBL)

The hole blocking layer (HBL) may be formed as a common hole blocking layer (HBL) or as separate hole blocking layers (HBL), which are not a common hole blocking layer (HBL). The HBL may be formed as a common HBL for the plurality of pixels or at least two pixels. The common HBL may extend over all pixels of the plurality of pixels or extends over at least two pixels of the plurality of pixels in the OLED display.

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and triazine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

### Electron transport layer (ETL)

The electron transport layer (ETL) may be formed as a common electron transport layer (ETL) or as separate electron transport layers (ETL), which are not a common electron transport layer (ETL).

The ETL may be formed as a common ETL for the plurality of pixels or at least two pixels. The common ETL may extend over all pixels of the plurality of pixels or extends over at least two pixels of the plurality of pixels in the OLED display.

Every individual pixel may have its own ETL that may not touch ETLs of other individual pixels.

The organic light-emitting diode according to the present invention may further comprise an electron transport layer (ETL).

According to another embodiment , the electron transport layer may further comprise an azine compound, preferably a triazine compound.

In one embodiment, wherein the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the EIL is within this range, the ETL may have satisfactory electron-injecting properties, without a substantial penalty in driving voltage.

According to another embodiment , the organic light-emitting diode may further comprise a hole blocking layer and an electron transport layer, wherein the hole blocking layer and the electron transport layer comprise an azine compound. Preferably, the azine compound is a triazine compound.

### Electron injection layer (EIL)

The EIL may be formed as a common EIL layer or as separate EIL layers, which are not a common EIL layer.

The EIL may be formed as a common EIL for the plurality of pixels or at least two pixels. The common EIL may extend over all pixels of the plurality of pixels or extends over at least two pixels of the plurality of pixels in the OLED display.

An optional EIL, which may facilitate injection of electrons from the cathode, may be formed on the ETL, preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

### Cathode electrode

The cathode electrode may be formed as a common cathode electrode layer or as separate cathode electrode layers, which are not a common cathode electrode layer.

The cathode may be formed as a common cathode for the plurality of pixels or at least two pixels. The common cathode may extend over all pixels of the plurality of pixels or extends over at least two pixels of the plurality of pixels in the OLED display.

The cathode electrode, also named cathode layer, is formed on the ETL or optional EIL.

The cathode can be made of a metal or a metal alloy with a low work function. Transparent cathodes made of a TCO are also well-known in the art. Preferably the cathode electrode may be formed of a metal, an alloy, an electrically conductive compound, or a mixture thereof. The cathode electrode may have a low work function. For example, the cathode electrode may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, , preferably ITO or IZO.

The thickness of the cathode electrode may be in the range from about 5 nm to about 1000 nm, for example, in the range from about 10 nm to about 100 nm. When the thickness of the cathode electrode is in the range from about 5 nm to about 50 nm, the cathode electrode may be transparent or semitransparent even if formed from a metal or metal alloy.

It is to be understood that the cathode electrode is not part of an electron injection layer or the electron transport layer.

### Stack of organic layers

The stack of organic layers may be made of organic compounds having a molecular weight of less than 2000 g / mol. In an alternative embodiment, the organic compounds may have a molecular weight of less than 1000 g / mol.

The at least two common semiconductor layers, which can be the HIL and the HTL, extend each over all pixels of the plurality of pixels or extends over at least two pixels of the plurality of pixels in the OLED display.

According to one embodiment the HIL and the HTL of the stack of organic layers extend over all pixels of the plurality of pixels or extends over at least two pixels of the plurality of pixels in the OLED display.

According to one embodiment the HIL, HTL and the HBL of the stack of organic layers are formed as common semiconductor layers and extend over all pixels of the plurality of pixels or extends over at least two pixels of the plurality of pixels in the OLED display.

According to one embodiment the HIL, HTL and the EBL of the stack of organic layers are formed as common semiconductor layers and extend over all pixels of the plurality of pixels or extends over at least two pixels of the plurality of pixels in the OLED display.

According to one embodiment the HIL, HTL, EBL and the ETL of the stack of organic layers are formed as common semiconductor layers and extend over all pixels of the plurality of pixels or extends over at least two pixels of the plurality of pixels in the OLED display.

According to one embodiment the HIL the HTL and n-side of the stack of organic layers are formed as common semiconductor layers and extend over all pixels of the plurality of pixels or extends over at least two pixels of the plurality of pixels in the OLED display.

According to one embodiment the HIL, HTL, HBL and n-side of the stack of organic layers are formed as common semiconductor layers and extend over all pixels of the plurality of pixels or extends over at least two pixels of the plurality of pixels in the OLED display.

According to one embodiment the HIL, HTL, EBL and n-side of the stack of organic layers are formed as common semiconductor layers and extend over all pixels of the plurality of pixels or extends over at least two pixels of the plurality of pixels in the OLED display.

According to one embodiment the HIL, HTL, EBL, ETL and n-side of the stack of organic layers are formed as common semiconductor layers and extend over all pixels of the plurality of pixels or extends over at least two pixels of the plurality of pixels in the OLED display.

Preferably every individual pixel may have its own ETL that may not touch ETLs of other individual pixels.

Preferably every individual pixel may have its own EML or PAL that may not touch ETLs or PALs of other individual pixels.

Preferably every individual pixel may have its own EBL that may not touch EBLs of other individual pixels.

Preferably every individual pixel may have its own HBL that may not touch HBLs of other individual pixels.

Preferably every individual pixel may have its own n-side that may not touch n-side of other individual pixels.

### Method of manufacture

Another aspect refers to a method for manufacture at least one common layer.

The method for manufacture of at least one common layer comprises, wherein the method for manufacture of at least one common layer comprises that each common layer is deposited onto the complete display area through one large mask opening in one processing step.

Hereinafter, the embodiments are illustrated in more detail with reference to examples. However, the present disclosure is not limited to the following examples. Reference will now be made in detail to the exemplary aspects.

### Description of the Drawings

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiment according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation as claimed.

### Figures 1 to 4

- FIG. 1: is a schematic sectional view of a display with two pixels and a common HIL, a common HTL and a common cathode layer;
- FIG. 2: is a schematic sectional view of a test element;
- FIG. 3: is a schematic sectional view of deposited layer stack.
- FIG. 4: is a schematic sectional view of a test element;

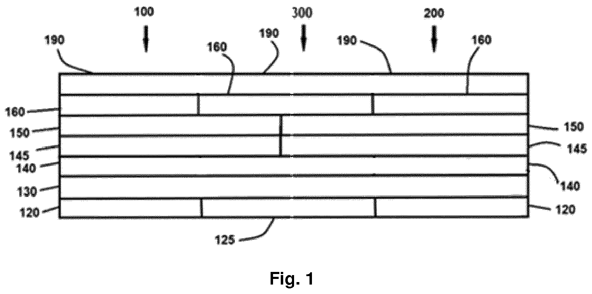

Hereinafter, the figures 1 to 4 are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of a display with two pixels (100; 200), according to an exemplary embodiment. The first pixel (100) comprises an anode layer (120) and the second pixel comprises an anode layer (120). The first pixel (100) has its own anode layer (120) and the second pixel (200) has its own anode (120), wherein the anode (120) of the first pixel (100) does not touch the anode layer (120) of the other second pixels (200). Between anode (120) of the first pixel (100) and the anode (120) of the second pixel (200) a pixel definition layer (125) may be arranged. A common hole injection layer (HIL) (130) is disposed on the anode layers (120) extending from the first pixel (100) to the second pixel (200). Onto the common HIL (130) a common hole transport layer (HTL) (140) is disposed extending from the first pixel (100) to the second pixel (200). Onto the hole transport layer (HTL) (140), an electron blocking layer (EBL) (145) is disposed such that the first pixel (100) has its own electron blocking layer (EBL) (145) and the second pixel (200) has its own electron blocking layer (EBL) (145), the electron blocking layer (EBL) (145) of the first pixel (100) can touch the electron blocking layer (EBL) (145) of the other second pixels (200). Onto the electron blocking layer (EBL) (145), a light emitting layer (EML) (150) is disposed such that the first pixel (100) has its own light emitting layer (EML) (150) and the second pixel (200) has its own light emitting layer (EML) (150), wherein the light emitting layer (EML) (150) of the first pixel (100) can touch the light emitting layer (EML) (150) of the other second pixels (200). Onto the light emitting layer (EML) (150), an electron transport layer (ETL) (160) is disposed such that the first pixel (100) has its own electron transport layer (ETL) (160) and the second pixel (200) has its own electron transport layer (ETL) (160). Onto the electron transport layer (ETL) (160), a common cathode layer (190) is disposed extending from the first pixel (100) to the second pixel (200). Between the first pixel (100) and the second pixel (200) a separation section (300) is arranged that has no anode layer (120) but a pixel definition layer (125) function as a sheet resistance layer, which is not an anode (120).

As can be seen in Fig. 1 the separation section (300) comprises at least one layer, which is a common hole injection layer (HIL) (130) and extends as a common layer from pixel (100) through the separation section (300) to pixel (200). The separation section (300) comprises at least two layers that are an electron blocking layer (EBL) (145) and a light emitting layer (EML) (150), which each extends from the pixel (100) and pixel (200) into the separation section (300). The electron transport layer (ETL) (160) and the hole transport layer (HTL) (140) of the separation section (300), do not extend into the pixel (100) and pixel (200).

Fig. 1 is an example only and the present invention is not restricted to this embodiment. There are a plurality of layer configuration possible in which a layer for example extends from one pixel into the separation section (300) or not. Further the material composition of each non common layer of the plurality of pixels and separation sections, such as pixel (100), (200) and the separation section (300), can be selected individually different and or same.

Fig. 2 shows the test element comprising 2 highly conductive electrodes with a gap "I" between the 2 highly conductive electrodes and a width "w" for the respective highly conductive electrodes.

Fig. 3 shows schematic representation of a deposited layer stack on a test element group for determining the sheet resistance. The test element consists of a channel (test element). The deposition layer (300) lies on top of the electrode.

Fig. 4 shows the test element comprising 2 highly conductive electrodes with interdigitated finger pattern with a gap "l" between electrode fingers and total width "w" as product of interdigitation width "we" and number of interdigitation areas.

Hereinafter, the embodiments are illustrated in more detail with reference to examples. However, the present disclosure is not limited to the following examples.

### Detailed description

The invention is furthermore illustrated by the following examples which are illustrative only and non-binding.

The compound may be prepared as described in the literature or alternative compounds may be prepared following similar compounds as described in the literature.

### Calculated HOMO and LUMO

The HOMO and LUMO are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected. The HOMO and LUMO levels are recorded in electron volt (eV).

### General procedure for fabrication of OLEDs

For Examples 1 to 18 and Comparative Example 1, a glass substrate with an anode layer comprising a first anode sub-layer of 120 nm Ag, a second anode sub-layer of 8 nm ITO and a third anode sub-layer of 10 nm ITO was cut to a size of 50 mm x 50 mm x 0.7 mm, ultrasonically washed with water for 60 minutes and then with isopropanol for 20 minutes.

Then, substantially covalent matrix compound and a hole injection material were codeposited in vacuum on the anode layer, to form a hole injection layer (HIL). Then, the substantially covalent matrix compound was vacuum deposited on the HIL, to form a HTL having a thickness of 128 nm. The formula of the substantially covalent matrix compound in the HTL was identical to the substantially covalent matrix compound used in the HIL.

Then was vacuum deposited on the HTL, to form an electron blocking layer (EBL) having a thickness of 5 nm.

Then 97 vol.-% H09 (Sun Fine Chemicals, Korea) as EML host and 3 vol.-% BD200 (Sun Fine Chemicals, Korea) as fluorescent blue emitter dopant were deposited on the EBL, to form a blue-emitting first emission layer (EML) with a thickness of 20 nm.

Then a hole blocking layer was formed with a thickness of 5 nm by depositing 2-(3'-(9,9-dimethyl-9H-fluoren-2-yl)-[1,1'-biphenyl]-3-yl)-4,6-diphenyl-1,3,5-triazine on the emission layer EML.

Then the electron transporting layer having a thickness of 31 nm was formed on the hole blocking layer by depositing 50 wt.-% 4'-(4-(4-(4,6-diphenyl-1,3,5-triazin-2-yl)phenyl)naphthalen-1-yl)-[1,1'-biphenyl]-4-carbonitrile and 50 wt.-% of LiQ.

Then the electron injection layer having a thickness of 2 nm was formed on the electron transporting layer by depositing Ytterbium at a rate of 0.01 to 1 Å/s at 10⁻⁷ mbar.

Then Ag:Mg (90:10 vol.-%) was evaporated at a rate of 0.01 to 1 Å/s at 10⁻⁷ mbar to form a cathode layer with a thickness of 100 nm on the electron injection layer.

The OLED stack is protected from ambient conditions by encapsulation of the device with a glass slide. Thereby, a cavity is formed, which includes a getter material for further protection.

To assess the performance of the inventive examples compared to the prior art, the current efficiency is measured at 20°C. The current-voltage characteristic is determined using a Keithley 2635 source measure unit, by sourcing an operating voltage U in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/m² using an Instrument Systems CAS-140CT array spectrometer (calibrated by Deutsche Akkreditierungsstelle (DAkkS)) for each of the voltage values.

Lifetime LT of the device is measured at ambient conditions (20°C) and 30 mA/cm², using a Keithley 2400 source meter, and recorded in hours. The brightness of the device is measured using a calibrated photo diode. The lifetime LT is defined as the time till the brightness of the device is reduced to 97 % of its initial value.

To determine the voltage stability over time U(100h)-(1h), a current density of at 30 mA/cm² was applied to the device. The operating voltage was measured after 1 hour and after 50 hours, followed by calculation of the voltage stability for the time period of 1 hour to 50 hours.

Table 2 shows HTL matrix materials that are more preferred and some are used in Table 4.

**Table 2: HTL matrix materials**

| | |
|---|---|
| 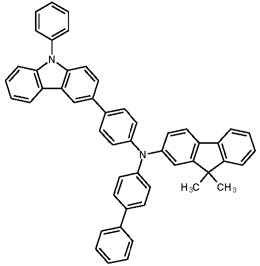 | 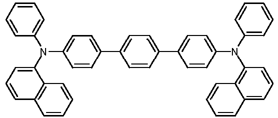 |
| F3 | F2 |
| 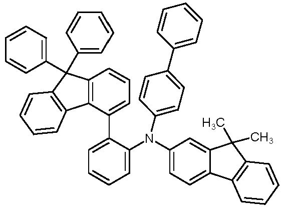 | 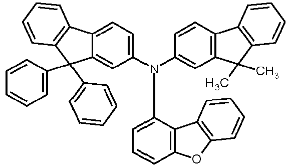 |
| F9 | F4 |
| 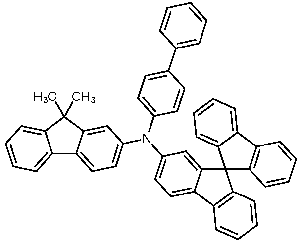 | 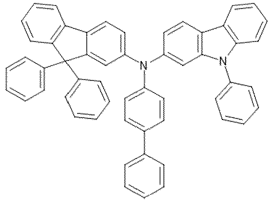 |
| F21 | F19 |
| 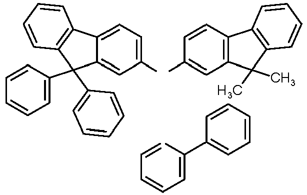 | 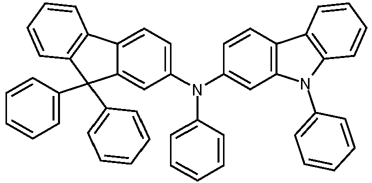 |
| F5 | F18 |
| 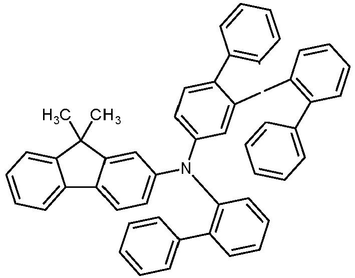 | 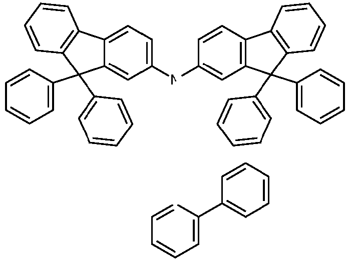 |
| F11 | F6 |
| 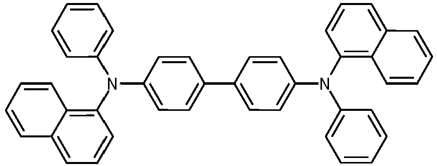 | 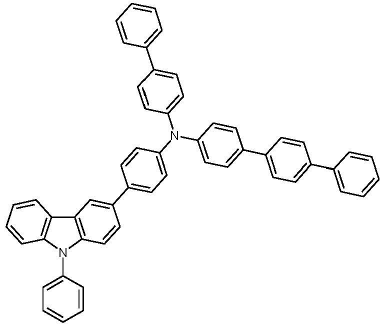 |
| F1 | F20 |

Table 3 shows EBL matrix materials that are more preferred and some are used in Table 4.

**Table 3: EBL matrix materials**

| | |
|---|---|
| 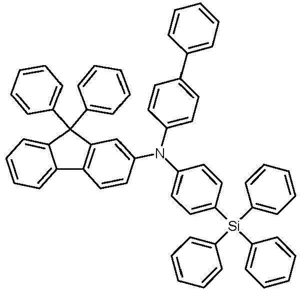 | 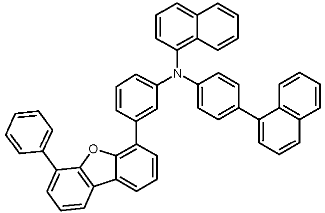 |
| F22 | F23 |
| 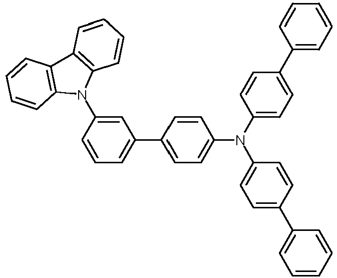 | 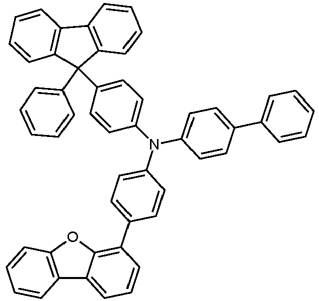 |
| F24 | F25 |

**Table 4**

| | Structure of HIL | HIL (p-dopant concentrat ion [wt%]) | HIL (Host ) | HIL Thickn ess [nm] | HTL | EBL | Rs of HIL + HTL [GΩ/s]** | Rs of HIL, HTL, and EBL [GΩ/s] ** | Rs of HIL, HTL, EBL, EML [GΩ/s] ** | Volta ge [V] at 15 mA/c m | EQE [%] at 15 mA/c m | LT97 at 15 mA/c m |
|---|---|---|---|---|---|---|---|---|---|---|---|---|
| Com parat ive exam ple 1 | 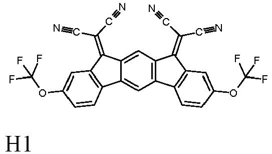 | 100 wt% | - | 10 | F3 | F22 | 2 | 2 | 2 | 3.99 | 13.6 | 100 |
| Inve ntive exam ple 1 | 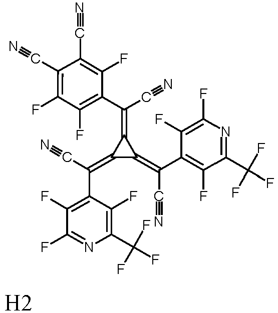 | 2.9 wt% | F9 | 10 | F9 | F23 | 958 | 952 | 949 | 3.84 | 12.4 | 224 |
| Inve ntive exam ple 2 | 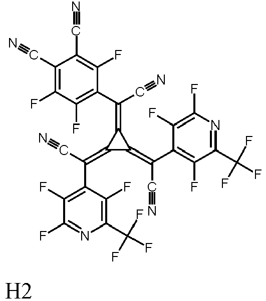 | 2wt% | F5 | 10 | F5 | F22 | 386 | 383 | 380 | 3.70 | 13.8 | 129 |
| Inve ntive exam ple 3 | 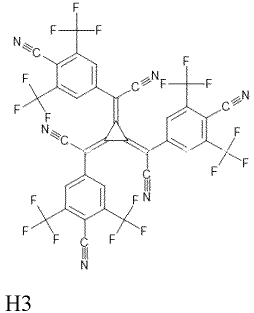 | 1.9 wt% | F9 | 10 | F9 | F23 | 5481 | 5474 | 5470 | 3.85 | 12.6 | 182 |
| Inve ntive exam ple 4 | 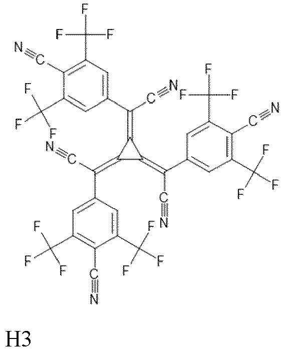 | 1.8 wt% | F5 | 10 | F5 | F22 | 96 | 96 | 96 | 3.68 | 13.8 | 134 |
| Inve ntive exam ple 5 | 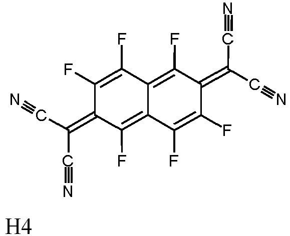 | 10 wt% | F19 | 10 | F19 | F22 | 319 | 316 | 314 | 3.82 | 13.8 | 45 |
| Inve ntive exam ple 6 | 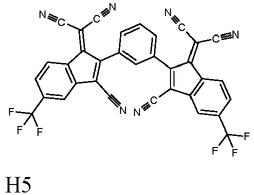 | 10.6wt% | F3 | 10 | F3 | F22 | 298474 | 296470 | 295477 | 3.85 | 14.7 | 292 |
| Inve ntive exam ple 7 | 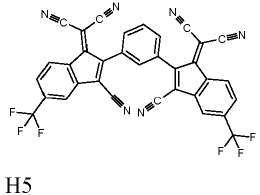 | 100 wt% | - | 2 | F3 | F22 | 25981 | 25731 | 25619 | 3.89 | 15.0 | 81 |
| Inve ntive exam ple 8 | 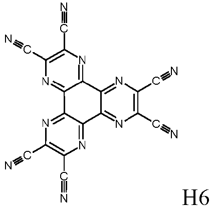 | 100 wt% | - | 5.1 | F3 | F22 | 158 | 157 | 156 | 3.89 | 14.0 | 88 |
| Inve ntive exam ple 9 | 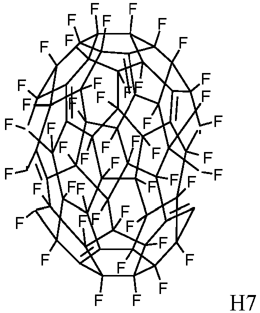 | 1. 69wt% | F18 | 10 | F18 | F24 | 556 | 555 | 553 | 3.61 | 19.8 | 74 |
| Inve ntive exam ple 10 | 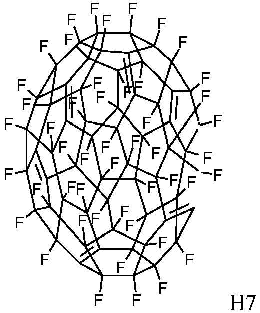 | 8.19 | F9 | 10 | F9 | F24 | 236 | 234 | 232 | 3.68 | 17.8 | 76 |
| Inve ntive exam ple 11 | 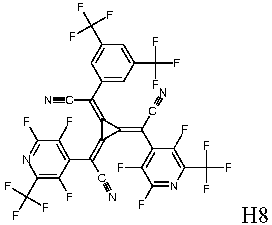 | 5 wt% | F11 | 11 | F11 | F24 | 257 | 255 | 254 | 3.72 | 13.0 | 217 |
| Inve ntive exam ple 12 | 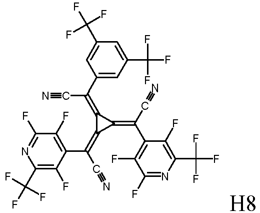 | 9.7 wt% | F5 | 10 | F6 | F24 | 555 | 553 | 549 | 3.88 | 12.8 | 81 |
| Inve ntive exam ple 13 | 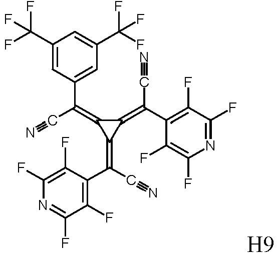 | 11.8 wt% | F3 | 10 | F3 | F25 | 285 | 285 | 284 | 3.82 | 14.3 | 104 |
| Inve ntive exam ple 14 | 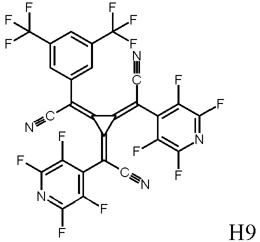 | 100 wt% | - | 0.5 | F3 | F25 | 62 | 62 | 62 | 3.90 | 13.1 | 64 |
| Inve ntive exam ple 15 | 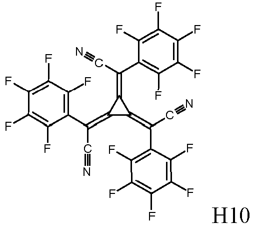 | 100 wt% | - | 0.6 | F3 | F22 | 138 | 138 | 137 | 3.83 | 14.5 | ??? |
| Inve ntive exam ple16 | 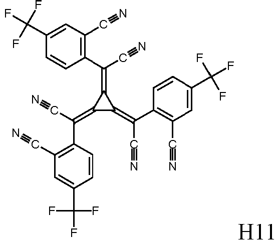 | 100 wt% | - | 1 | F3 | F22 | 204 | 204 | 202 | 3.83 | 13.5 | 83 |
| Inve ntive exam ple 17 | 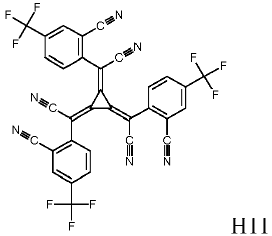 | 100 wt% | - | 2 | F18 | F22 | 405 | 404 | 401 | 3.82 | 14.3 | 80 |
| Inve ntive exam ple 18 | 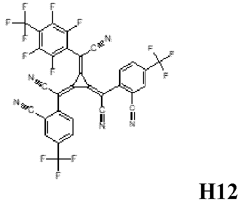 | 20.8 wt.-% | F3 | 12 | F3 | F22 | 570 | 565 | 562 | 3.88 | 13.6 | 92 |

### Technical Effect of the invention

As can be seen from Table 4 the device has a beneficial operational voltage since the operational voltage is low and at the same time the sheet resistance is high or higher as 50 giga ohms per square. Moreover, in addition to the operational voltage the EQE and/or the lifetime is improved.

## Claims

1. An active-matrix OLED display, comprising a plurality of OLED pixels (100; 200; 300), wherein each pixel itself (100; 200; 300) comprises a stack of organic layers and each layer of the stack of organic layers can form a common semiconductor layer, wherein
- at least a first OLED pixel (100) and a second OLED pixel (200) comprising
- an anode layer (120),
- a common cathode layer (190),
- at least one emission layer, which is optional a common emission layer,
- at least a stack of organic layers, wherein the stack of organic layers is arranged between the anode layer (120) and cathode layer (190), comprising
- a plurality of semiconductor layers, and the plurality of semiconductor layers comprising at least two or more common semiconductor layers, wherein the plurality of semiconductor layers comprising
- at least a common first semiconductor layer comprises at least one organic p-dopant,
- at least a common second semiconductor layer,
- a common third semiconductor layer,
- a common semiconductor layer extends over all pixels of the plurality of pixels or extends over at least two pixels of the plurality of pixels in the OLED display,
- wherein the common first semiconductor layer is a common hole injection layer (130),
- wherein the common second semiconductor layer is a common hole transport layer (140),
- wherein the common third semiconductor layer is a common electron blocking layer (145),
- wherein the common hole injection layer (130) is in direct contact with the common hole transport layer (140),
- wherein the common electron blocking layer (145) is in direct contact to the common hole transport layer (140),
- wherein the common second semiconductor layer has a layer thickness of ≥15 nm to ≤230 nm,
- wherein the common third semiconductor layer has a layer thickness of 1 nm to 20 nm,
and
wherein the common first semiconductor comprises at least one organic p-dopant, the common second semiconductor layer and the common third semiconductor layer have together a sheet resistance of ≥ 50 giga ohms per square, wherein the sheet resistance Rs is measured by the transmission line method as described in the description.

2. The active-matrix OLED display according to any of the preceding claim 1, wherein the organic p-dopant is selected from the group comprising a substituted or unsubstituted 3-radialene, a substituted or unsubstituted quinone, a substituted or unsubstituted quinoid, and a substituted or unsubstituted aromatic compound that comprises condensed rings, and more preferred the organic p-dopant is selected from substituted or unsubstituted 3-radialene compounds.

3. The active-matrix OLED display according to claim 2, wherein the 3-radialene compound is represented by Formula (1): 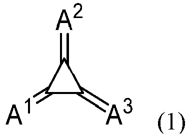 wherein A¹, A² and A³ are independently selected from Formula (2): 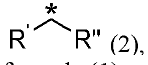 wherein "*" is the binding position of A¹, A² and A³ to the double bond of formula (1),
R' is independently selected from the group comprising substituted or unsubstituted aryl, substituted or unsubstituted heteroaryl, substituted or unsubstituted alkyl, and preferably substituted or unsubstituted C₆ to C₂₄ aryl, substituted or unsubstituted C₂ to C₂₀ heteroaryl, substituted or unsubstituted C₁ to C₈ alkyl;
wherein the substituent on R' is independently selected from the group comprising electron-withdrawing group, CN, halogen, Cl, F, partially fluorinated or perfluorinated alkyl, partially fluorinated or perfluorinated alkoxy, and preferably partially fluorinated or perfluorinated C₁ to C₁₀ alkyl, partially fluorinated or perfluorinated C₁ to C₆ alkoxy, and more preferred CF₃, OCF₃, D or H;
R" is selected from the group comprising an electron-withdrawing group, preferably CN, substituted or unsubstituted alkyl, substituted or unsubstituted heteroaryl, substituted or unsubstituted aryl, perfluorinated alkyl, further preferred substituted or unsubstituted C₁ to C₈ alkyl, substituted or unsubstituted C₂ to C₂₀ heteroaryl, substituted or unsubstituted C₆ to C₂₄ aryl, perfluorinated C₁ to C₈ alkyl, and more preferred CF₃, NO₂ or F;
wherein the substituent on R'' is independently selected from the group comprising electron-withdrawing group, CN, halogen, Cl, F, partially fluorinated or perfluorinated alkyl, partially fluorinated or perfluorinated alkoxy, and preferably partially fluorinated or perfluorinated C₁ to C₁₀ alkyl, partially fluorinated or perfluorinated C₁ to C₆ alkoxy, and more preferred CF₃, OCF₃, D or H;
wherein R' and R'' together optional form a substituted or unsubstituted carbocycle or substituted or unsubstituted heterocycle, preferably substituted or unsubstituted heterocycle;
wherein the substituents are independently selected from the group comprising electron-withdrawing group, F, CN, perfluorinated C₁ to C₈ alkyl, substituted or unsubstituted C₆ to C₁₈ aryl, substituted or unsubstituted C₂ to C₁₈ heteroaryl, substituted or unsubstituted C₃ to C₁₈ carbocyclene, substituted or unsubstituted C₃ to C₁₈ carbocyclidene, substituted or unsubstituted C₁ to C₈ alkylene, substituted or unsubstituted C₁ to C₈ alkylidene;
wherein the substituents are selected from the group comprising an electron-withdrawing group, halogen, F, Cl, CN, perfluorinated alkyl, perfluorinated C₁ to C₈ alkyl, CF₃, partially fluorinated or perfluorinated alkylaryl, partially fluorinated or perfluorinated C₆ to C₁₈ alkylaryl.

4. The active-matrix OLED display according to any of the preceding claims 1 to 3, wherein
R' is independently selected from the group comprising substituted or unsubstituted C₆ to C₂₄ aryl, substituted or unsubstituted C₂ to C₂₀ heteroaryl;
R" is an electron-withdrawing group, preferably R'' is independently selected from the group comprising CN, CF₃, NO₂, or F, and more preferred R'' is CN.

5. The active-matrix OLED display according to any of the preceding claims 1 to 4, wherein A¹, A² and A³ are selected A¹=A²≠A³, or A¹≠A² and A¹≠A³ and A² = A³.

6. The active-matrix OLED display according to any of the preceding claims 1 to 5, wherein A¹ is selected from Formulae (3) or (4): 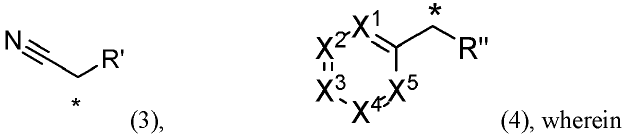
X¹ is selected from CR¹ or N;
X² is selected from CR² or N;
X³ is selected from CR³ or N;
X⁴ is selected from CR⁴ or N;
X⁵ is selected from CR⁵ or N;
R¹, R², R³, R⁴, and R⁵ are independently selected from a group comprising electron-withdrawing group, CN, halogen, Cl, F, partially fluorinated or perfluorinated alkyl, partially fluorinated or perfluorinated C₁ to C₁₀ alkyl, preferably CF₃, partially fluorinated or perfluorinated alkoxy, partially fluorinated or perfluorinated C₁ to C₆ alkoxy, D or H;
wherein at least two of X¹ to X⁵ are independently selected from CR¹ to CR⁵; and
wherein "*"on Formulae (3) and (4) is the binding position of A¹ to the double bond of formula (1).

7. The active-matrix OLED display according to any of the preceding claims 1 to 6, wherein A¹ is selected from a group comprising of D1 to D210: 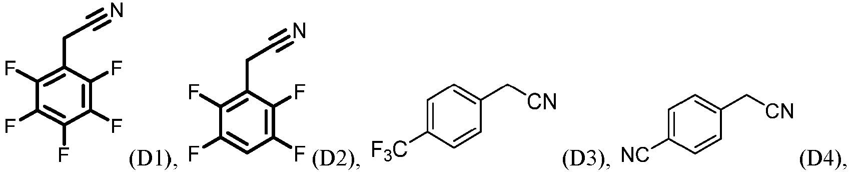 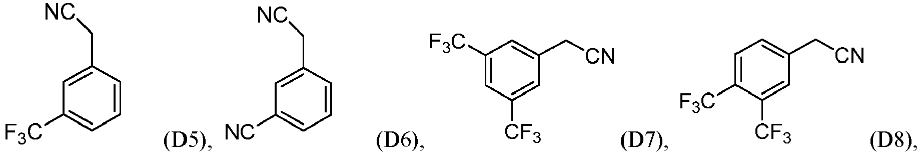 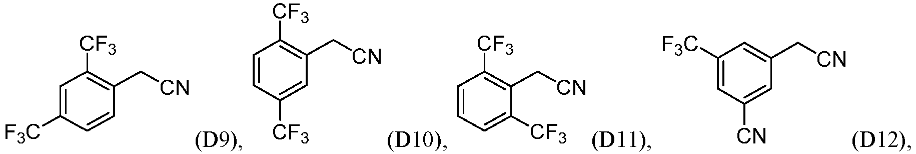 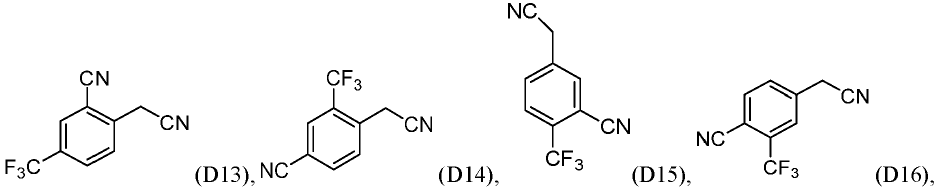 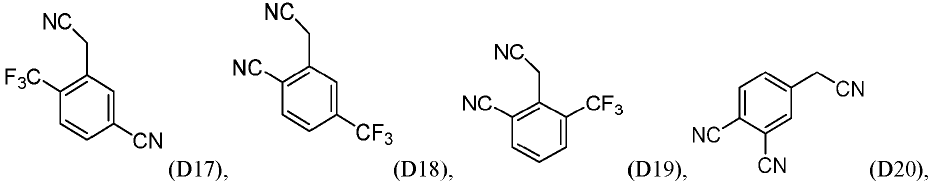 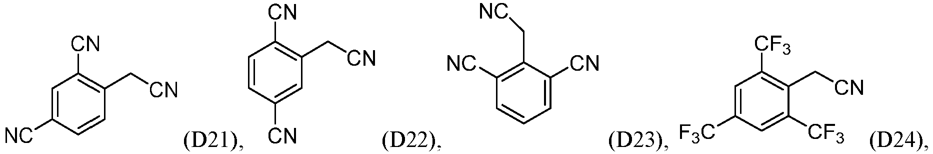 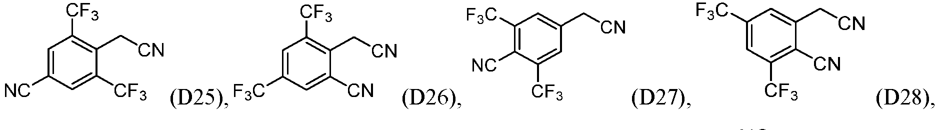 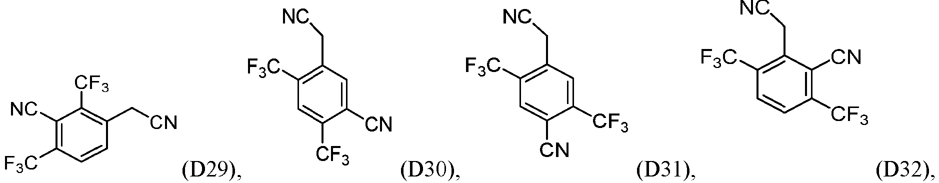 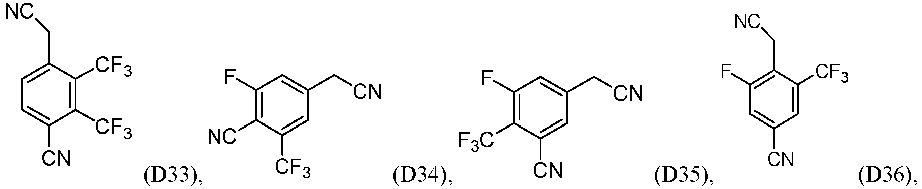 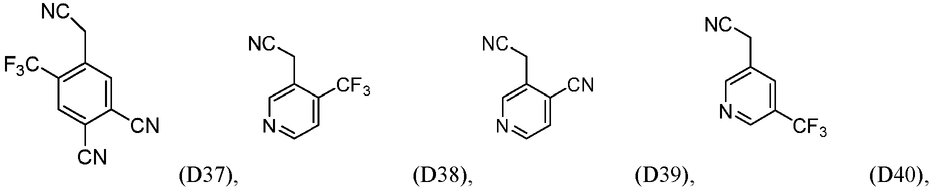 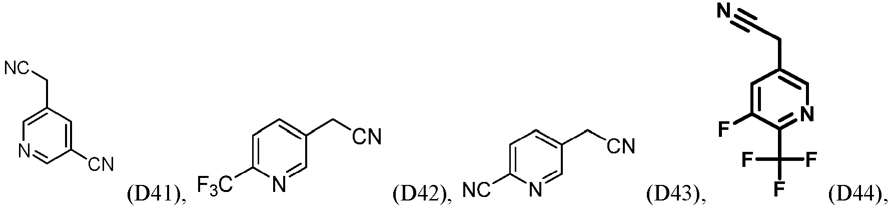 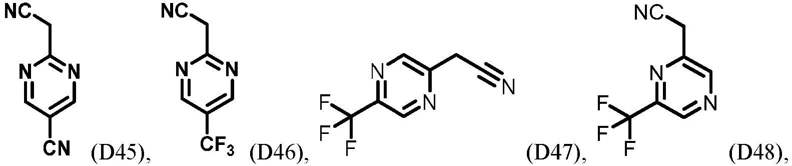 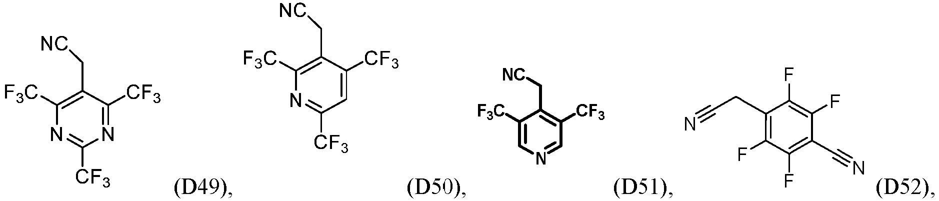 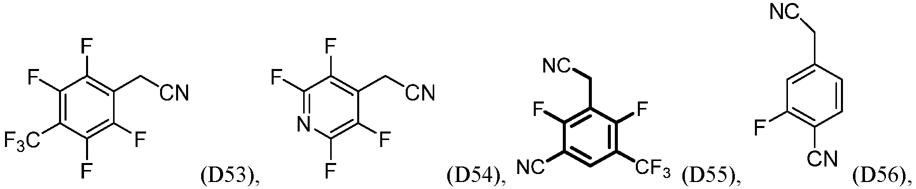 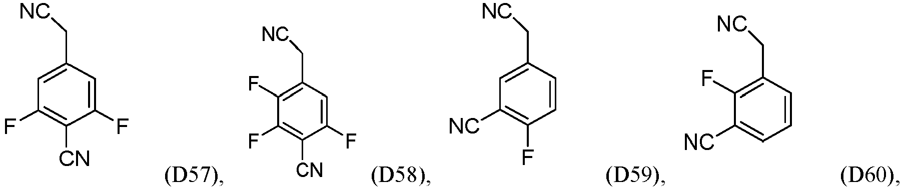 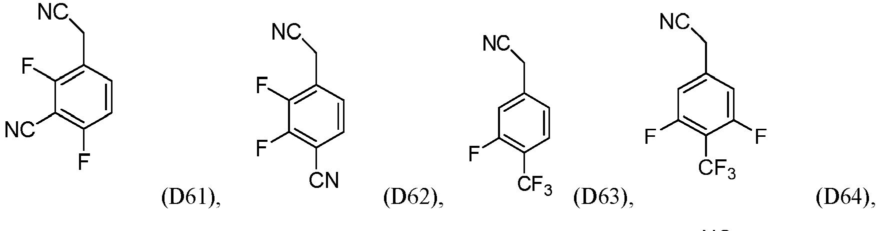 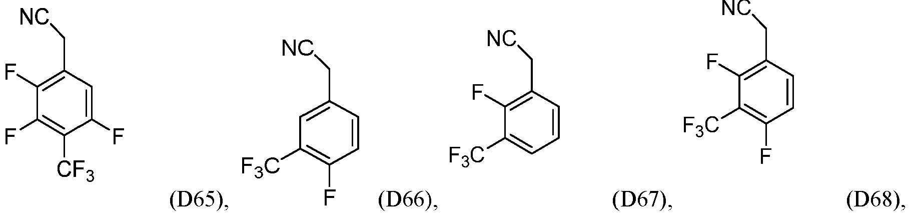 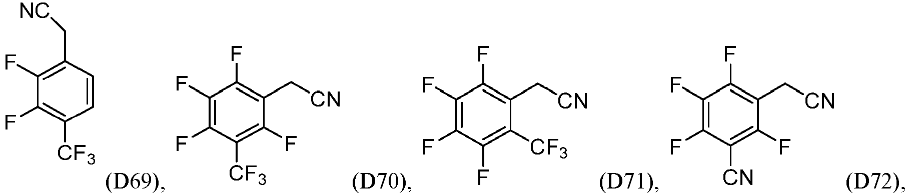 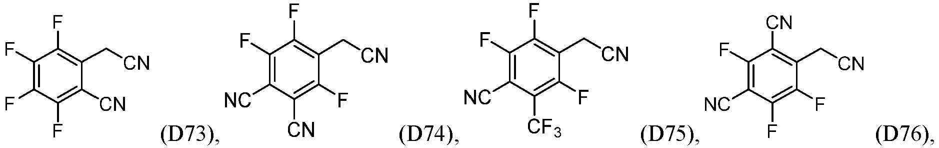 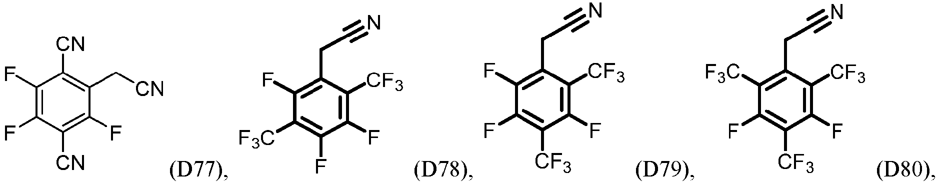 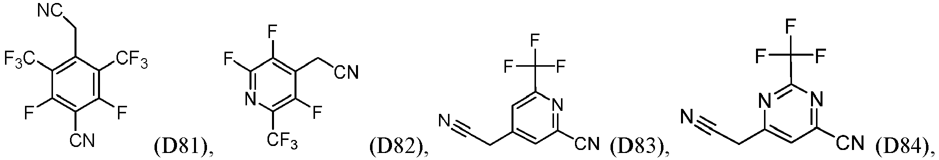 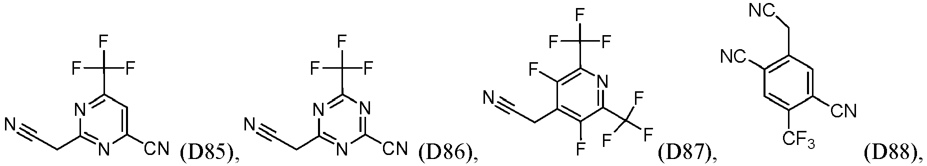 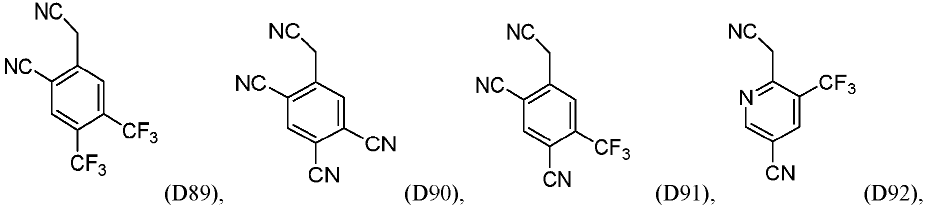 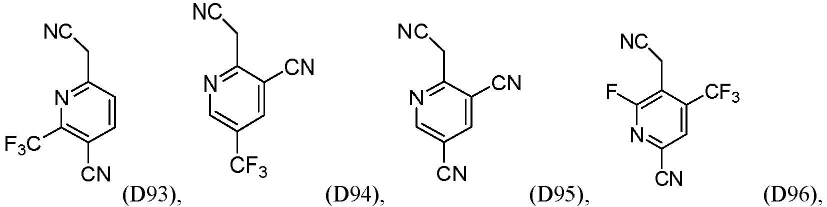 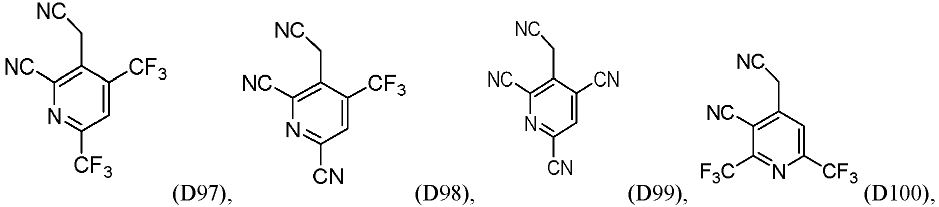 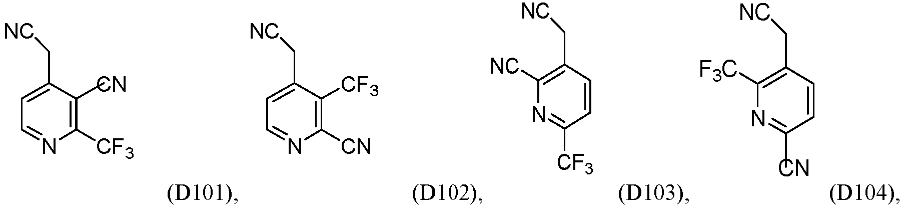 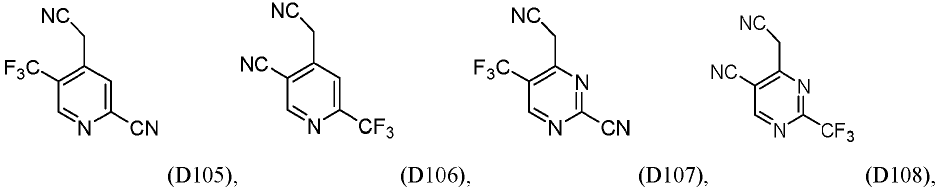 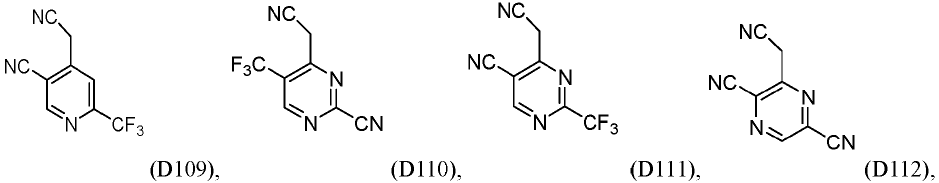 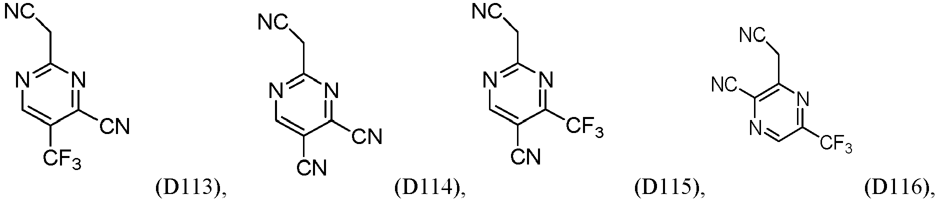 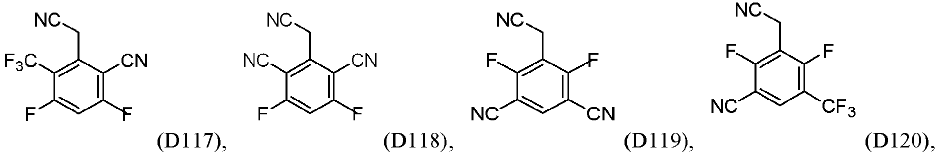 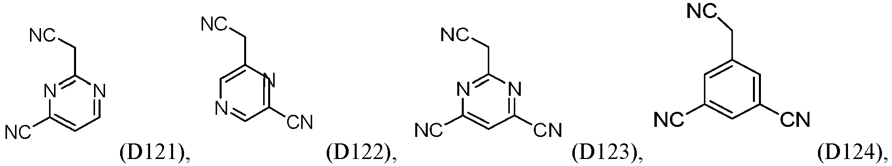 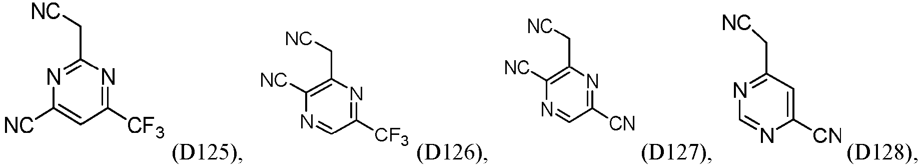 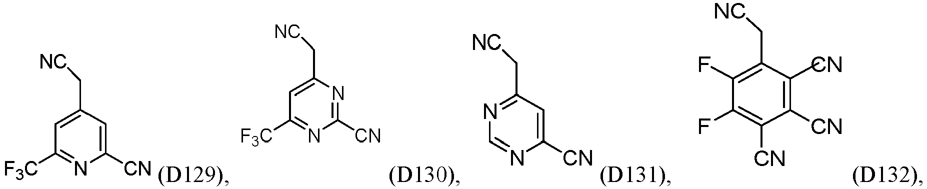 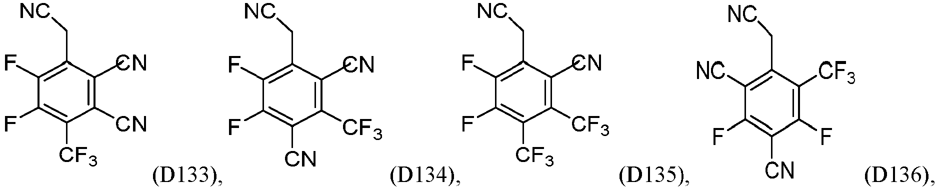 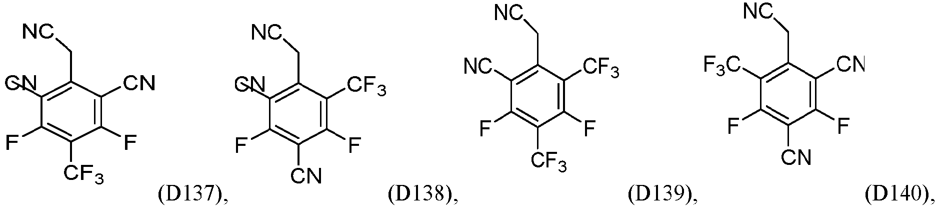 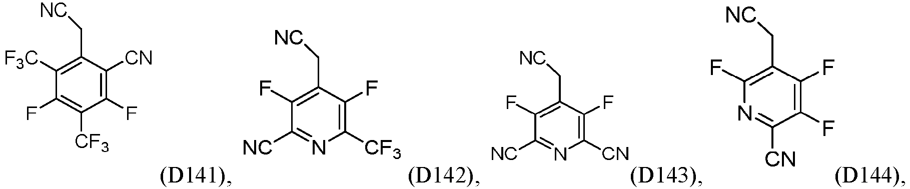 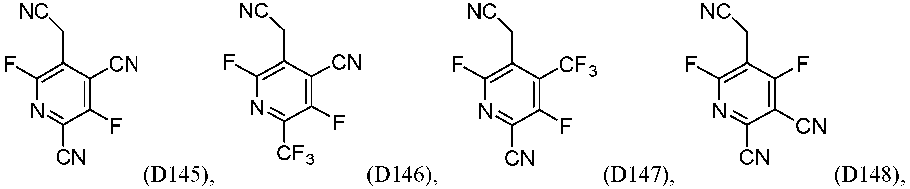 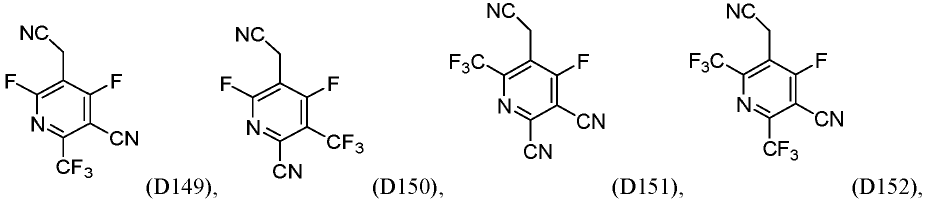 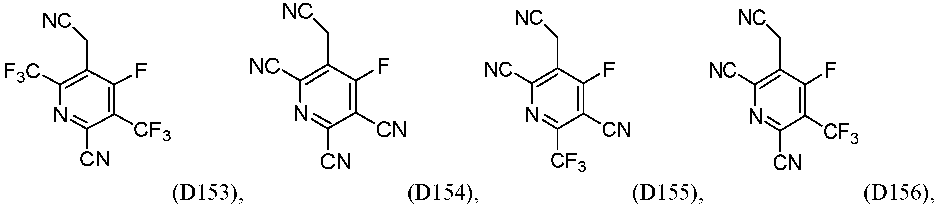 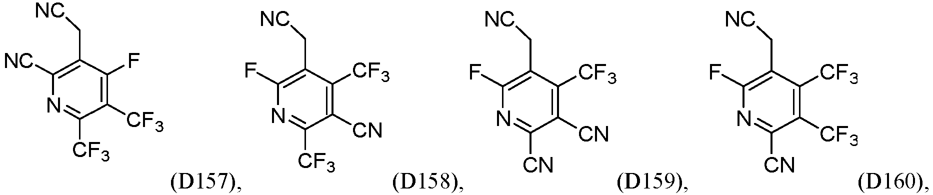 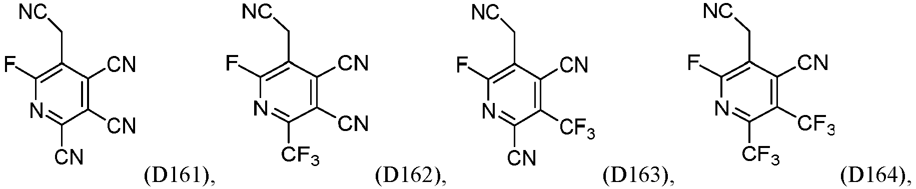 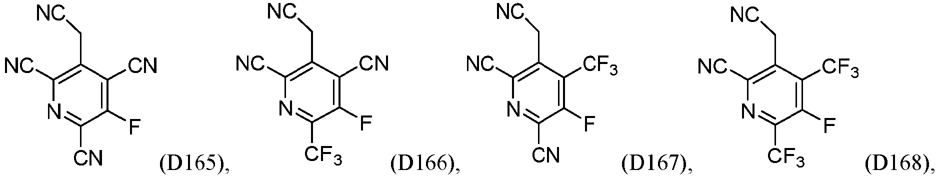 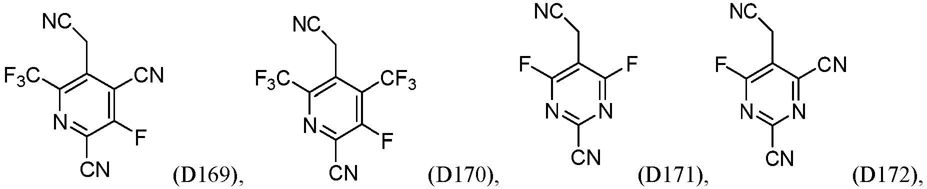 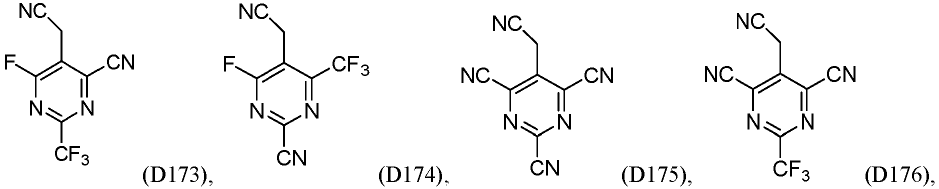 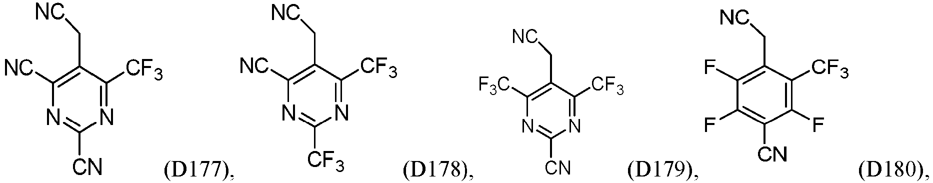 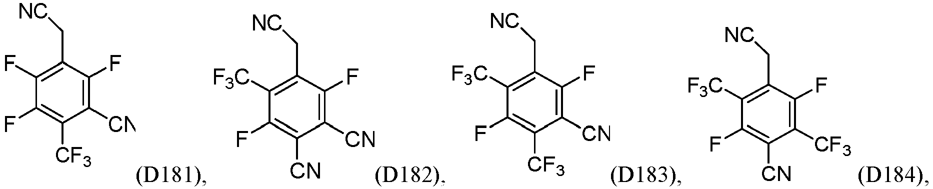 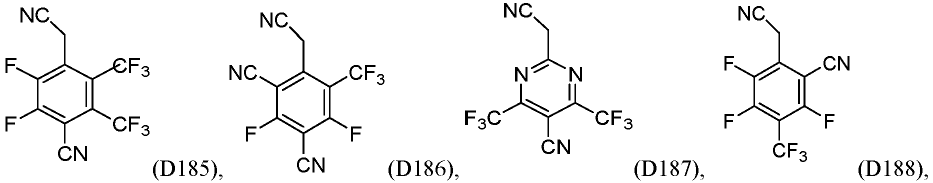 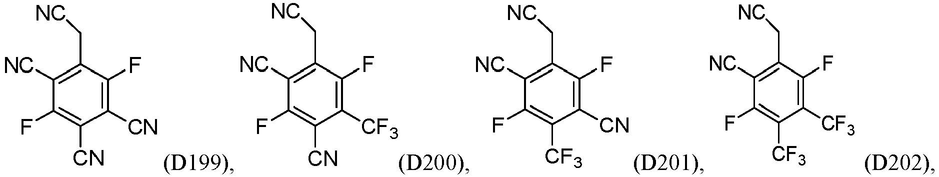 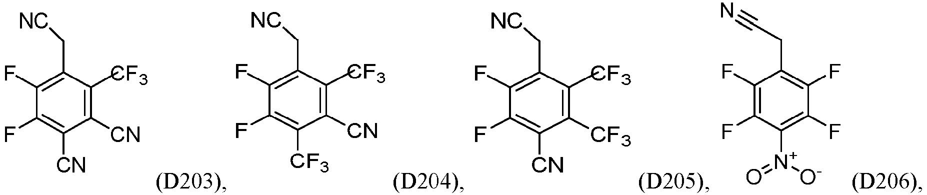 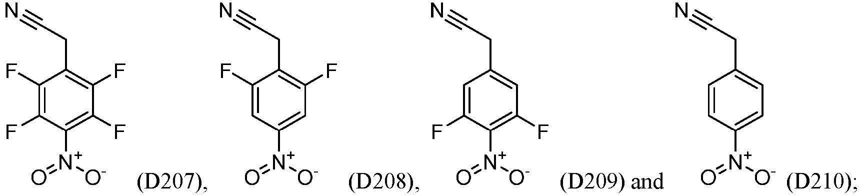 wherein
"*" of **the** substituent 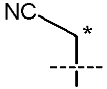 on the groups D1 to D210 indicates the binding position of A¹ to the double bond of formula (1).

8. The active-matrix OLED display according to any of the preceding claims 2 to 7, wherein the quinone of the organic p-dopant has the Formula (5) and the quinoid of the organic p-dopant has the Formula (6), 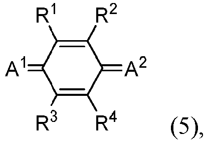 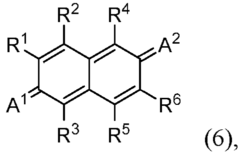 wherein
A¹ and A² are independently selected from formula (7): 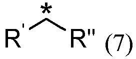 or NR‴, wherein "*" is the binding position of A¹ and A² to the double bond of formula (5) and formula (6):
R' is selected from an electron-withdrawing group, substituted or unsubstituted alkyl, substituted or unsubstituted heteroaryl, substituted or unsubstituted aryl, perfluorinated alkyl, preferably substituted or unsubstituted C₁ to C₈ alkyl, substituted or unsubstituted C₂ to C₂₀ heteroaryl, substituted or unsubstituted C₆ to C₂₄ aryl, perfluorinated C₁ to C₈ alkyl, CF₃, NO₂, F, CN,
wherein the substituent on R' are independently selected from a group comprising D, H , electron-withdrawing group, CN, halogen, Cl, F, partially fluorinated or perfluorinated alkyl, partially fluorinated or perfluorinated C₁ to C₁₀ alkyl, CF₃, partially fluorinated or perfluorinated alkoxy, partially fluorinated or perfluorinated C₁ to C₆ alkoxy, and more preferred CN, CF₃, OCF₃, D or H;
R" an electron-withdrawing group, substituted or unsubstituted alkyl, substituted or unsubstituted heteroaryl, substituted or unsubstituted aryl, perfluorinated alkyl, preferably substituted or unsubstituted C₁ to C₈ alkyl, substituted or unsubstituted C₂ to C₂₀ heteroaryl, substituted or unsubstituted C₆ to C₂₄ aryl, perfluorinated C₁ to C₈ alkyl, CF₃, NO₂, F, CN,
wherein the substituent on R" are independently selected from a group comprising electron-withdrawing group, CN, halogen, Cl, F, partially fluorinated or perfluorinated alkyl, partially fluorinated or perfluorinated C₁ to C₁₀ alkyl, CF₃, partially fluorinated or perfluorinated alkoxy, partially fluorinated or perfluorinated C₁ to C₆ alkoxy and more preferred CN, CF₃, OCF₃, D or H;
wherein R' and R'' together optional form a substituted or unsubstituted cycle, and wherein the substituted or unsubstituted cycle can be substituted or unsubstituted carbocyclic or substituted or unsubstituted heterocyclic, preferably substituted or unsubstituted heterocyclic;
R‴ is selected from a bond, substituted or unsubstituted C₁ to C₁₈ alkyl, substituted or unsubstituted C₆ to C₂₄ aryl, substituted or unsubstituted C₆ to C₂₄ heteroaryl, CN,
wherein the substituent on R‴ is independently selected from a group comprising substituted or unsubstituted C₆ to C₂₄ aryl, electron-withdrawing group, CN, F, CF₃, perfluorinated C₁ to C₈ alkyl;
R¹, R², R³, and R⁴ are independently selected from a group comprising electron-withdrawing group, halogen, substituted or unsubstituted alkyl, partially fluorinated or perfluorinated alkyl, substituted or unsubstituted aryl, substituted or unsubstituted heteroaryl, substituted alkoxy, partially fluorinated or perfluorinated alkoxy, partially fluorinated or perfluorinated alkylaryl, O, S, substituted or unsubstituted N, preferably F, Cl, CN, substituted or unsubstituted C₁ to C₈ alkyl, partially fluorinated or perfluorinated C₁ to C₈ alkyl, CF₃, substituted or unsubstituted C₆ to C₂₄ aryl, substituted or unsubstituted C₂ to C₂₀ heteroaryl, substituted or unsubstituted C₁ to C₈ alkoxy, partially fluorinated or perfluorinated C₁ to C₈ alkoxy, OCF₃, substituted or unsubstituted C₁ to C₈ alkyl, CF₃, partially fluorinated or perfluorinated C₆ to C₂₄ alkylaryl,
wherein the substituent on R¹, R², R³, and R⁴ are independently selected from a group comprising an electron-withdrawing group, substituted or unsubstituted alkyl, substituted or unsubstituted heteroaryl, substituted or unsubstituted aryl, perfluorinated alkyl, preferably CN, substituted or unsubstituted C₁ to C₈ alkyl, substituted or unsubstituted C₂ to C₂₀ heteroaryl, substituted or unsubstituted C₆ to C₂₄ aryl, perfluorinated C₁ to C₈ alkyl, CF₃, NO₂, F;
wherein R¹ and R² together, or R³ and R⁴ together optional form independently from each other a substituted or unsubstituted carbocycle or substituted or unsubstituted heterocycle, preferably substituted or unsubstituted heterocycle;
wherein the substituents are independently selected from a group comprising an electron-withdrawing group, F, CN, perfluorinated C₁ to C₈ alkyl preferably, perfluorinated C₁ to C₈ alkoxy preferably OCF₃; substituted or unsubstituted C₆ to C₁₈ aryl, substituted or unsubstituted C₂ to C₁₈ heteroaryl, substituted or unsubstituted carbocyclene, substituted or unsubstituted carbocyclidene, substituted or unsubstituted alkylene, substituted or unsubstituted alkylidene;
wherein the substituents are independently selected from a group comprising an electron-withdrawing group halogen, F, Cl, CN, perfluorinated alkyl, CF₃, partially fluorinated or perfluorinated alkylaryl, partially fluorinated or perfluorinated C₆ to C₁₈ alkylaryl, perfluorinated C₁ to C₈ alkoxy preferably OCF₃;
wherein A¹ and R³ together and A² and R together optional independently from each other form a substituted or unsubstituted heterocyclic ring;
wherein the substituents are independently selected from a group comprising substituted or unsubstituted C₆ to C₁₈ aryl, substituted or unsubstituted carbocyclene, substituted or unsubstituted carbocyclidene, substituted or unsubstituted alkylene, substituted or unsubstituted alkylidene;
wherein the substituents are independently selected from a group comprising electron-withdrawing group halogen, F, Cl, CN, perfluorinated alkyl, CF₃, partially fluorinated or perfluorinated alkylaryl, partially fluorinated or perfluorinated C₆ to C₁₈ alkylaryl.

9. The active-matrix OLED display according to any of the preceding claims 1 to 8, wherein A¹ and A² is independently selected from a group D1 to D8: 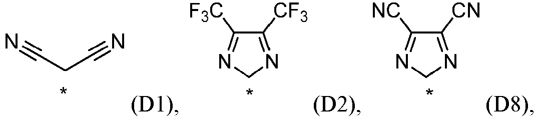 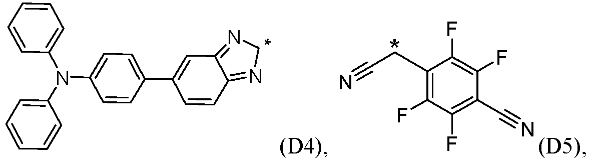 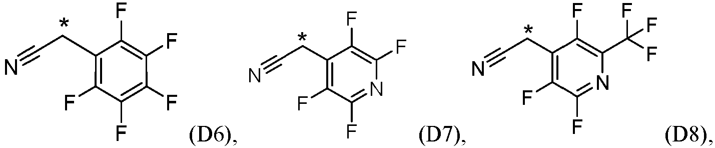 wherein
"*" is the binding position of A¹, A² and A³ to the double bond of formula (1), and A¹ and A² of formula (5) and formula (6).

10. The active-matrix OLED display according to any of the preceding claims 1 to 9, wherein A1 and A2 is selected from Formulae (8) to (13): 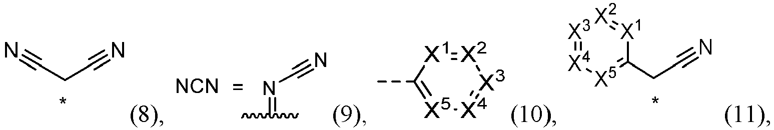 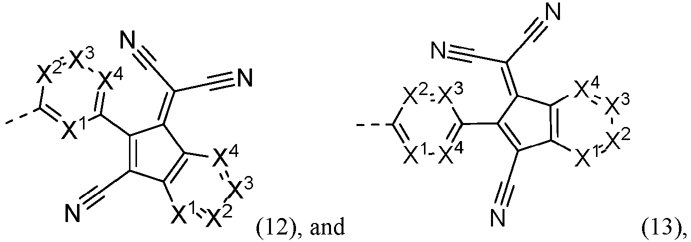 wherein
X¹ is selected from CR¹ or N;
X² is selected from CR² or N;
X³ is selected from CR³ or N;
X⁴ is selected from CR⁴ or N;
X⁵ is selected from CR⁵ or N;
wherein one of R¹, R², R³, R⁴, and R⁵ are independently selected from electron-withdrawing group, halogen, partially fluorinated or perfluorinated alkyl, partially fluorinated or perfluorinated alkoxy, D or H, preferably CN, Cl, F, partially fluorinated or perfluorinated C₁ to C₁₀ alkyl, CF₃, partially fluorinated or perfluorinated C₁ to C₆ alkoxy;
wherein at least two of X¹ to X⁵ are independently selected from CR¹ to CR⁵.

11. The active-matrix OLED display according to any of the preceding claims 2 to 10, wherein the compounds of p-dopants comprising quinone or quinoid have the following structure E1 to E11:

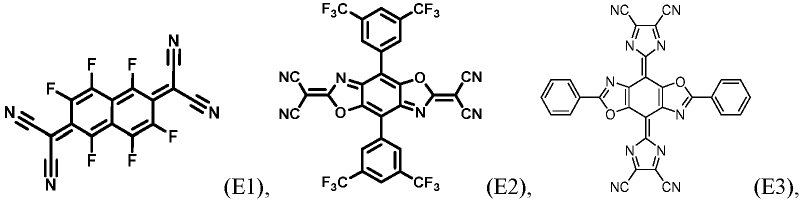

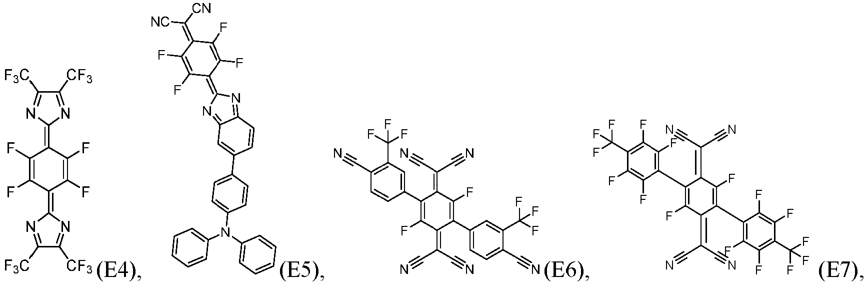

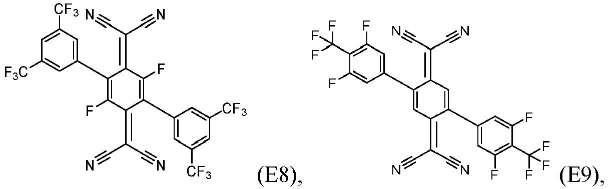

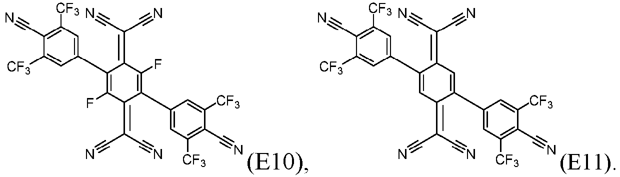

12. The active-matrix OLED display according to any of the preceding claims 1 to 11, wherein the substituted or unsubstituted aromatic compound that comprises condensed rings are represented by Formulae (14a), (14b), (14c), (14d), (14e) and Formula (15): 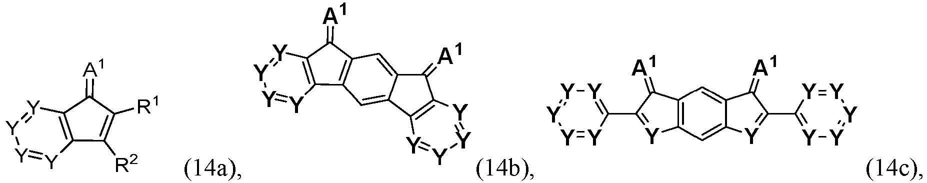 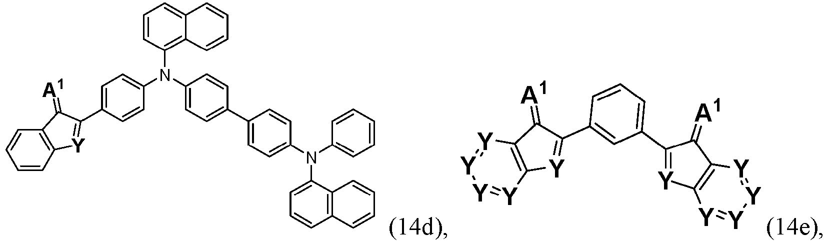 wherein
A¹ is selected from 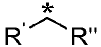 or NR‴, wherein "*" is the binding position of A¹ to the double bond of formula (14), wherein
R' is selected from an electron-withdrawing group, substituted or unsubstituted alkyl, substituted or unsubstituted heteroaryl, substituted or unsubstituted C₂ to C₂₀ heteroaryl, substituted or unsubstituted aryl, substituted or unsubstituted C₆ to C₂₄ aryl, perfluorinated alkyl, most preferably substituted or unsubstituted C₁ to C₈ alkyl, CN, substituted or unsubstituted C₂ to C₂₀ heteroaryl, substituted or unsubstituted C6 to C₂₄ aryl, C₁ to C₈ alkyl, perfluorinated C₁ to C₈ alkyl, CF₃, NO₂, F,
wherein the substituent on R' are independently selected from a group comprising electron-withdrawing group, CN, halogen, Cl, F, partially fluorinated or perfluorinated alkyl, partially fluorinated or perfluorinated C₁ to C₁₀ alkyl, CF₃, partially fluorinated or perfluorinated alkoxy, partially fluorinated or perfluorinated C₁ to C₆ alkoxy, most preferably OCF₃, D or H;
R" is selected from an electron-withdrawing group, substituted or unsubstituted alkyl, substituted or unsubstituted heteroaryl, substituted or unsubstituted C₂ to C₂₀ heteroaryl, substituted or unsubstituted aryl, substituted or unsubstituted C₆ to C₂₄ aryl, perfluorinated alkyl, most preferably substituted or unsubstituted C₁ to C₈ alkyl, CN, substituted or unsubstituted C₂ to C₂₀ heteroaryl, substituted or unsubstituted C6 to C₂₄ aryl, C₁ to C₈ alkyl, perfluorinated C₁ to C₈ alkyl, CF₃, NO₂, F,
wherein the substituent on R" are independently selected from a group comprising electron-withdrawing group, CN, halogen, Cl, F, partially fluorinated or perfluorinated alkyl, partially fluorinated or perfluorinated C₁ to C₁₀ alkyl, CF₃, partially fluorinated or perfluorinated alkoxy, partially fluorinated or perfluorinated C₁ to C₆ alkoxy most preferably OCF₃, D or H;
R‴ is selected from a bond, substituted or unsubstituted C₁ to C₁₈ alkyl, substituted or unsubstituted C₆ to C₂₄ aryl, substituted or unsubstituted C₆ to C₂₄ heteroaryl, CN,
wherein the substituent on R‴ is independently selected from a group comprising substituted or unsubstituted C₆ to C₂₄ aryl, electron-withdrawing group, CN, F, CF₃, perfluorinated C₁ to C₈ alkyl;
R¹ and R² are independently selected from a group comprising electron-withdrawing group, halogen, F, Cl, CN, substituted alkyl, substituted C₁ to C₈ alkyl, partially fluorinated or perfluorinated C₁ to C₈ alkyl, preferably CF₃, substituted or unsubstituted aryl, substituted or unsubstituted C₆ to C₂₄ aryl, substituted or unsubstituted heteroaryl, substituted or unsubstituted C₂ to C₂₀ heteroaryl, substituted C₁ to C₈ alkoxy, partially fluorinated or perfluorinated C₁ to C₈ alkoxy, preferably OCF₃, partially fluorinated or perfluorinated alkylaryl, partially fluorinated or perfluorinated C₆ to C₂₄ alkylaryl, O, S, N;
wherein the substituent on R¹ and R² are independently selected from a group comprising an electron-withdrawing group preferably CN, substituted or unsubstituted alkyl, substituted or unsubstituted C₁ to C₈ alkyl, substituted or unsubstituted heteroaryl, substituted or unsubstituted C₂ to C₂₀ heteroaryl, substituted or unsubstituted aryl, substituted or unsubstituted C₆ to C₂₄ aryl, perfluorinated alkyl, perfluorinated C₁ to C₈ alkyl, most preferably CF₃, NO₂, F;
wherein R¹ and R² together optional form a substituted or unsubstituted carbocycle or substituted or unsubstituted heterocycle, preferably substituted or unsubstituted carbocycle;
wherein the substituents on the cycle are selected from a group comprising electron-withdrawing group, F, CN, perfluorinated C₁ to C₈ alkyl preferably, perfluorinated C₁ to C₈ alkoxy, OCF₃; substituted or unsubstituted C₆ to C₁₈ aryl, substituted or unsubstituted C₂ to C₁₈ heteroaryl, substituted or unsubstituted carbocyclene, substituted or unsubstituted carbocyclidene, substituted or unsubstituted alkylene, substituted or unsubstituted alkylidene;
wherein the substituents are selected from a group comprising an electron-withdrawing group halogen, F, Cl, CN, perfluorinated alkyl, perfluorinated C₁ to C₈ alkyl, CF₃, partially fluorinated or perfluorinated alkylaryl, partially fluorinated or perfluorinated C₆ to C₁₈ alkylaryl, perfluorinated C₁ to C₈ alkoxy, OCF₃;
Y is independently selected from each other from N or CR^{a},
R^{a} is independently selected from a group comprising H, D, electron-withdrawing group, CN, substituted or unsubstituted C₁ to C₈ alkyl, perfluorinated C₁ to C₈ alkyl, CF₃, perfluorinated C₁ to C₈ alkoxy, OCF₃;
wherein the substituents on R^{a} are independently selected from a group comprising electron-withdrawing group, CN, halogen, Cl, F, partially fluorinated or perfluorinated alkyl, partially fluorinated or perfluorinated C₁ to C₁₀ alkyl, CF₃, partially fluorinated or perfluorinated alkoxy, partially fluorinated or perfluorinated C₁ to C₆ alkoxy most preferably OCF₃, D or H;
wherein two R^{a} optional form a substituted or unsubstituted carbocycle or substituted or unsubstituted heterocycle, preferably substituted or unsubstituted carbocycle;
wherein the substituents on the cycle independently selected from a group comprising electron-withdrawing group, F, CN, perfluorinated C₁ to C₈ alkyl preferably, perfluorinated C₁ to C₈ alkoxy, OCF₃; substituted or unsubstituted C₆ to C₁₈ aryl, substituted or unsubstituted C₂ to C₁₈ heteroaryl, substituted or unsubstituted carbocyclene, substituted or unsubstituted carbocyclidene, substituted or unsubstituted alkylene, substituted or unsubstituted alkylidene;
wherein two Y optional form a substituted or unsubstituted carbocycle or substituted or unsubstituted heterocycle, preferably substituted or unsubstituted carbocycle;
wherein the substituents on the cycle can be electron-withdrawing group, F, CN, perfluorinated C₁ to C₈ alkyl preferably, perfluorinated C₁ to C₈ alkoxy, OCF₃; substituted or unsubstituted C₆ to C₁₈ aryl, substituted or unsubstituted C₂ to C₁₈ heteroaryl, substituted or unsubstituted carbocyclene, substituted or unsubstituted carbocyclidene, substituted or unsubstituted alkylene, substituted or unsubstituted alkylidene; 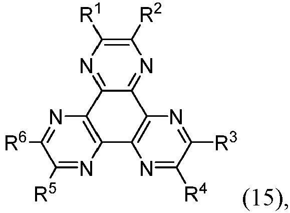 wherein
R¹, R², R³, R⁴, R⁵, and R⁶ are independently selected from a group comprising H, F, CN, CF₃, and NO₂, wherein at least one of R¹, R², R³, R⁴, R⁵, and R⁶ is F, CN, CF₃, or NO₂.

13. The active-matrix OLED display according to any of the preceding claims 1 to 12, wherein the substituted or unsubstituted aromatic compound that comprises condensed rings having a structure of G1 to G4: 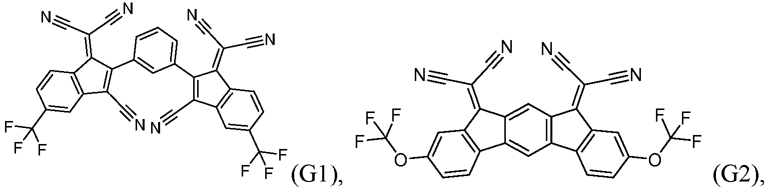 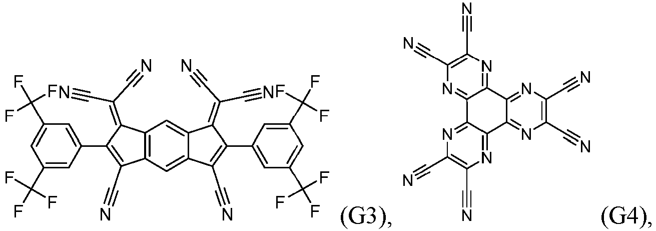 and

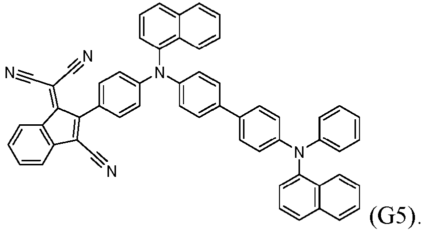

14. The active-matrix OLED display according to any of the preceding claims 1 to 13, wherein at least one R¹ and R² are independently selected from a group comprising CN, OCF₃, CF₃, F, perfluorinated C₁ to C₈ alkyl, substituted C₆ to C₂₄ aryl, wherein the substituent is F, CF₃, CN, substituted C₁ to C₈ alkylene.

15. The active-matrix OLED display according to claims 1 to 14, wherein the common hole injection layer (130) consists of the organic p-dopant or the common hole transport layer (140) comprises the organic p-dopant and a hole transport material.

16. The active-matrix OLED display according to claims 1 to 15, wherein the first common semiconductor layer comprises at least one organic p-dopant is in direct contact to the anode layer (120), wherein the second common semiconductor layer is arranged between the first semiconductor layer and the emission layer.

17. The active-matrix OLED display according to any of the preceding claims 1 to 16, wherein the common stack of organic layers comprises in addition a common organic layer selected from the group comprising common electron injection layer, common hole blocking layer and/or electron transport layer (160), preferably the common electron injection layer is in direct contact with the common cathode layer (190).

18. The active-matrix OLED display according to any of the preceding claims 1 to 17, wherein the active-matrix OLED display comprises a driving circuit configured to separately driving the pixels of the plurality of organic-light emitting diode pixels.

19. The active-matrix OLED display according to any of the preceding claims 1 to 18, wherein the first common semiconductor layer is shared by the plurality of OLED pixels and/or the second common semiconductor layer is shared by the plurality of OLED pixels, preferably all common semiconductor layers are shared by the plurality of OLED pixels.

## Patentansprüche

1. Aktivmatrix-OLED-Anzeige, umfassend eine Vielzahl von OLED-Pixeln (100; 200; 300), wobei jedes Pixel selbst (100; 200; 300) einen Stapel von organischen Schichten umfasst und jede Schicht des Stapels von organischen Schichten eine gemeinsame Halbleiterschicht bilden kann, wobei
- wenigstens ein erstes OLED-Pixel (100) und ein zweites OLED-Pixel (200) umfassen
- eine Anodenschicht (120),
- eine gemeinsame Kathodenschicht (190),
- wenigstens eine Emissionsschicht, die gegebenenfalls eine gemeinsame Emissionsschicht ist,
- wenigstens einen Stapel von organischen Schichten, wobei der Stapel von organischen Schichten zwischen der Anodenschicht (120) und der Kathodenschicht (190) angeordnet ist, umfassend
- eine Vielzahl von Halbleiterschichten, wobei die Vielzahl von Halbleiterschichten wenigstens zwei oder mehr gemeinsame Halbleiterschichten umfasst, wobei die Vielzahl von Halbleiterschichten umfasst
- wenigstens eine gemeinsame erste Halbleiterschicht, die wenigstens einen organischen p-Dotierstoff umfasst,
- wenigstens eine gemeinsame zweite Halbleiterschicht,
- eine gemeinsame dritte Halbleiterschicht,
- eine gemeinsame Halbleiterschicht, die sich über alle Pixel der Vielzahl von Pixeln erstreckt oder sich über wenigstens zwei Pixel der Vielzahl von Pixeln in der OLED-Anzeige erstreckt,
- wobei die gemeinsame erste Halbleiterschicht eine gemeinsame Lochinjektionsschicht (130) ist,
- wobei die gemeinsame zweite Halbleiterschicht eine gemeinsame Lochtransportschicht (140) ist,
- wobei die gemeinsame dritte Halbleiterschicht eine gemeinsame Elektronensperrschicht (145) ist,
- wobei sich die gemeinsame Lochinjektionsschicht (130) in direktem Kontakt mit der gemeinsamen Lochtransportschicht (140) befindet,
- wobei sich die gemeinsame Elektronensperrschicht (145) in direktem Kontakt mit der gemeinsamen Lochtransportschicht (140) befindet,
- wobei die gemeinsame zweite Halbleiterschicht eine Schichtdicke von ≥15 nm bis ≤230 nm aufweist,
- wobei die gemeinsame dritte Halbleiterschicht eine Schichtdicke von 1 nm bis 20 nm aufweist, und
wobei der gemeinsame erste Halbleiter wenigstens einen organischen p-Dotierstoff umfasst, die gemeinsame zweite Halbleiterschicht und die gemeinsame dritte Halbleiterschicht zusammen einen Flächenwiderstand von ≥ 50 Gigaohm pro Quadrat aufweisen, wobei der Flächenwiderstand Rs durch das Übertragungsleitungsverfahren wie in der Beschreibung beschrieben gemessen wird.

2. Aktivmatrix-OLED-Anzeige nach einem der vorstehenden Ansprüche 1, wobei der organische p-Dotierstoff ausgewählt ist aus der Gruppe umfassend ein substituiertes oder unsubstituiertes 3-Radialen, ein substituiertes oder unsubstituiertes Chinon, ein substituiertes oder unsubstituiertes Chinoid und eine substituierte oder unsubstituierte aromatische Verbindung, die kondensierte Ringe umfasst, und wobei der organische p-Dotierstoff bevorzugter ausgewählt ist aus substituierten oder unsubstituierten 3-Radialen-Verbindungen.

3. Aktivmatrix-OLED-Anzeige nach Anspruch 2, wobei die 3-Radialen-Verbindung durch Formel (1) dargestellt wird: 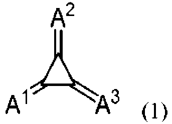 wobei A¹, A² und A³ unabhängig ausgewählt sind aus Formel (2) : 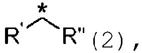 wobei "*" die Bindungsposition von A¹, A² und A³ an die Doppelbindung von Formel (1) ist,
R' unabhängig ausgewählt ist aus der Gruppe umfassend substituiertes oder unsubstituiertes Aryl, substituiertes oder unsubstituiertes Heteroaryl, substituiertes oder unsubstituiertes Alkyl und vorzugsweise substituiertes oder unsubstituiertes C₆- bis C₂₄-Aryl, substituiertes oder unsubstituiertes C₂- bis C₂₀-Heteroaryl, substituiertes oder unsubstituiertes C₁-bis C₈-Alkyl;
wobei der Substituent an R' unabhängig ausgewählt ist aus der Gruppe umfassend elektronenziehende Gruppe, CN, Halogen, Cl, F, teilfluoriertes oder perfluoriertes Alkyl, teilfluoriertes oder perfluoriertes Alkoxy, und vorzugsweise teilfluoriertes oder perfluoriertes C₁- bis C₁₀-Alkyl, teilfluoriertes oder perfluoriertes C₁- bis C₆-Alkoxy und bevorzugter CF₃, OCF₃, D oder H;
R" ausgewählt ist aus der Gruppe umfassend eine elektronenziehende Gruppe, vorzugsweise CN, substituiertes oder unsubstituiertes Alkyl, substituiertes oder unsubstituiertes Heteroaryl, substituiertes oder unsubstituiertes Aryl, perfluoriertes Alkyl, bevorzugter substituiertes oder unsubstituiertes C₁- bis C₈-Alkyl, substituiertes oder unsubstituiertes C₂- bis C₂₀-Heteroaryl, substituiertes oder unsubstituiertes C₆- bis C₂₄-Aryl, perfluoriertes C₁-bis C₈-Alkyl und bevorzugter CF₃, NO₂ oder F;
wobei der Substituent an R" unabhängig ausgewählt ist aus der Gruppe umfassend elektronenziehende Gruppe, CN, Halogen, Cl, F, teilfluoriertes oder perfluoriertes Alkyl, teilfluoriertes oder perfluoriertes Alkoxy, und vorzugsweise teilfluoriertes oder perfluoriertes C₁- bis C₁₀-Alkyl, teilfluoriertes oder perfluoriertes C₁- bis C₆-Alkoxy und bevorzugter CF₃, OCF₃, D oder H;
wobei R' und R" zusammen gegebenenfalls einen substituierten oder unsubstituierten Carbozyklus oder einen substituierten oder unsubstituierten Heterozyklus, vorzugsweise einen substituierten oder unsubstituierten Heterozyklus, bilden;
wobei die Substituenten unabhängig ausgewählt sind aus der Gruppe umfassend elektronenziehende Gruppe, F, CN, perfluoriertes C₁- bis C₈-Alkyl, substituiertes oder unsubstituiertes C₆- bis C₁₈-Aryl, substituiertes oder unsubstituiertes C₂- bis C₁₈-Heteroaryl, substituiertes oder unsubstituiertes C₃- bis C₁₈-Carbocyclen, substituiertes oder unsubstituiertes C₃- bis C₁₈-Carbocycliden, substituiertes oder unsubstituiertes C₁-bis C₈-Alkylen, substituiertes oder substituiertes C₁-bis C₈-Alkyliden;
wobei die Substituenten ausgewählt sind aus der Gruppe umfassend eine elektronenziehende Gruppe, Halogen, F, Cl, CN, perfluoriertes Alkyl, perfluoriertes C₁- bis C₈-Alkyl, CF₃, teilfluoriertes oder perfluoriertes Alkylaryl, teilfluoriertes oder perfluoriertes C₆- bis C₁₈-Alkylaryl.

4. Aktivmatrix-OLED-Anzeige nach einem der vorstehenden Ansprüche 1 bis 3, wobei
R' unabhängig ausgewählt ist aus der Gruppe umfassend substituiertes oder unsubstituiertes C₆- bis C₂₄-Aryl, substituiertes oder unsubstituiertes C₂- bis C₂₀-Heteroaryl;
R" eine elektronenziehende Gruppe ist, vorzugsweise R" unabhängig ausgewählt ist aus der Gruppe umfassend CN, CF₃, NO₂ und F, und bevorzugter R" CN ist.

5. Aktivmatrix-OLED-Anzeige nach einem der vorstehenden Ansprüche 1 bis 4, wobei A¹, A² und A³ ausgewählt sind aus A¹=A²≠A³ oder A¹≠A² und A¹≠A³ und A² = A³.

6. Aktivmatrix-OLED-Anzeige nach einem der vorstehenden Ansprüche 1 bis 5, wobei A¹ ausgewählt ist aus den Formeln (3) und (4): 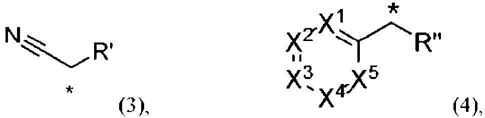 wobei
X¹ ausgewählt ist aus CR¹ und N;
X² ausgewählt ist aus CR² und N;
X³ ausgewählt ist aus CR³ und N;
X⁴ ausgewählt ist aus CR⁴ und N;
X⁵ ausgewählt ist aus CR⁵ und N;
R¹, R², R³, R⁴ und R⁵ unabhängig ausgewählt sind aus einer Gruppe umfassend elektronenziehende Gruppe, CN, Halogen, Cl, F, teilfluoriertes oder perfluoriertes Alkyl, teilfluoriertes oder perfluoriertes C₁- bis C₁₀-Alkyl, vorzugsweise CF₃, teilfluoriertes oder perfluoriertes Alkoxy, teilfluoriertes oder perfluoriertes C₁- bis C₆-Alkoxy, D und H;
wobei wenigstens zwei von X¹ bis X⁵ unabhängig ausgewählt sind aus CR¹ bis CR⁵; und
wobei "*" in den Formeln (3) und (4) die Bindungsposition von A¹ an die Doppelbindung in Formel (1) ist.

7. Aktivmatrix-OLED-Anzeige nach einem der vorstehenden Ansprüche 1 bis 6, wobei A¹ ausgewählt ist aus einer Gruppe umfassend D1 bis D210: 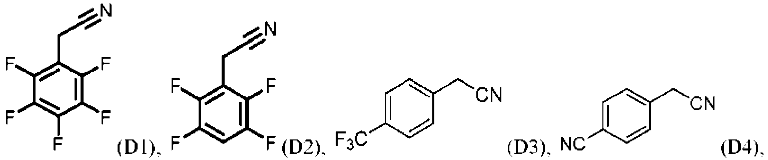 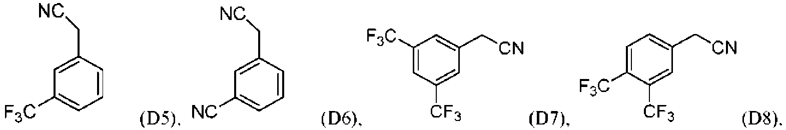 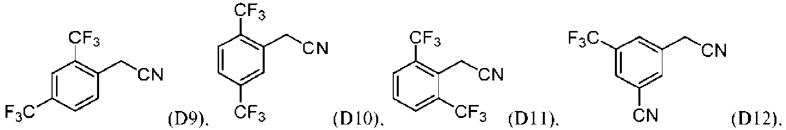 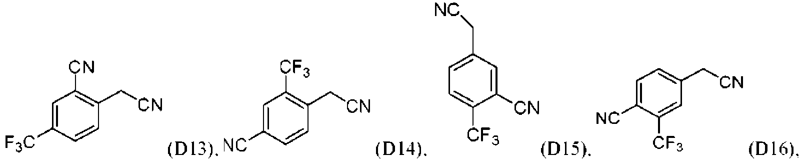 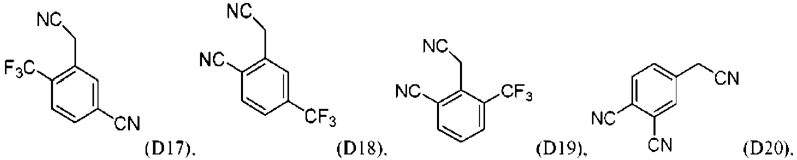 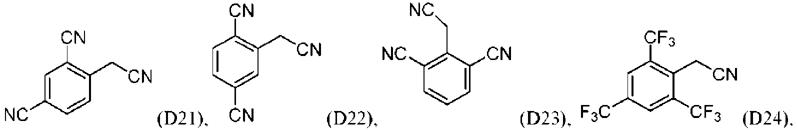 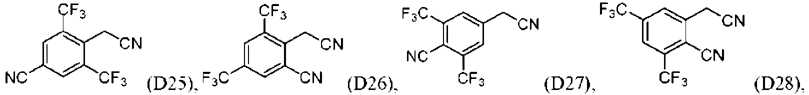 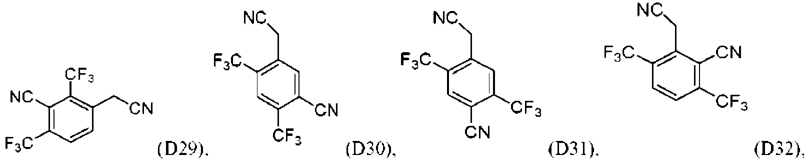 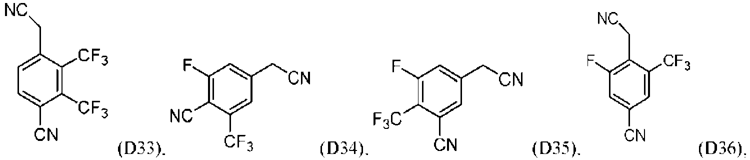 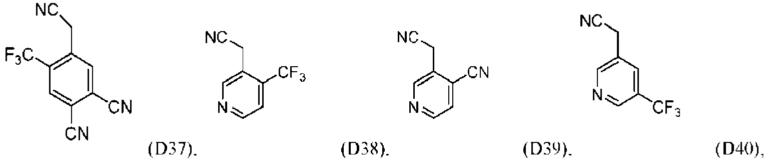 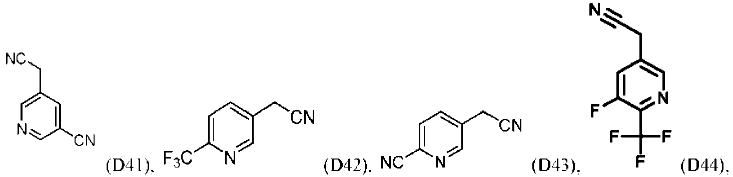 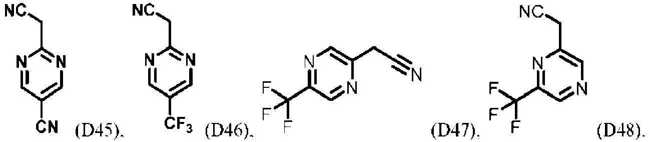 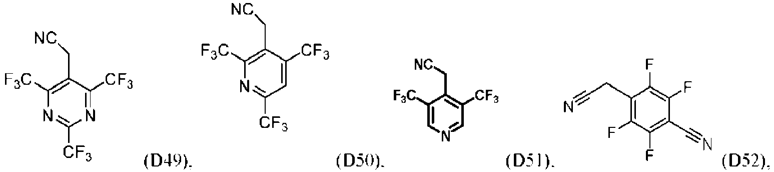 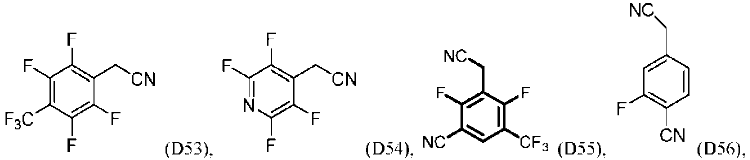 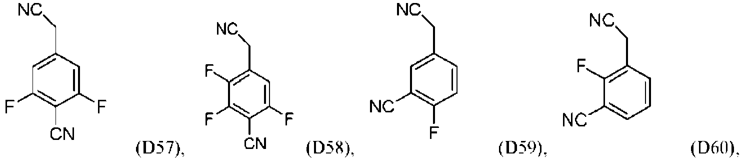 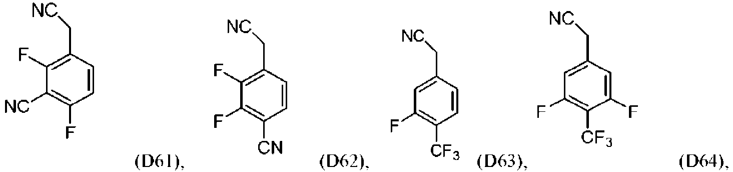 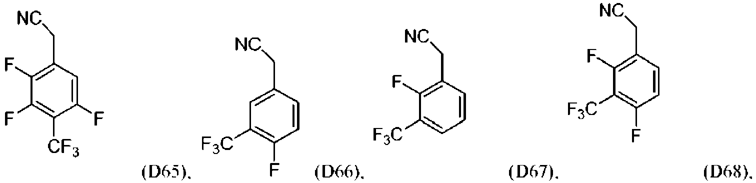 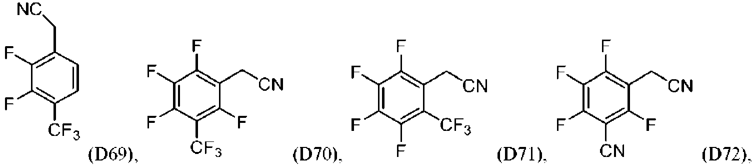 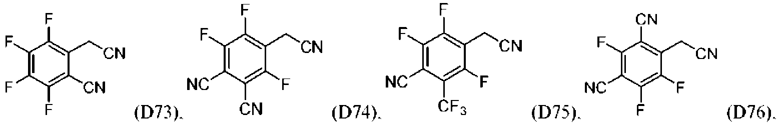 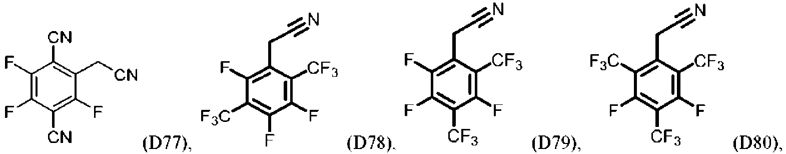 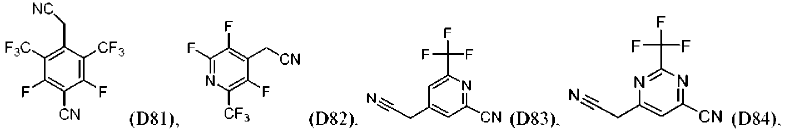 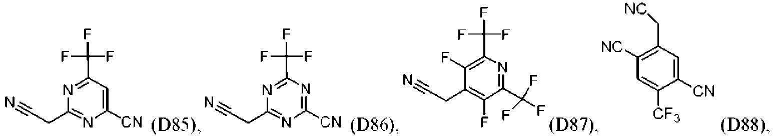 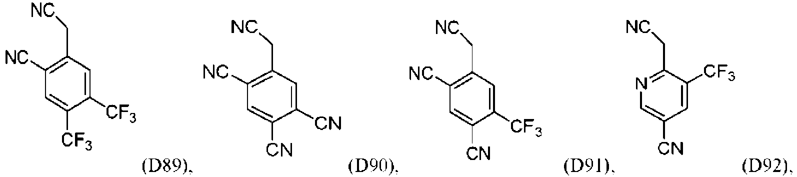 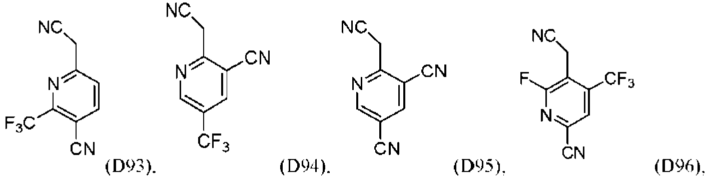 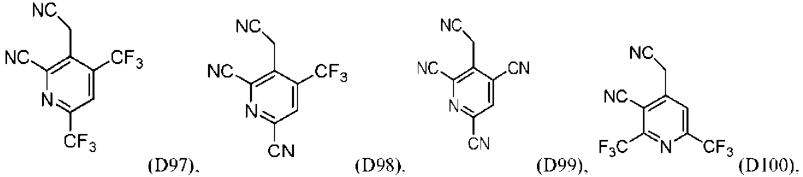 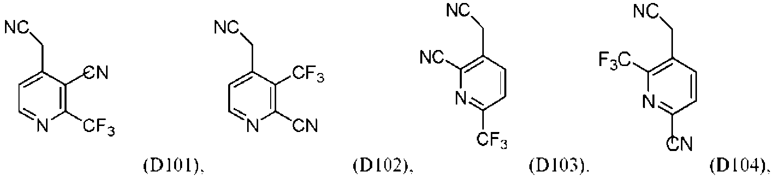 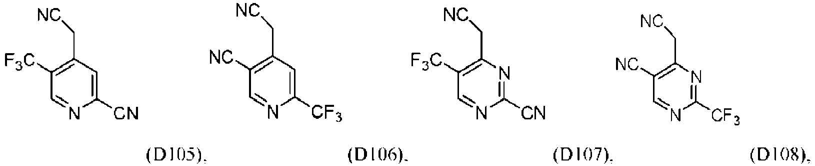 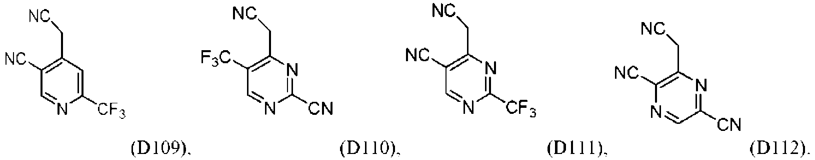 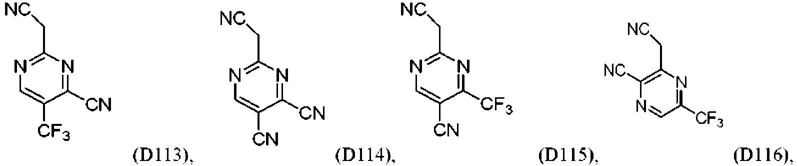 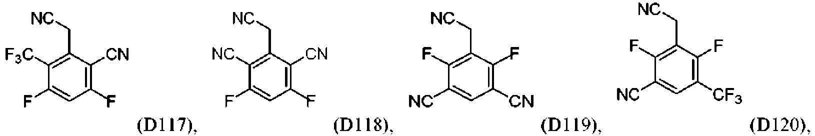 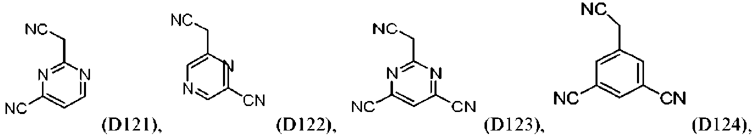 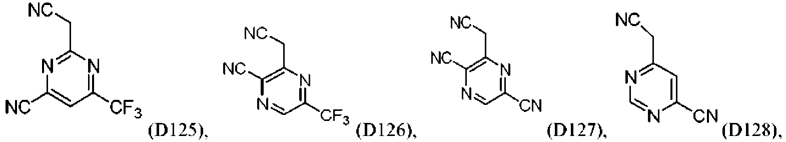 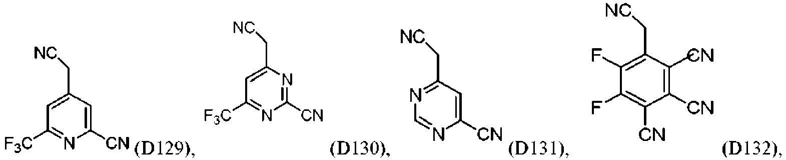 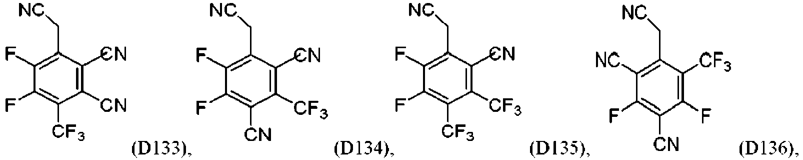 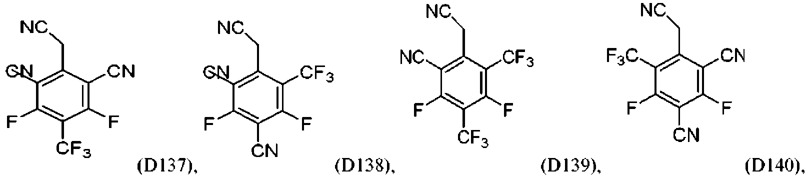 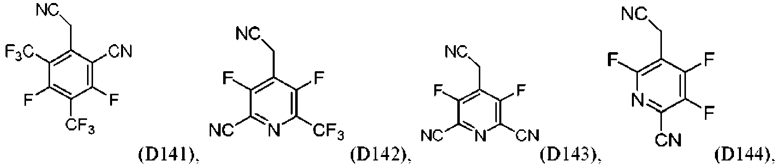 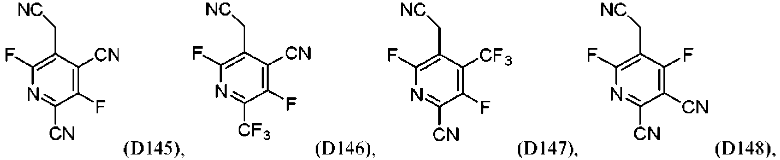 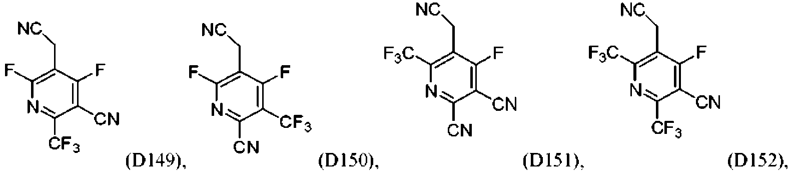 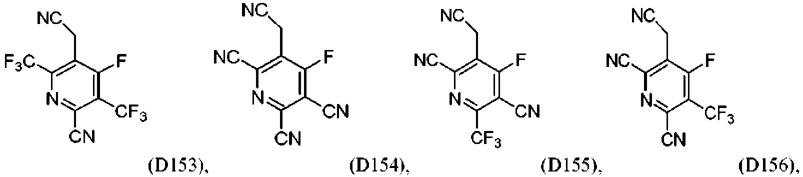 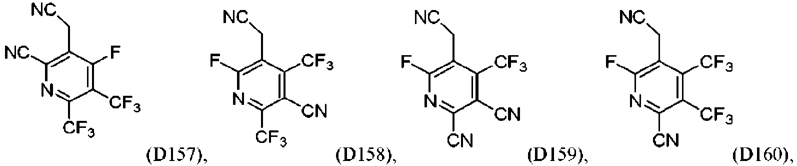 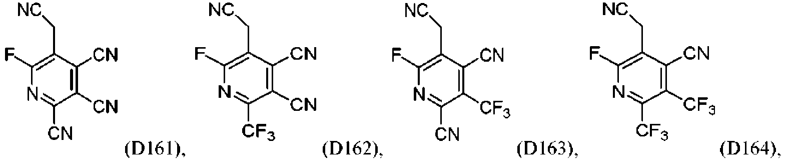 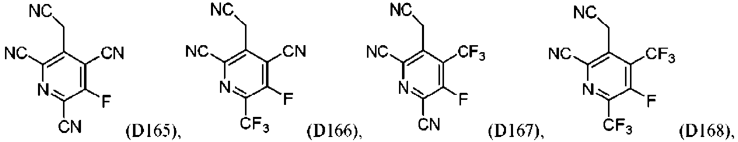 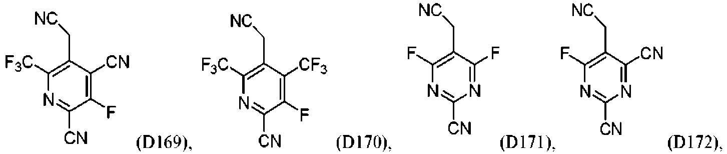 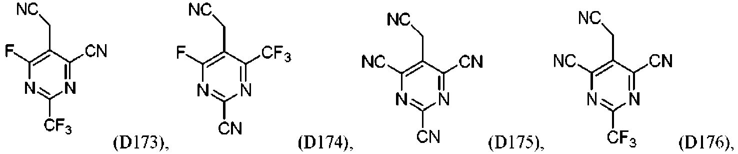 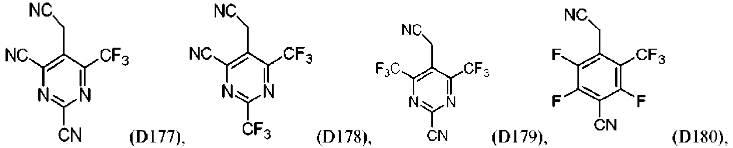 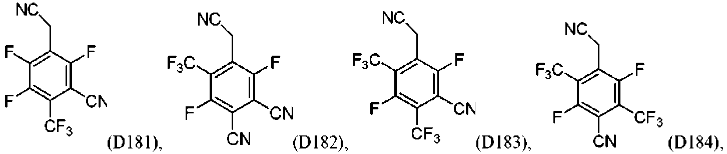 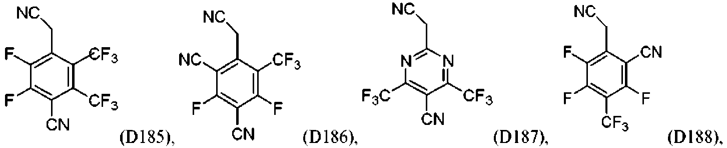 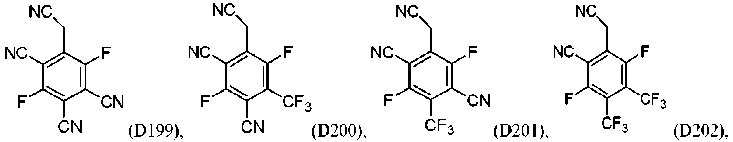 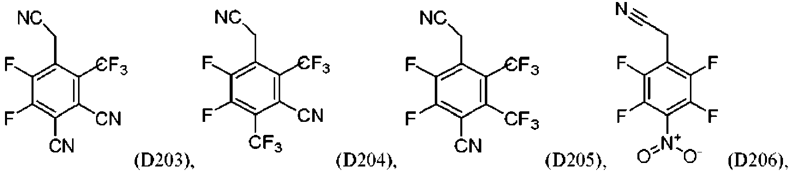 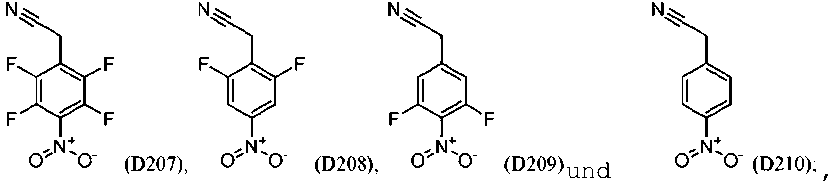 wobei
"*" des Substituenten 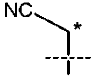 an den Gruppen D1 bis D210 die Bindungsposition von A¹ an die Doppelbindung der Formel (1) anzeigt.

8. Aktivmatrix-OLED-Anzeige nach einem der vorstehenden Ansprüche 2 bis 7, wobei das Chinon des organischen p-Dotierstoffs die Formel (5) aufweist und das Chinoid des organischen p-Dotierstoffs die Formel (6) aufweist, 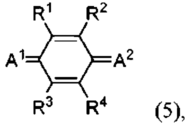 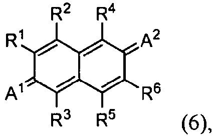 wobei
A¹ und A² unabhängig ausgewählt sind aus Formel (7): 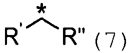 oder NR‴, wobei "*" die Bindungsposition von A¹ und A² an die Doppelbindung von Formel (5) und Formel (6) ist:
R' ausgewählt ist aus einer elektronenziehenden Gruppe, substituiertem oder unsubstituiertem Alkyl, substituiertem oder unsubstituiertem Heteroaryl, substituiertem oder unsubstituiertem Aryl, perfluoriertem Alkyl, vorzugsweise substituiertem oder unsubstituiertem C₁- bis C₈-Alkyl, substituiertem oder unsubstituiertem C₂- bis C₂₀-Heteroaryl, substituiertem oder unsubstituiertem C₆- bis C₂₄-Aryl, perfluoriertem C₁-bis C₈-Alkyl, CF₃, NO₂, F, CN,
wobei der Substituent an R' unabhängig ausgewählt ist aus einer Gruppe umfassend D, H, elektronenziehende Gruppe, CN, Halogen, Cl, F, teilfluoriertes oder perfluoriertes Alkyl, teilfluoriertes oder perfluoriertes C₁- bis C₁₀-Alkyl, CF₃, teilfluoriertes oder perfluoriertes Alkoxy, teilfluoriertes oder perfluoriertes C₁- bis C₆-Alkoxy und bevorzugter CN, CF₃, OCF₃, D oder H;
R" eine elektronenziehende Gruppe, substituiertes oder unsubstituiertes Alkyl, substituiertes oder unsubstituiertes Heteroaryl, substituiertes oder unsubstituiertes Aryl, perfluoriertes Alkyl, vorzugsweise substituiertes oder unsubstituiertes C₁- bis C₈-Alkyl, substituiertes oder unsubstituiertes C₂- bis C₂₀-Heteroaryl, substituiertes oder unsubstituiertes C₆-bis C₂₄-Aryl, perfluoriertes C₁ bis C₈-Alkyl, CF₃, NO₂, F, CN,
wobei der Substituent an R" unabhängig ausgewählt ist aus einer Gruppe umfassend elektronenziehende Gruppe, CN, Halogen, Cl, F, teilfluoriertes oder perfluoriertes Alkyl, teilfluoriertes oder perfluoriertes C₁- bis C₁₀-Alkyl, CF₃, teilfluoriertes oder perfluoriertes Alkoxy, teilfluoriertes oder perfluoriertes C₁- bis C₆-Alkoxy und bevorzugter CN, CF₃, OCF₃, D oder H;
wobei R' und R" zusammen gegebenenfalls einen substituierten oder unsubstituierten Zyklus bilden und wobei der substituierte oder unsubstituierte Zyklus substituiert oder unsubstituiert carbocyclisch oder substituiert oder unsubstituiert heterocyclisch, vorzugsweise substituiert oder unsubstituiert heterocyclisch, sein kann;
R‴ ausgewählt ist aus einer Bindung, substituiertem oder unsubstituiertem C₁- bis C₁₈-Alkyl, substituiertem oder unsubstituiertem C₆- bis C₂₄-Aryl, substituiertem oder unsubstituiertem C₆- bis C₂₄-Heteroaryl, CN,
wobei der Substituent an R‴ unabhängig ausgewählt ist aus einer Gruppe umfassend substituiertes oder unsubstituiertes C₆- bis C₂₄-Aryl, elektronenziehende Gruppe, CN, F, CF₃, perfluoriertes C₁- bis C₈-Alkyl;
R¹, R², R³ und R⁴ unabhängig ausgewählt sind aus einer Gruppe umfassend elektronenziehende Gruppe, Halogen, substituiertes oder unsubstituiertes Alkyl, teilfluoriertes oder perfluoriertes Alkyl, substituiertes oder unsubstituiertes Aryl, substituiertes oder unsubstituiertes Heteroaryl, substituiertes Alkoxy, teilfluoriertes oder perfluoriertes Alkoxy, teilfluoriertes oder perfluoriertes Alkylaryl, O, S, substituiertes oder unsubstituiertes N, vorzugsweise F, Cl, CN, substituiertes oder unsubstituiertes C₁- bis C₈-Alkyl, teilfluoriertes oder perfluoriertes C₁- bis C₈-Alkyl, CF₃, substituiertes oder unsubstituiertes C₆- bis C₂₄-Aryl, substituiertes oder unsubstituiertes C₂- bis C₂₀-Heteroaryl, substituiertes oder unsubstituiertes C₁- bis C₈-Alkoxy, teilfluoriertes oder perfluoriertes C₁- bis C₈-Alkoxy, OCF₃, substituiertes oder unsubstituiertes C₁-bis C₈-Alkyl, CF₃, teilfluoriertes oder perfluoriertes C₆-bis C₂₄-Alkylaryl,
wobei der Substituent an R¹, R², R³ und R⁴ unabhängig ausgewählt ist aus einer Gruppe umfassend eine elektronenziehende Gruppe, substituiertes oder unsubstituiertes Alkyl, substituiertes oder unsubstituiertes Heteroaryl, substituiertes oder unsubstituiertes Aryl, perfluoriertes Alkyl, vorzugsweise CN, substituiertes oder unsubstituiertes C₁-bis C₈-Alkyl, substituiertes oder unsubstituiertes C₂-bis C₂₀-Heteroaryl, substituiertes oder unsubstituiertes C₆- bis C₂₄-Aryl, perfluoriertes C₁- bis C₈-Alkyl, CF₃, NO₂, F;
wobei R¹ und R² zusammen oder R³ und R⁴ zusammen gegebenenfalls unabhängig voneinander einen substituierten oder unsubstituierten Carbozyklus oder substituierten oder unsubstituierten Heterozyklus, vorzugsweise substituierten oder unsubstituierten Heterozyklus, bilden;
wobei die Substituenten unabhängig ausgewählt sind aus einer Gruppe umfassend eine elektronenziehende Gruppe, F, CN, perfluoriertes C₁- bis C₈-Alkyl, vorzugsweise perfluoriertes C₁- bis C₈-Alkoxy, vorzugsweise OCF₃; substituiertes oder unsubstituiertes C₆-bis C₁₈-Aryl, substituiertes oder unsubstituiertes C₂- bis C₁₈-Heteroaryl, substituiertes oder unsubstituiertes Carbocyclen, substituiertes oder unsubstituiertes Carbocycliden, substituiertes oder unsubstituiertes Alkylen, substituiertes oder unsubstituiertes Alkyliden; wobei die Substituenten unabhängig ausgewählt sind aus einer Gruppe umfassend eine elektronenziehende Gruppe, Halogen, F, Cl, CN, perfluoriertes Alkyl, CF₃, teilfluoriertes oder perfluoriertes Alkylaryl, teilfluoriertes oder perfluoriertes C₆- bis C₁₈-Alkylaryl, perfluoriertes C₁- bis C₈-Alkoxy, vorzugsweise OCF₃;
wobei A¹ und R³ zusammen und A² und R zusammen gegebenenfalls unabhängig voneinander einen substituierten oder unsubstituierten heterocyclischen Ring bilden;
wobei die Substituenten unabhängig ausgewählt sind aus einer Gruppe umfassend substituiertes oder unsubstituiertes C₆- bis C₁₈-Aryl, substituiertes oder unsubstituiertes Carbocyclen, substituiertes oder unsubstituiertes Carbocycliden, substituiertes oder unsubstituiertes Alkylen, substituiertes oder unsubstituiertes Alkyliden;
wobei die Substituenten unabhängig ausgewählt sind aus einer Gruppe umfassend elektronenziehende Gruppe, Halogen, F, Cl, CN, perfluoriertes Alkyl, CF₃, teilfluoriertes oder perfluoriertes Alkylaryl, teilfluoriertes oder perfluoriertes C₆- bis C₁₈-Alkylaryl.

9. Aktivmatrix-OLED-Anzeige nach einem der vorstehenden Ansprüche 1 bis 8, wobei A¹ und A² unabhängig ausgewählt sind aus einer Gruppe D1 bis D8: 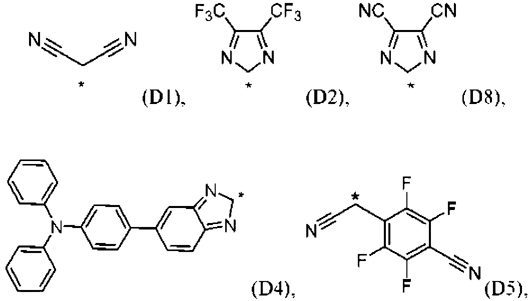 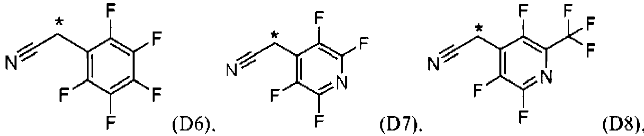 wobei
"*" die Bindungsposition von A¹, A² und A³ an die Doppelbindung von Formel (1) und A¹ und A² von Formel (5) und Formel (6) ist.

10. Aktivmatrix-OLED-Anzeige nach einem der vorstehenden Ansprüche 1 bis 9, wobei A1 und A2 ausgewählt sind aus den Formeln (8) bis (13): 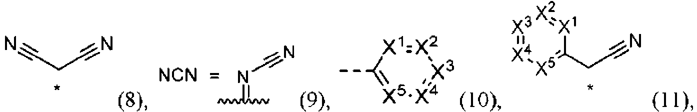 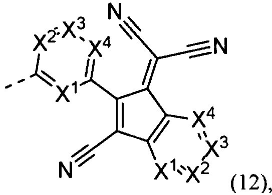 und 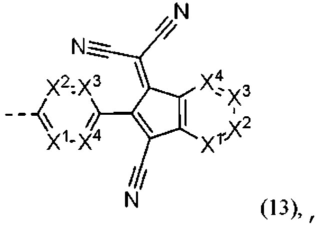 wobei
X¹ ausgewählt ist aus CR¹ und N;
X² ausgewählt ist aus CR² und N;
X³ ausgewählt ist aus CR³ und N;
X⁴ ausgewählt ist aus CR⁴ und N;
X⁵ ausgewählt ist aus CR⁵ und N;
wobei eines von R¹, R², R³, R⁴ und R⁵ unabhängig ausgewählt ist aus elektronenziehender Gruppe, Halogen, teilfluoriertem oder perfluoriertem Alkyl, teilfluoriertem oder perfluoriertem Alkoxy, D oder H, vorzugsweise CN, Cl, F, teilfluoriertem oder perfluoriertem C₁- bis C₁₀-Alkyl, CF₃, teilfluoriertem oder perfluoriertem C₁- bis C₆-Alkoxy;
wobei wenigstens zwei von X¹ bis X⁵ unabhängig ausgewählt sind aus CR¹ bis CR⁵.

11. Aktivmatrix-OLED-Anzeige nach einem der vorstehenden Ansprüche 2 bis 10, wobei die Verbindungen von p-Dotierstoffen, die Chinon oder Chinoid umfassen, die folgende Struktur E1 bis E11 aufweisen:

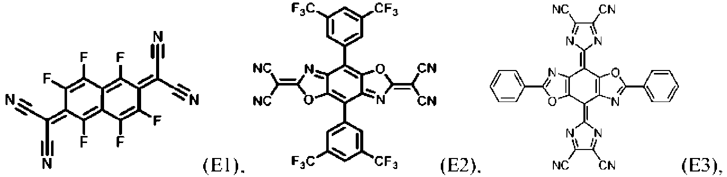

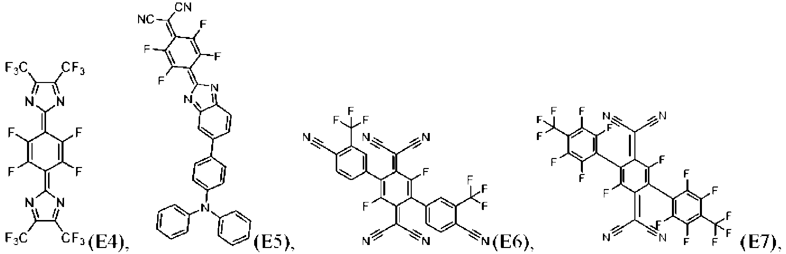

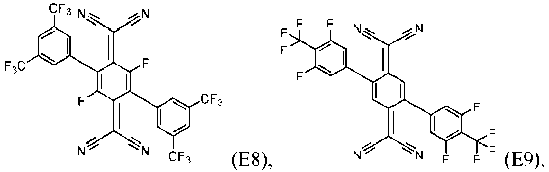

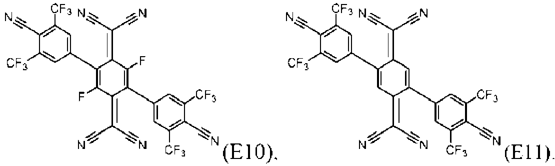

12. Aktivmatrix-OLED-Anzeige nach einem der vorstehenden Ansprüche 1 bis 11, wobei die substituierte oder unsubstituierte aromatische Verbindung, die kondensierte Ringe umfasst, durch die Formeln (14a), (14b), (14c), (14d), (14e) und Formel (15) dargestellt wird: 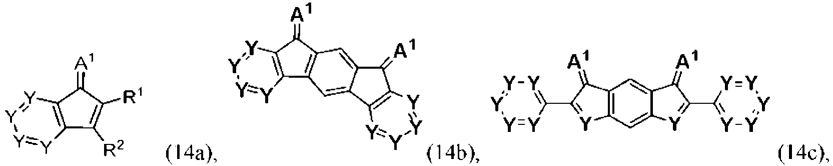 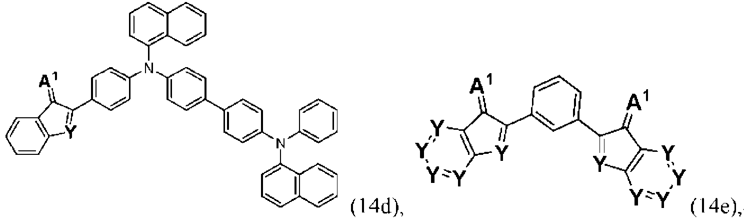 wobei
A¹ ausgewählt ist aus 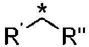 oder NR"', wobei "*" die Bindungsposition von A¹ an die Doppelbindung von Formel (14) ist, wobei
R' ausgewählt ist aus einer elektronenziehenden Gruppe, substituiertem oder unsubstituiertem Alkyl, substituiertem oder unsubstituiertem Heteroaryl, substituiertem oder unsubstituiertem C₂- bis C₂₀-Heteroaryl, substituiertem oder unsubstituiertem Aryl, substituiertem oder unsubstituiertem C₆- bis C₂₄-Aryl, perfluoriertem Alkyl, höchst bevorzugt substituiertem oder unsubstituiertem C₁- bis C₈-Alkyl, CN, substituiertem oder unsubstituiertem C₂- bis C₂₀-Heteroaryl, substituiertem oder unsubstituiertem C6- bis C₂₄-Aryl, C₁- bis C₈-Alkyl, perfluoriertem C₁- bis C₈-Alkyl, CF₃, NO₂, F,
wobei der Substituent an R' unabhängig ausgewählt ist aus einer Gruppe umfassend eine elektronenziehende Gruppe, CN, Halogen, Cl, F, teilfluoriertes oder perfluoriertes Alkyl, teilfluoriertes oder perfluoriertes C₁- bis C₁₀-Alkyl, CF₃, teilfluoriertes oder perfluoriertes Alkoxy, teilfluoriertes oder perfluoriertes C₁- bis C₆-Alkoxy, höchst bevorzugt OCF₃, D oder H;
R" ausgewählt ist aus einer elektronenziehenden Gruppe, substituiertem oder unsubstituiertem Alkyl, substituiertem oder unsubstituiertem Heteroaryl, substituiertem oder unsubstituiertem C₂- bis C₂₀-Heteroaryl, substituiertem oder unsubstituiertem Aryl, substituiertem oder unsubstituiertem C₆- bis C₂₄-Aryl, perfluoriertem Alkyl, höchst bevorzugt substituiertem oder unsubstituiertem C₁- bis C₃-Alkyl, CN, substituiertem oder unsubstituiertem C₂- bis C₂₀-Heteroaryl, substituiertem oder unsubstituiertem C6- bis C₂₄-Aryl, C₁- bis C₈-Alkyl, perfluoriertem C₁- bis C₈-Alkyl, CF₃, NO₂, F,
wobei der Substituent an R" unabhängig ausgewählt ist aus einer Gruppe umfassend elektronenziehende Gruppe, CN, Halogen, Cl, F, teilfluoriertes oder perfluoriertes Alkyl, teilfluoriertes oder perfluoriertes C₁- bis C₁₀-Alkyl, CF₃, teilfluoriertes oder perfluoriertes Alkoxy, teilfluoriertes oder perfluoriertes C₁- bis C₆-Alkoxy, höchst bevorzugt OCF₃, D oder H;
R‴ ausgewählt ist aus einer Bindung, substituiertem oder unsubstituiertem C₁- bis C₁₈-Alkyl, substituiertem oder unsubstituiertem C₆- bis C₂₄-Aryl, substituiertem oder unsubstituiertem C₆- bis C₂₄-Heteroaryl, CN,
wobei der Substituent an R‴ unabhängig ausgewählt ist aus einer Gruppe umfassend substituiertes oder unsubstituiertes C₆- bis C₂₄-Aryl, elektronenziehende Gruppe, CN, F, CF₃, perfluoriertes C₁- bis C₈-Alkyl;
R¹ und R² unabhängig ausgewählt sind aus einer Gruppe umfassend elektronenziehende Gruppe, Halogen, F, Cl, CN, substituiertes Alkyl, substituiertes C₁- bis C₈-Alkyl, teilfluoriertes oder perfluoriertes C₁- bis C₈-Alkyl, vorzugsweise CF₃, substituiertes oder unsubstituiertes Aryl, substituiertes oder unsubstituiertes C₆ bis C₂₄-Ary, substituiertes oder unsubstituiertes Heteroaryl, substituiertes oder unsubstituiertes C₂- bis C₂₀-Heteroaryl, substituiertes C₁ bis C₈-Alkoxy, teilfluoriertes oder perfluoriertes C₁- bis C₈-Alkoxy, vorzugsweise OCF₃, teilfluoriertes oder perfluoriertes Alkylaryl, teilfluoriertes oder perfluoriertes C₆- bis C₂₄-Alkylaryl, O, S, N;
wobei der Substituent an R¹ und R² unabhängig ausgewählt ist aus einer Gruppe umfassend eine elektronenziehende Gruppe, vorzugsweise CN, substituiertes oder unsubstituiertes Alkyl, substituiertes oder unsubstituiertes C₁- bis C₃-Alkyl, substituiertes oder
unsubstituiertes Heteroaryl, substituiertes oder unsubstituiertes C₂- bis C₂₀-Heteroaryl, substituiertes oder unsubstituiertes Aryl, substituiertes oder unsubstituiertes C₆- bis C₂₄-Aryl, perfluoriertes Alkyl, perfluoriertes C₁- bis C₈-Alkyl, höchst bevorzugt CF₃, NO₂, F;
wobei R¹ und R² zusammen gegebenenfalls einen substituierten oder unsubstituierten Carbozyklus oder einen substituierten oder unsubstituierten Heterozyklus, vorzugsweise einen substituierten oder unsubstituierten Carbozyklus, bilden;
wobei die Substituenten an dem Zyklus ausgewählt sind aus einer Gruppe umfassend elektronenziehende Gruppe, F, CN, perfluoriertes C₁- bis C₈-Alkyl, vorzugsweise perfluoriertes C₁- bis C₈-Alkoxy, OCF₃; substituiertes oder unsubstituiertes C₆- bis C₁₈-Aryl, substituiertes oder unsubstituiertes C₂- bis C₁₈-Heteroaryl, substituiertes oder unsubstituiertes Carbocyclen, substituiertes oder unsubstituiertes Carbocycliden, substituiertes oder unsubstituiertes Alkylen, substituiertes oder unsubstituiertes Alkyliden;
wobei die Substituenten ausgewählt sind aus einer Gruppe umfassend eine elektronenziehende Gruppe, Halogen, F, Cl, CN, perfluoriertes Alkyl, perfluoriertes C₁- bis C₈-Alkyl, CF₃, teilfluoriertes oder perfluoriertes Alkylaryl, teilfluoriertes oder perfluoriertes C₆- bis C₁₈-Alkylaryl, perfluoriertes C₁- bis C₈-Alkoxy, OCF₃;
Y unabhängig voneinander ausgewählt ist aus N und CR^{a},
R^{a} unabhängig ausgewählt ist aus einer Gruppe umfassend H, D, elektronenziehende Gruppe, CN, substituiertes oder unsubstituiertes C₁- bis C₈-Alkyl, perfluoriertes C₁- bis C₈-Alkyl, CF₃, perfluoriertes C₁- bis C₈-Alkoxy, OCF₃;
wobei die Substituenten an R^{a} unabhängig ausgewählt sind aus einer Gruppe umfassend elektronenziehende Gruppe, CN, Halogen, Cl, F, teilfluoriertes oder perfluoriertes Alkyl, teilfluoriertes oder perfluoriertes C₁- bis C₁₀-Alkyl, CF₃, teilfluoriertes oder perfluoriertes Alkoxy, teilfluoriertes oder perfluoriertes C₁- bis C₆-Alkoxy, höchst bevorzugt OCF₃, D oder H;
wobei zwei R^{a} gegebenenfalls einen substituierten oder unsubstituierten Carbozyklus oder einen substituierten oder unsubstituierten Heterozyklus, vorzugsweise einen substituierten oder unsubstituierten Carbozyklus, bilden;
wobei die Substituenten an dem Zyklus unabhängig ausgewählt sind aus einer Gruppe umfassend elektronenziehende Gruppe, F, CN, perfluoriertes C₁- bis C₈-Alkyl, vorzugsweise perfluoriertes C₁- bis C₈-Alkoxy, OCF₃; substituiertes oder unsubstituiertes C₆- bis C₁₈-Aryl, substituiertes oder unsubstituiertes C₂- bis C₁₈-Heteroaryl, substituiertes oder unsubstituiertes Carbocyclen, substituiertes oder unsubstituiertes Carbocycliden, substituiertes oder unsubstituiertes Alkylen, substituiertes oder unsubstituiertes Alkyliden; wobei zwei Y gegebenenfalls einen substituierten oder unsubstituierten Carbozyklus oder einen substituierten oder unsubstituierten Heterozyklus, vorzugsweise einen substituierten oder unsubstituierten Carbozyklus, bilden;
wobei die Substituenten an dem Zyklus elektronenziehende Gruppe, F, CN, perfluoriertes C₁- bis C₃-Alkyl, vorzugsweise perfluoriertes C₁- bis C₈-Alkoxy, OCF₃; substituiertes oder unsubstituiertes C₆- bis C₁₈-Aryl, substituiertes oder unsubstituiertes C₂- bis C₁₈-Heteroaryl, substituiertes oder unsubstituiertes Carbocyclen, substituiertes oder unsubstituiertes Carbocycliden, substituiertes oder unsubstituiertes Alkylen, substituiertes oder unsubstituiertes Alkyliden sein können; 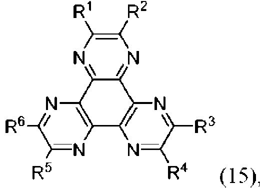 wobei
R¹, R², R³, R⁴, R⁵ und R⁶ unabhängig ausgewählt sind aus einer Gruppe umfassend H, F, CN, CF₃ und NO₂, wobei wenigstens eines von R¹, R², R³, R⁴, R⁵ und R⁶ F, CN, CF₃ oder NO₂ ist.

13. Aktivmatrix-OLED-Anzeige nach einem der vorstehenden Ansprüche 1 bis 12, wobei die substituierte oder unsubstituierte aromatische Verbindung, die kondensierte Ringe umfasst, eine Struktur von G1 bis G4 aufweist:

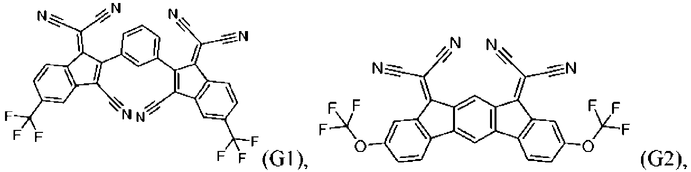

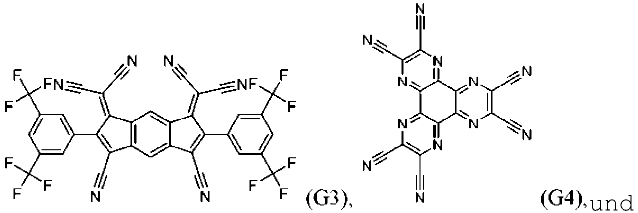

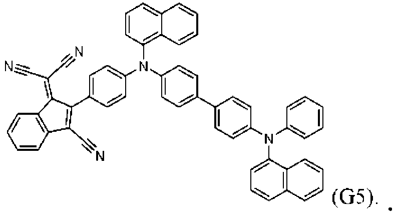

14. Aktivmatrix-OLED-Anzeige nach einem der vorstehenden Ansprüche 1 bis 13, wobei wenigstens ein R¹ und R² unabhängig ausgewählt ist aus einer Gruppe umfassend CN, OCF₃, CF₃, F, perfluoriertes C₁- bis C₈-Alkyl, substituiertes C₆- bis C₂₄-Aryl, wobei der Substituent F, CF₃, CN, substituiertes C₁- bis C₈-Alkylen, ist.

15. Aktivmatrix-OLED-Anzeige nach den Ansprüchen 1 bis 14, wobei die gemeinsame Lochinjektionsschicht (130) aus dem organischen p-Dotierstoff besteht oder die gemeinsame Lochtransportschicht (140) den organischen p-Dotierstoff und ein Lochtransportmaterial umfasst.

16. Aktivmatrix-OLED-Anzeige nach den Ansprüchen 1 bis 15, wobei die erste gemeinsame Halbleiterschicht wenigstens einen organischen p-Dotierstoff umfasst, der sich in direktem Kontakt mit der Anodenschicht (120) befindet, wobei die zweite gemeinsame Halbleiterschicht zwischen der ersten Halbleiterschicht und der Emissionsschicht angeordnet ist.

17. Aktivmatrix-OLED-Anzeige nach einem der vorstehenden Ansprüche 1 bis 16, wobei der gemeinsame Stapel von organischen Schichten zusätzlich eine gemeinsame organische Schicht ausgewählt aus der Gruppe umfassend eine gemeinsame Elektroneninjektionsschicht, eine gemeinsame Lochsperrschicht und/oder eine Elektronentransportschicht (160) umfasst, wobei sich die gemeinsame Elektroneninjektionsschicht vorzugsweise in direktem Kontakt mit der gemeinsamen Kathodenschicht (190) befindet.

18. Aktivmatrix-OLED-Anzeige nach einem der vorstehenden Ansprüche 1 bis 17, wobei die Aktivmatrix-OLED-Anzeige eine Ansteuerschaltung umfasst, die dafür gestaltet ist, die Pixel der Vielzahl von organischen Leuchtdiodenpixeln getrennt anzusteuern.

19. Aktivmatrix-OLED-Anzeige nach einem der vorstehenden Ansprüche 1 bis 18, wobei die erste gemeinsame Halbleiterschicht von der Vielzahl von OLED-Pixeln gemeinsam genutzt wird und/oder die zweite gemeinsame Halbleiterschicht von der Vielzahl von OLED-Pixeln gemeinsam genutzt wird, wobei vorzugsweise alle gemeinsamen Halbleiterschichten von der Vielzahl von OLED-Pixeln gemeinsam genutzt werden.

## Revendications

1. Écran OLED à matrice active, comprenant une pluralité de pixels OLED (100 ; 200 ; 300), chaque pixel (100 ; 200 ; 300) comprenant lui-même un empilement de couches organiques et chaque couche de l'empilement de couches organiques pouvant former une couche semi-conductrice commune, dans lequel
- au moins un premier pixel OLED (100) et un deuxième pixel OLED (200) comprennent
- une couche anodique (120),
- une couche cathodique commune (190),
- au moins une couche d'émission, qui est éventuellement une couche d'émission commune,
- au moins un empilement de couches organiques, l'empilement de couches organiques étant disposé entre la couche anodique (120) et la couche cathodique (190), comprenant
- une pluralité de couches semi-conductrices, la pluralité de couches semi-conductrices comprenant au moins deux couches semi-conductrices communes ou plus, la pluralité de couches semi-conductrices comprenant
- au moins une première couche semi-conductrice commune comprenant au moins un dopant p organique,
- au moins une deuxième couche semi-conductrice commune,
- une troisième couche semi-conductrice commune,
- une couche semi-conductrice commune s'étendant sur tous les pixels de la pluralité de pixels ou s'étendant sur au moins deux pixels de la pluralité de pixels dans l'écran OLED,
- la première couche semi-conductrice commune étant une couche d'injection de trous commune (130),
- la deuxième couche semi-conductrice commune étant une couche de transport de trous commune (140),
- la troisième couche semi-conductrice commune étant une couche de blocage d'électrons commune (145),
- la couche d'injection de trous commune (130) étant en contact direct avec la couche de transport de trous commune (140),
- la couche de blocage d'électrons commune (145) étant en contact direct avec la couche de transport de trous commune (140),
- la deuxième couche semi-conductrice commune ayant une épaisseur de couche ≥ 15 nm à ≤ 230 nm,
- la troisième couche semi-conductrice commune ayant une épaisseur de couche de 1 nm à 20 nm, et
dans lequel le premier semi-conducteur commun comprend au moins un dopant p organique, la deuxième couche semi-conductrice commune et la troisième couche semi-conductrice commune possèdent ensemble une résistance de couche ≥ 50 gigaohms par carré, la résistance de couche Rs étant mesurée par le procédé de ligne de transmission tel que décrit dans la description.

2. Écran OLED à matrice active selon la revendication 1 précédente, dans lequel le dopant p organique est choisi dans le groupe comprenant un 3-radialène substitué ou non substitué, une quinone substituée ou non substituée, un quinoïde substitué ou non substitué, et un composé aromatique substitué ou non substitué qui comprend des noyaux condensés, et mieux encore le dopant p organique est choisi parmi les composés 3-radialène substitués ou non substitués.

3. Écran OLED à matrice active selon la revendication 2, dans lequel le composé 3-radialène est représenté par la formule (1) : 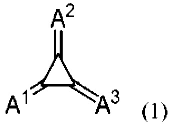 dans laquelle A¹, A² et A³ sont indépendamment choisis à partir de la formule (2) : 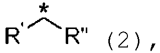 dans laquelle « * » est la position de liaison de A¹, A² et A³ à la double liaison de la formule (1),
R' est indépendamment choisi dans le groupe comprenant les groupes aryle substitués ou non substitués, hétéroaryle substitués ou non substitués, alkyle substitués ou non substitués, et de préférence aryle en C₆ à C₂₄ substitués ou non substitués, hétéroaryle en C₂ à C₂₀ substitués ou non substitués, alkyle en C₁ à C₃ substitués ou non substitués ;
dans laquelle le substituant sur R' est indépendamment choisi dans le groupe comprenant un groupe électroattracteur, CN, un halogène, Cl, F, un alkyle partiellement fluoré ou perfluoré, un alcoxy partiellement fluoré ou perfluoré, et de préférence un alkyle en C₁ à C₁₀ partiellement fluoré ou perfluoré, un alcoxy en C₁ à C₆ partiellement fluoré ou perfluoré, et mieux encore CF₃, OCF₃, D et H ;
R" est choisi dans le groupe comprenant un groupe électroattracteur, de préférence CN, un alkyle substitué ou non substitué, un hétéroaryle substitué ou non substitué, un aryle substitué ou non substitué, un alkyle perfluoré, mieux un alkyle en C₁ à C₈ substitué ou non substitué, un hétéroaryle en C₂ à C₂₀ substitué ou non substitué, un aryle en C₆ à C₂₄ substitué ou non substitué, un alkyle en C₁ à C₈ perfluoré, et mieux encore CF₃, NO₂ et F ;
dans laquelle le substituant sur R" est indépendamment choisi dans le groupe comprenant un groupe électroattracteur, CN, un halogène, Cl, F, un alkyle partiellement fluoré ou perfluoré, un alcoxy partiellement fluoré ou perfluoré, et de préférence un alkyle en C₁ à C₁₀ partiellement fluoré ou perfluoré, un alcoxy en C₁ à C₆ partiellement fluoré ou perfluoré, et mieux encore CF₃, OCF₃, D et H ;
dans laquelle R' et R" forment éventuellement ensemble un carbocycle substitué ou non substitué ou un hétérocycle substitué ou non substitué, de préférence un hétérocycle substitué ou non substitué ;
dans laquelle les substituants sont indépendamment choisis dans le groupe comprenant un groupe électroattracteur, F, CN, un alkyle en C₁ à C₈ perfluoré, un aryle en C₆ à C₁₈ substitué ou non substitué, un hétéroaryle en C₂ à C₁₈ substitué ou non substitué, un carbocyclène en C₃ à C₁₈ substitué ou non substitué, un carbocyclidène en C₃ à C₁₈ substitué ou non substitué, un alkylène en C₁ à C₈ substitué, un alkylidène en C₁ à C₈ substitué ou non substitué ;
dans laquelle les substituants sont choisis dans le groupe comprenant un groupe électroattracteur, un halogène, F, Cl, CN, un alkyle perfluoré, un alkyle perfluoré en C₁ à C₈, CF₃, un alkylaryle partiellement fluoré ou perfluoré, un alkylaryle en C₆ à C₁₈ partiellement fluoré ou perfluoré.

4. Écran OLED à matrice active selon l'une quelconque des revendications 1 à 3 précédentes, dans lequel
R' est indépendamment choisi dans le groupe comprenant un aryle en C₆ à C₂₄ substitué ou non substitué et un hétéroaryle en C₂ à C₂₀ substitué ou non substitué ;
R" est un groupe électroattracteur, de préférence R" est indépendamment choisi dans le groupe comprenant CN, CF₃, NO₂ et F, et mieux encore R" est CN.

5. Écran OLED à matrice active selon l'une quelconque des revendications 1 à 4 précédentes, dans lequel A¹, A² et A³ sont choisis de telle sorte que A¹=A²≠A³, ou A¹≠A² et A¹≠A³ et A²=A³.

6. Écran OLED à matrice active selon l'une quelconque des revendications 1 à 5 précédentes, dans lequel A¹ est choisi parmi les formules (3) et (4) : 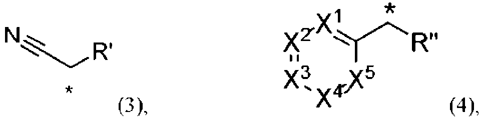 dans lesquelles
X¹ est choisi entre CR¹ et N ;
X² est choisi entre CR² et N ;
X³ est choisi entre CR³ et N ;
X⁴ est choisi entre CR⁴ et N ;
X⁵ est choisi entre CR⁵ et N ;
R¹, R², R³, R⁴ et R⁵ sont indépendamment choisis dans un groupe comprenant un groupe électroattracteur, CN, un halogène, Cl, F, un alkyle partiellement fluoré ou perfluoré, un alkyle en C₁ à C₁₀ partiellement fluoré ou perfluoré, de préférence CF₃, un alcoxy partiellement fluoré ou perfluoré, un alcoxy en C₁ à C₆ partiellement fluoré ou perfluoré, D et H ;
dans laquelle au moins deux des X¹ à X⁵ sont indépendamment choisis parmi les CR¹ à CR⁵ ; et
dans laquelle « * » dans les formules (3) et (4) est la position de liaison de A¹ à la double liaison de la formule (1).

7. Écran OLED à matrice active selon l'une quelconque des revendications 1 à 6 précédentes, dans lequel A¹ est choisi dans un groupe comprenant les groupes D1 à D210 : 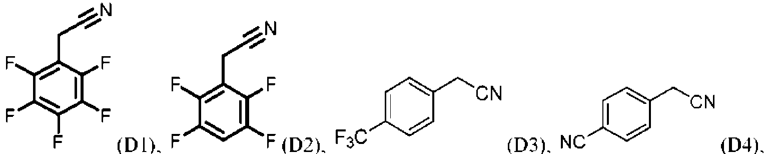 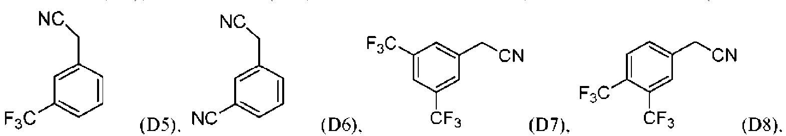 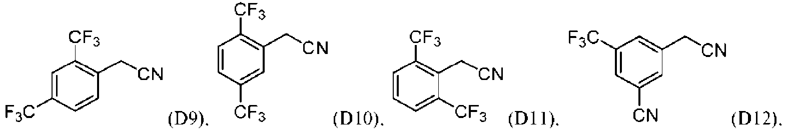 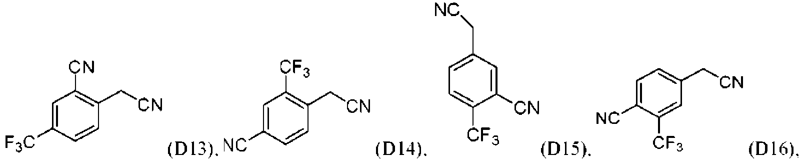 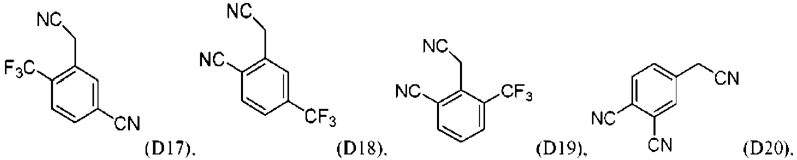 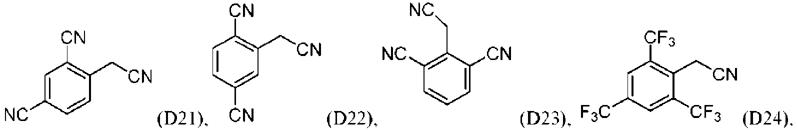 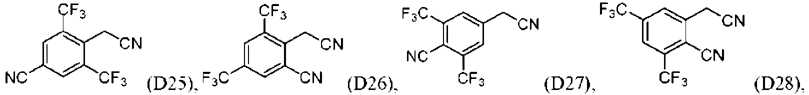 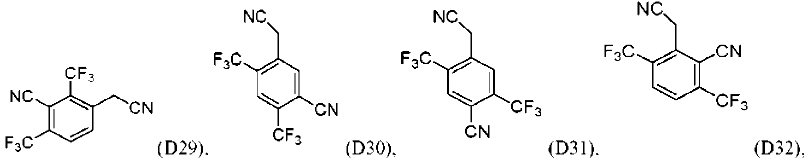 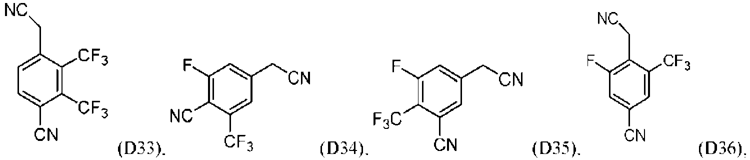 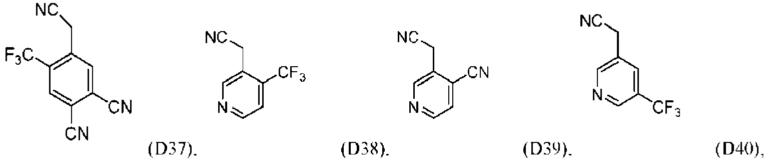 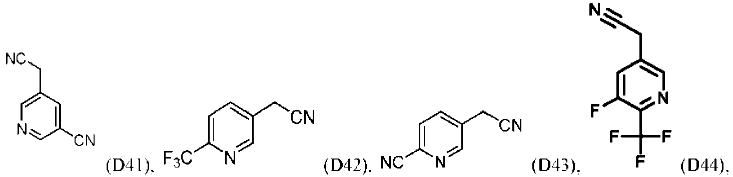 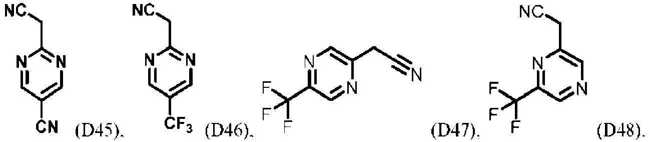 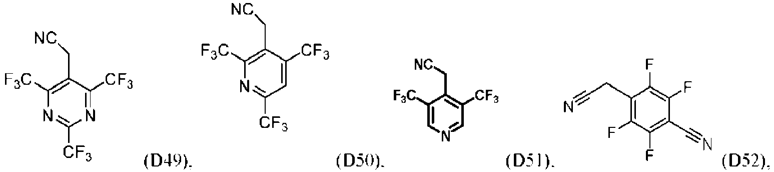 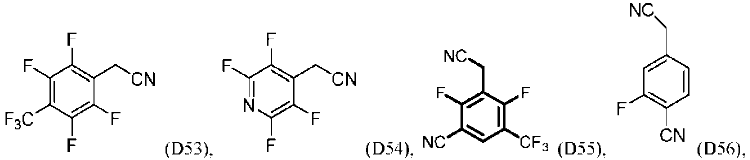 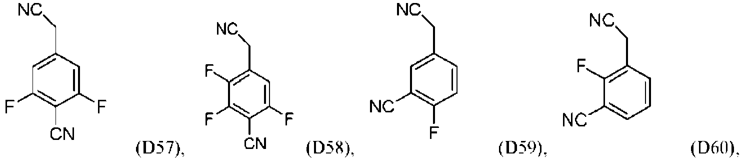 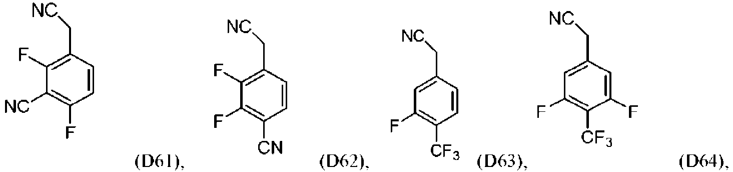 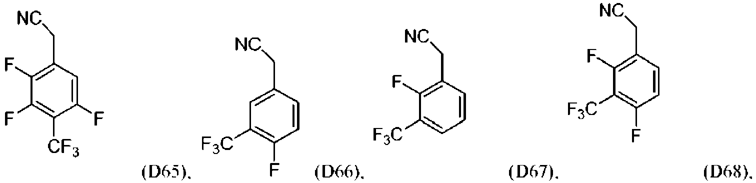 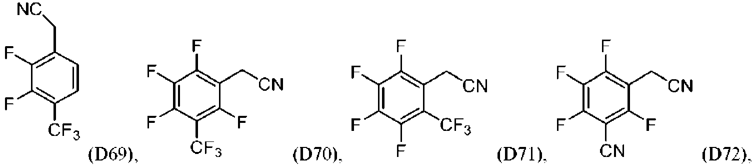 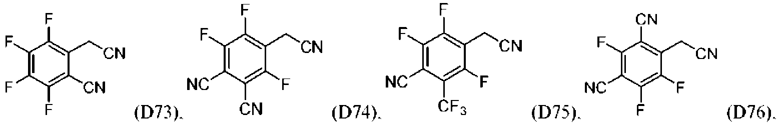 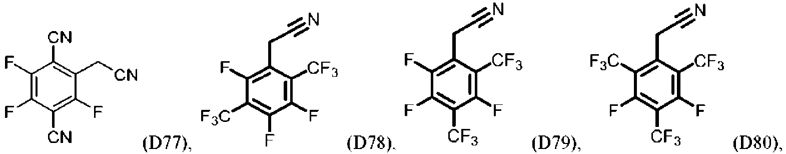 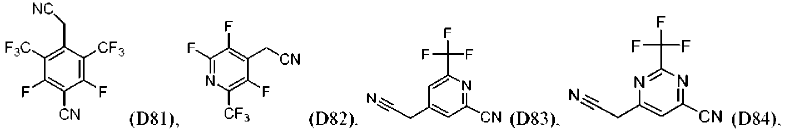 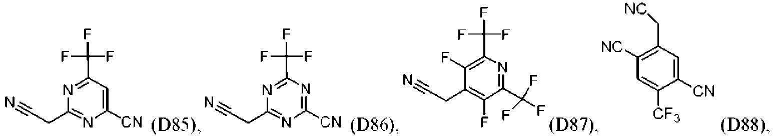 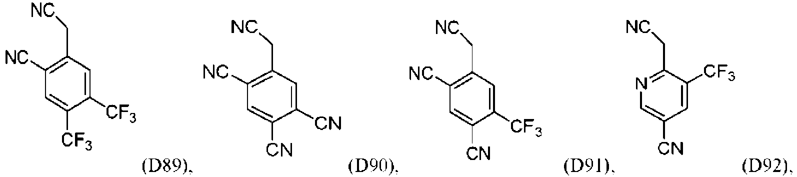 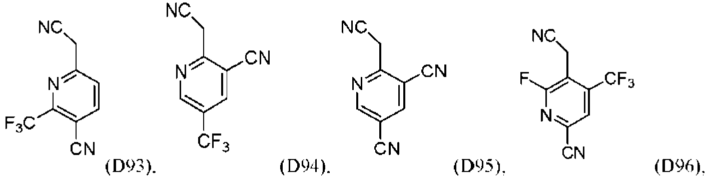 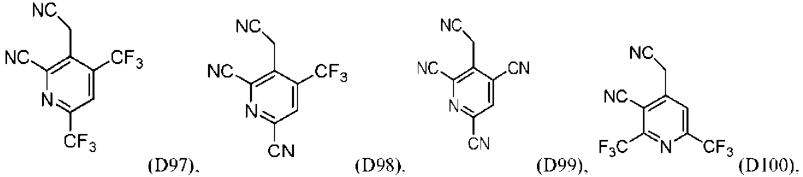 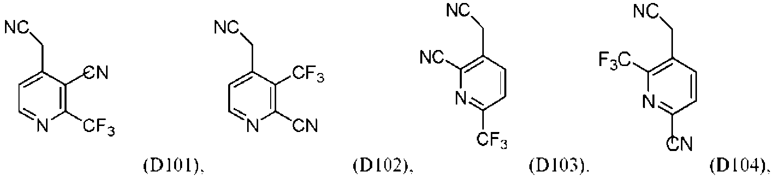 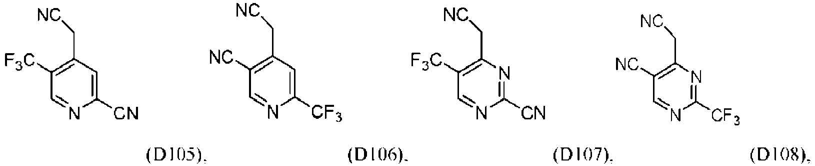 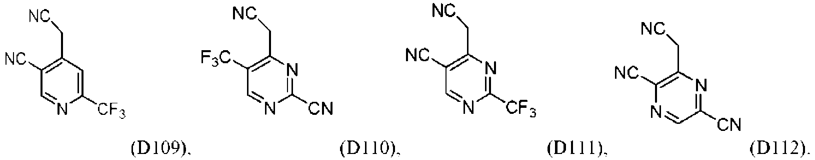 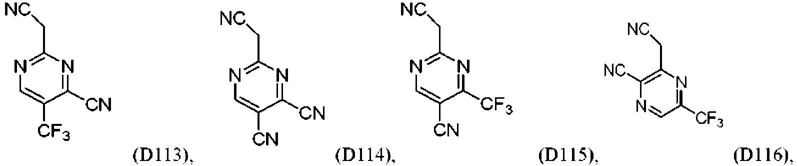 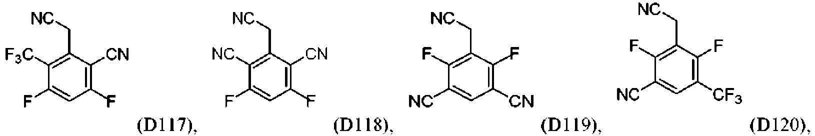 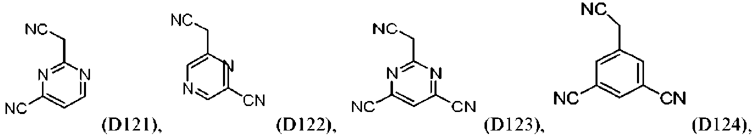 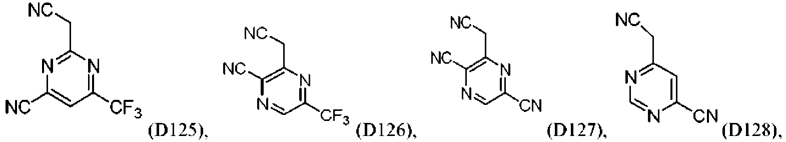 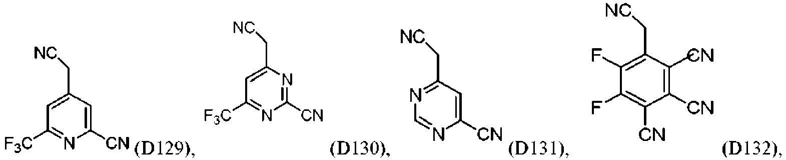 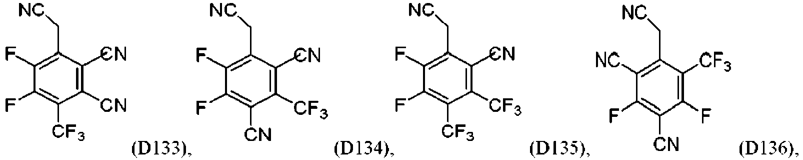 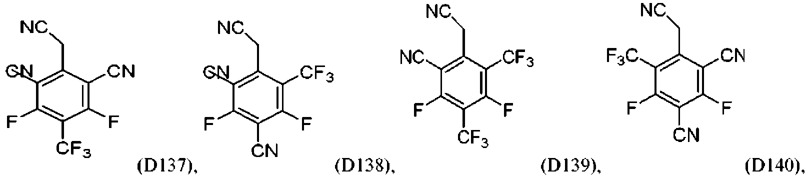 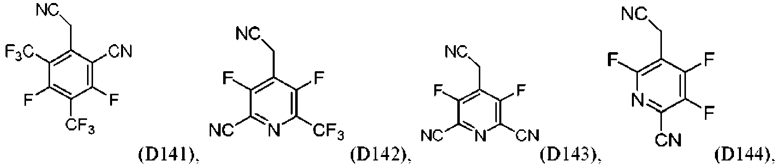 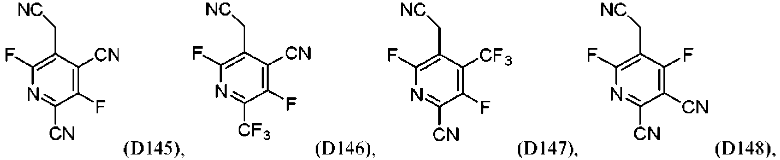 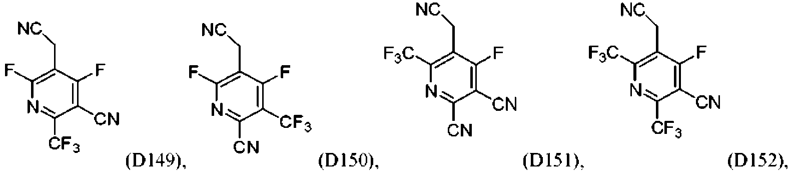 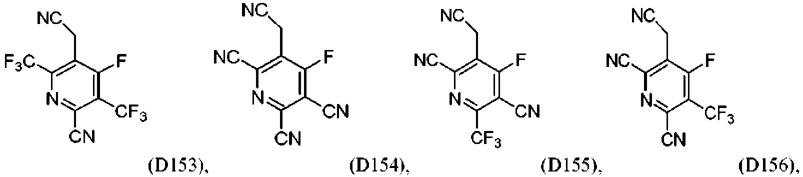 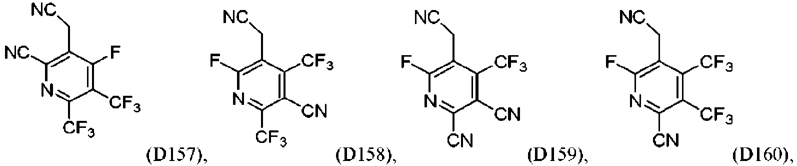 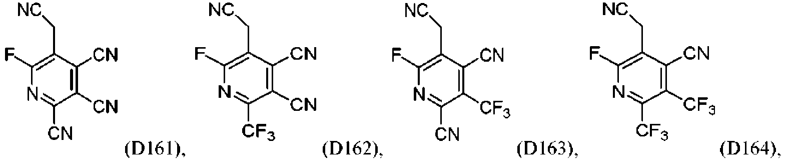 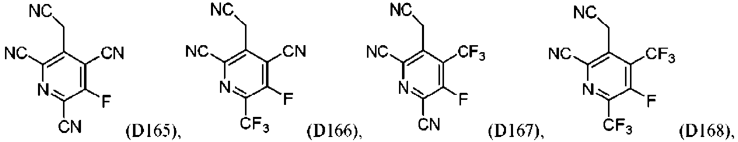 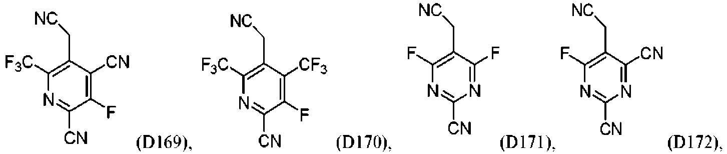 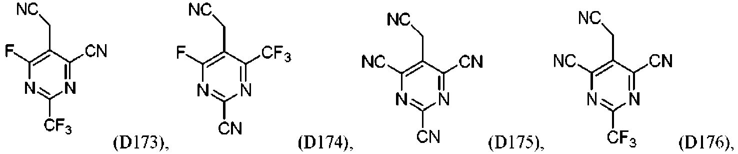 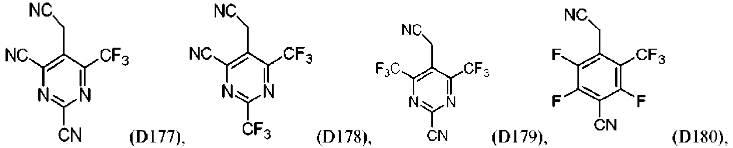 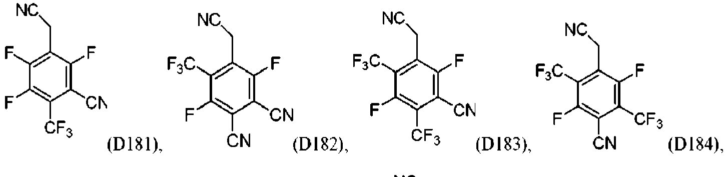 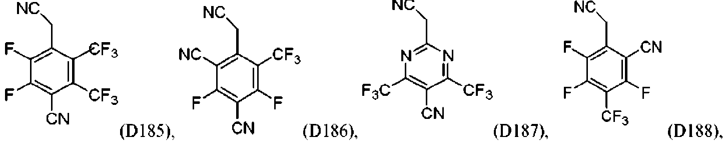 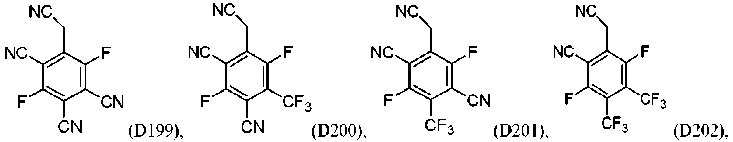 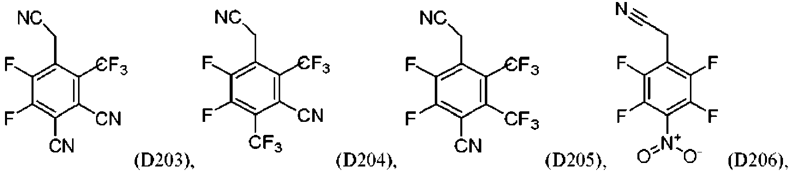 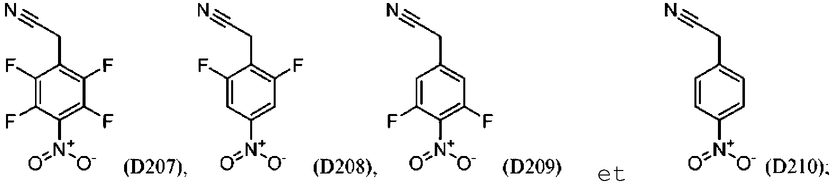 dans lesquels
« * » du substituant 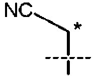 dans les groupes D1 à D210 indique la position de liaison de A¹ à la double liaison de la formule (1).

8. Écran OLED à matrice active selon l'une quelconque des revendications 2 à 7 précédentes, dans lequel la quinone du dopant p organique répond à la formule (5) et le quinoïde du dopant p organique répond à la formule (6), 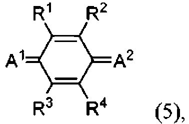 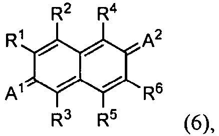 dans lesquelles
A¹ et A² sont indépendamment choisis parmi la formule (7) : 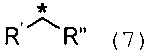 et NR''', « * » étant la position de liaison de A¹ et A² à la double liaison de la formule (5) et de la formule (6) :
R' est choisi parmi un groupe électroattracteur, un alkyle substitué ou non substitué, un hétéroaryle substitué ou non substitué, un aryle substitué ou non substitué, un alkyle perfluoré, de préférence un alkyle en C₁ à C₈ substitué ou non substitué, un hétéroaryle en C₂ à C₂₀ substitué ou non substitué, un aryle en C₆ à C₂₄ substitué ou non substitué, un alkyle perfluoré en C₁ à C₈, CF₃, NO₂, F, CN,
le substituant sur R' étant indépendamment choisi dans un groupe comprenant D, H, un groupe électroattracteur, CN, un halogène, Cl, F, un alkyle partiellement fluoré ou perfluoré, un alkyle en C₁ à C₁₀ partiellement fluoré ou perfluoré, CF₃, un alcoxy partiellement fluoré ou perfluoré, un alcoxy en C₁ à C₆ partiellement fluoré ou perfluoré, et mieux encore CN, CF₃, OCF₃, D et H ;
R" un groupe électroattracteur, un alkyle substitué ou non substitué, un hétéroaryle substitué ou non substitué, un aryle substitué ou non substitué, un alkyle perfluoré, de préférence un alkyle en C₁ à C₃ substitué ou non substitué, un hétéroaryle en C₂ à C₂₀ substitué ou non substitué, un aryle en C₆ à C₂₄ substitué ou non substitué, un alkyle perfluoré en C₁ à C₈, CF₃, NO₂, F, CN,
le substituant sur R" étant indépendamment choisi dans un groupe comprenant un groupe électroattracteur, CN, un halogène, Cl, F, un alkyle partiellement fluoré ou perfluoré, un alkyle en C₁ à C₁₀ partiellement fluoré ou perfluoré, CF₃, un alcoxy partiellement fluoré ou perfluoré, un alcoxy en C₁ à C₆ partiellement fluoré ou perfluoré, et mieux encore CN, CF₃, OCF₃, D et H ;
R' et R" formant éventuellement ensemble un cycle substitué ou non substitué, et le cycle substitué ou non substitué pouvant être un carbocycle substitué ou non substitué ou un hétérocycle substitué ou non substitué, de préférence un hétérocycle substitué ou non substitué ; R''' est choisi parmi une liaison, un alkyle en C₁ à C₁₈ substitué ou non substitué, un aryle en C₆ à C₂₄ substitué ou non substitué, un hétéroaryle en C₆ à C₂₄ substitué ou non substitué, CN,
le substituant sur R‴ étant indépendamment choisi dans un groupe comprenant un aryle en C₆ à C₂₄ substitué ou non substitué, un groupe électroattracteur, CN, F, CF₃, un alkyle perfluoré en C₁ à C₈ ;
R¹, R², R³ et R⁴ sont indépendamment choisis dans un groupe comprenant un groupe électroattracteur, un halogène, un alkyle substitué ou non substitué, un alkyle partiellement fluoré ou perfluoré, un aryle substitué ou non substitué, un hétéroaryle substitué ou non substitué, un alcoxy substitué, un alcoxy partiellement fluoré ou perfluoré, un alkylaryle partiellement fluoré ou
perfluoré, O, S, N substitué ou non substitué, de préférence F, Cl, CN, un alkyle en C₁ à C₈ substitué ou non substitué, un alkyle en C₁ à C₈ partiellement fluoré ou perfluoré, CF₃, un aryle en C₆ à C₂₄ substitué ou non substitué, un hétéroaryle en C₂ à C₂₀ substitué ou non substitué, un alcoxy en C₁ à C₈ substitué ou non substitué, un alcoxy en C₁ à C₈ partiellement fluoré ou perfluoré, OCF₃, un alkyle en C₁ à C₈ substitué ou non substitué, CF₃, un alkylaryle en C₆ à C₂₄ partiellement fluoré ou perfluoré,
les substituants sur R¹, R², R³ et R⁴ étant indépendamment choisis dans un groupe comprenant un groupe électroattracteur, un alkyle substitué ou non substitué, un hétéroaryle substitué ou non substitué, un aryle substitué ou non substitué, un alkyle perfluoré, de préférence CN, un alkyle en C₁ à C₃ substitué ou non substitué, un hétéroaryle en C₂ à C₂₀ substitué ou non substitué, un aryle en C₆ à C₂₄ substitué ou non substitué, un alkyle perfluoré en C₁ à C₈, CF₃, NO₂, F ;
R¹ et R² ensemble, ou R³ et R⁴ ensemble, pouvant éventuellement former indépendamment les uns des autres un carbocycle substitué ou non substitué ou un hétérocycle substitué ou non substitué, de préférence un hétérocycle substitué ou non substitué ;
les substituants étant indépendamment choisis dans un groupe comprenant un groupe électroattracteur, F, CN, un alkyle perfluoré en C₁ à C₈, de préférence un alcoxy perfluoré en C₁ à C₈, de préférence OCF₃ ; un aryle en C₆ à C₁₈ substitué ou non substitué, un hétéroaryle en C₂ à C₁₈ substitué ou non substitué, un carbocyclène substitué ou non substitué, un carbocyclidène substitué ou non substitué, un alkylène substitué ou non substitué, un alkylidène substitué ou non substitué ;
les substituants étant indépendamment choisis dans un groupe comprenant un groupe électroattracteur, un halogène, F, Cl, CN, un alkyle perfluoré, CF₃, un alkylaryle partiellement fluoré ou perfluoré, un alkylaryle en C₆ à C₁₈ partiellement fluoré ou perfluoré, un alcoxy perfluoré en C₁ à C₈, de préférence OCF₃ ;
A¹ et R³ ensemble et A² et R ensemble formant éventuellement, indépendamment les uns des autres, un noyau hétérocyclique substitué ou non substitué ;
les substituants étant indépendamment choisis dans un groupe comprenant un aryle en C₆ à C₁₈ substitué ou non substitué, un carbocyclène substitué ou non substitué, un carbocyclidène substitué ou non substitué, un alkylène substitué ou non substitué, un alkylidène substitué ou non substitué ;
les substituants étant indépendamment choisis dans un groupe comprenant un groupe électroattracteur, un halogène, F, Cl, CN, un alkyle perfluoré, CF₃, un alkylaryle partiellement fluoré ou perfluoré, un alkylaryle en C₆ à C₁₈ partiellement fluoré ou perfluoré.

9. Écran OLED à matrice active selon l'une quelconque des revendications 1 à 8 précédentes, dans lequel A¹ et A² sont indépendamment choisis parmi les groupes D1 à D8 : 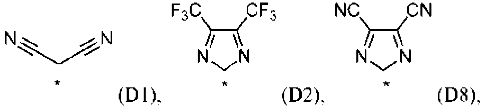 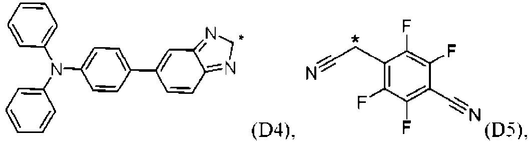 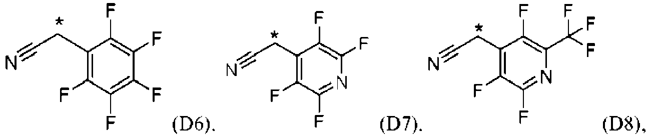 dans lesquels
« * » est la position de liaison de A¹, A² et A³ à la double liaison de la formule (1), et A¹ et A² de la formule (5) et de la formule (6).

10. Écran OLED à matrice active selon l'une quelconque des revendications 1 à 9 précédentes, dans lequel A¹ et A2 sont choisis parmi les formules (8) à (13) : 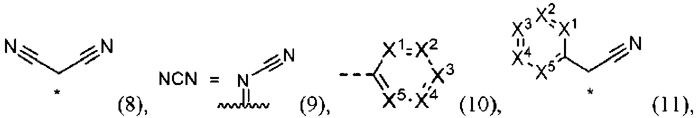 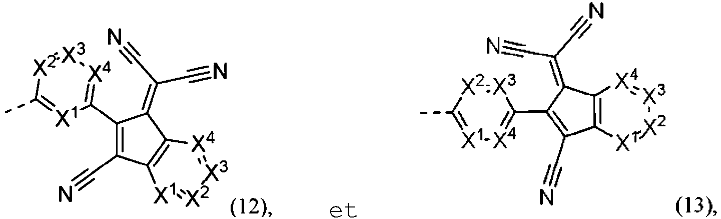 dans lesquelles
X¹ est choisi entre CR¹ et N ;
X² est choisi entre CR² et N ;
X³ est choisi entre CR³ et N ;
X⁴ est choisi entre CR⁴ et N ;
X⁵ est choisi entre CR⁵ et N ;
l'un des R¹, R², R³, R⁴ et R⁵ étant indépendamment choisis parmi un groupe électroattracteur, un halogène, un alkyle partiellement fluoré ou perfluoré, un alcoxy partiellement fluoré ou perfluoré, D et H, de préférence CN, Cl, F, un alkyle en C₁ à C₁₀ partiellement fluoré ou perfluoré, CF₃, un alcoxy en C₁ à C₆ partiellement fluoré ou perfluoré ;
au moins deux des X¹ à X⁵ étant indépendamment choisis parmi les CR¹ à CR⁵.

11. Écran OLED à matrice active selon l'une quelconque des revendications 2 à 10 précédentes, dans lequel les composés de dopants p comprenant une quinone ou un quinoïde possèdent une des structures E1 à E11 suivantes :

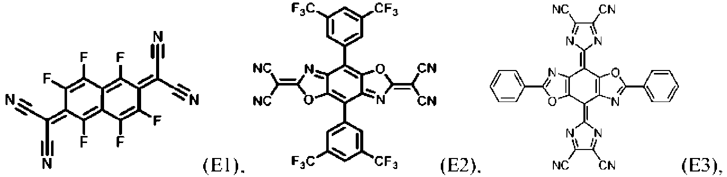

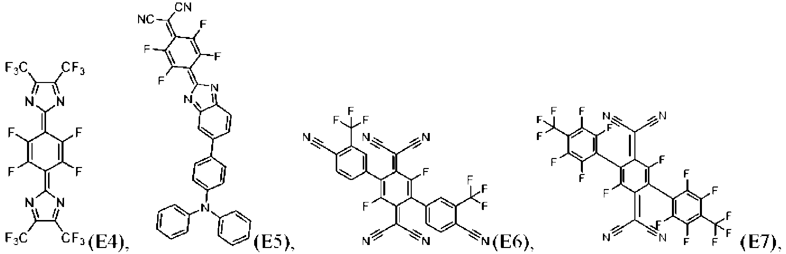

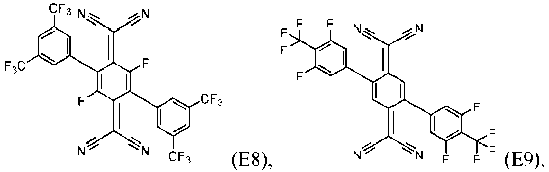

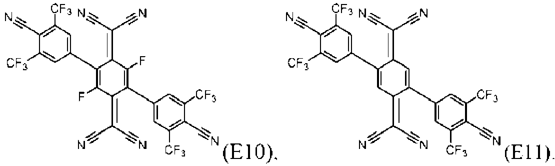

12. Écran OLED à matrice active selon l'une quelconque des revendications 1 à 11 précédentes, dans lequel le composé aromatique substitué ou non substitué qui comprend des noyaux condensés est représenté par les formules (14a), (14b), (14c), (14d), (14e) et la formule (15) : 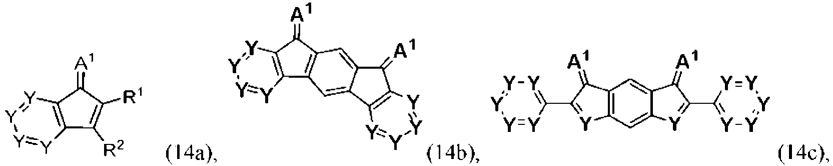 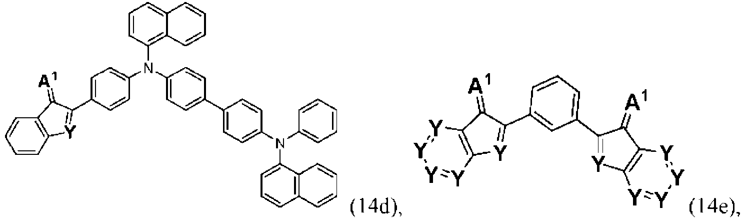 dans lesquelles
A¹ est choisi parmi 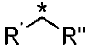 et NR''', « * » étant la position de liaison de A¹ à la double liaison de la formule (14), dans lesquels
R' est choisi parmi un groupe électroattracteur, un alkyle substitué ou non substitué, un hétéroaryle substitué ou non substitué, un hétéroaryle en C₂ à C₂₀ substitué ou non substitué, un aryle substitué ou non substitué, un aryle en C₆ à C₂₄ substitué ou non substitué, un alkyle perfluoré, idéalement un alkyle en C₁ à C₈ substitué ou non substitué, CN, un hétéroaryle en C₂ à C₂₀ substitué ou non substitué, un aryle en C₆ à C₂₄ substitué ou non substitué, un alkyle en C₁ à C₈, un alkyle perfluoré en C₁ à C₈, CF₃, NO₂, F,
le substituant sur R' étant indépendamment choisi dans un groupe comprenant un groupe électroattracteur, CN, un halogène, Cl, F, un alkyle partiellement fluoré ou perfluoré, un alkyle en C₁ à C₁₀ partiellement fluoré ou perfluoré, CF₃, un alcoxy partiellement fluoré ou perfluoré, un alcoxy en C₁ à C₆ partiellement fluoré ou perfluoré, idéalement OCF₃, D et H ;
R" est choisi parmi un groupe électroattracteur, un alkyle substitué ou non substitué, un hétéroaryle substitué ou non substitué, un hétéroaryle en C₂ à C₂₀ substitué ou non substitué, un aryle substitué ou non substitué, un aryle en C₆ à C₂₄ substitué ou non substitué, un alkyle perfluoré, idéalement un alkyle en C₁ à C₃ substitué ou non substitué, CN, un hétéroaryle en C₂ à C₂₀ substitué ou non substitué, un aryle en C₆ à C₂₄ substitué ou non substitué, un alkyle en C₁ à C₈, un alkyle perfluoré en C₁ à C₈, CF₃, NO₂, F,
le substituant sur R" étant indépendamment choisi dans un groupe comprenant un groupe électroattracteur, CN, un halogène, Cl, F, un alkyle partiellement fluoré ou perfluoré, un alkyle en C₁ à C₁₀ partiellement fluoré ou perfluoré, CF₃, un alcoxy partiellement fluoré ou perfluoré, un alcoxy en C₁ à C₆ partiellement fluoré ou perfluoré, idéalement OCF₃, D et H ;
R‴ est choisi parmi une liaison, un alkyle en C₁ à C₁₈ substitué ou non substitué, un aryle en C₆ à C₂₄ substitué ou non substitué, un hétéroaryle en C₆ à C₂₄ substitué ou non substitué, CN,
le substituant sur R‴ étant indépendamment choisi dans un groupe comprenant un aryle en C₆ à C₂₄ substitué ou non substitué, un groupe électroattracteur, CN, F, CF₃, un alkyle perfluoré en C₁ à C₈ ;
R¹ et R² sont indépendamment choisis dans un groupe comprenant un groupe électroattracteur, un halogène, F, Cl, CN, un alkyle substitué, un alkyle substitué en C₁ à C₈, un alkyle en C₁ à C₈ partiellement fluoré ou perfluoré, de préférence CF₃, un aryle substitué ou non substitué, un aryle en C₆ à C₂₄ substitué ou non substitué, un hétéroaryle substitué ou non substitué, un hétéroaryle en C₂ à C₂₀ substitué ou non substitué, un alcoxy en C₁ à C₈ substitué ou non substitué, un alcoxy en C₁ à C₈ partiellement fluoré ou perfluoré, de préférence OCF₃, un alkylaryle partiellement fluoré ou perfluoré, un alkylaryle en C₆ à C₂₄ partiellement fluoré ou perfluoré, O, S, N ;
les substituants sur R¹ et R² étant indépendamment choisis dans un groupe comprenant un groupe électroattracteur, de préférence CN, un alkyle substitué ou non substitué, un alkyle en C₁ à C₈ substitué ou non substitué, un hétéroaryle substitué ou non substitué, un hétéroaryle en C₂ à C₂₀ substitué ou non substitué, un aryle substitué ou non substitué, un aryle en C₆ à C₂₄ substitué ou non substitué, un alkyle perfluoré, un alkyle perfluoré en C₁ à C₈, idéalement CF₃, NO₂, F ;
R¹ et R² formant éventuellement ensemble un carbocycle substitué ou non substitué ou un hétérocycle substitué ou non substitué, de préférence un carbocycle substitué ou non substitué ;
les substituants sur le cycle étant choisis dans un groupe comprenant un groupe électroattracteur, F, CN, un alkyle perfluoré en C₁ à C₈, de préférence un alcoxy en C₁ à C₈ perfluoré, OCF₃ ; un aryle en C₆ à C₁₈ substitué ou non substitué, un hétéroaryle en C₂ à C₁₈ substitué ou non substitué, un carbocyclène substitué ou non substitué, un carbocyclidène substitué ou non substitué, un alkylène substitué ou non substitué, un alkylidène substitué ou non substitué ;
les substituants étant choisis dans un groupe comprenant un groupe électroattracteur, un halogène, F, Cl, CN, un alkyle perfluoré, un alkyle perfluoré en C₁ à C₈, CF₃, un alkylaryle partiellement fluoré ou perfluoré, un alkylaryle en C₆ à C₁₈ partiellement fluoré ou perfluoré, un alcoxy perfluoré en C₁ à C₈, OCF₃ ;
les Y sont choisis indépendamment les uns des autres parmi N et CR^{a},
R^{a} est indépendamment choisi dans un groupe comprenant H, D, un groupe électroattracteur, CN, un alkyle en C₁ à C₈ substitué ou non substitué, alkyle perfluoré en C₁ à C₈, CF₃, un alcoxy perfluoré en C₁ à C₈, OCF₃ ;
les substituants sur R^{a} étant indépendamment choisis dans un groupe comprenant un groupe électroattracteur, CN, un halogène, Cl, F, un alkyle partiellement fluoré ou perfluoré, un alkyle en C₁ à C₁₀ partiellement fluoré ou perfluoré, CF₃, un alcoxy partiellement fluoré ou perfluoré, un alcoxy en C₁ à C₆ partiellement fluoré ou perfluoré, idéalement OCF₃, D et H ;
deux R^{a} formant éventuellement un carbocycle substitué ou non substitué ou un hétérocycle substitué ou non substitué, de préférence un carbocycle substitué ou non substitué ;
les substituants sur le cycle étant indépendamment choisis dans un groupe comprenant un groupe électroattracteur, F, CN, un alkyle perfluoré en C₁ à C₈, de préférence un alcoxy perfluoré en C₁ à C₈, OCF₃ ; un aryle en C₆ à C₁₈ substitué ou non substitué, un hétéroaryle en C₂ à C₁₈ substitué ou non substitué, un carbocyclène substitué ou non substitué, un carbocyclidène substitué ou non substitué, un alkylène substitué ou non substitué, un alkylidène substitué ou non substitué ;
deux Y formant éventuellement un carbocycle substitué ou non substitué ou un hétérocycle substitué ou non substitué, de préférence un carbocycle substitué ou non substitué ;
les substituants sur le cycle pouvant être un groupe électroattracteur, F, CN, un alkyle perfluoré en C₁ à C₈, de préférence un alcoxy perfluoré en C₁ à C₈, OCF₃ ; un aryle en C₆ à C₁₈ substitué ou non substitué, un hétéroaryle en C₂ à C₁₈ substitué ou non substitué, un carbocyclène substitué ou non substitué, un carbocyclidène substitué ou non substitué, un alkylène substitué, un alkylidène substitué ou non substitué ; 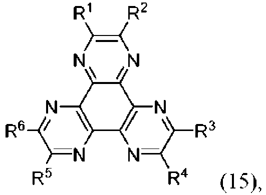 dans laquelle
R¹, R², R³, R⁴, R⁵ et R⁶ sont indépendamment choisis dans un groupe comprenant H, F, CN, CF₃ et NO₂, au moins un des R¹, R², R³, R⁴, R⁵ et R⁶ étant F, CN, CF₃ ou NO₂.

13. Écran OLED à matrice active selon l'une quelconque des revendications 1 à 12 précédentes, dans lequel le composé aromatique substitué ou non substitué qui comprend des noyaux condensés possède une des structures G1 à G4 : 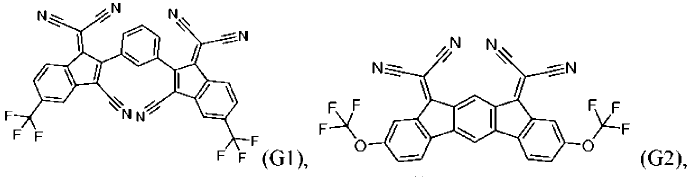 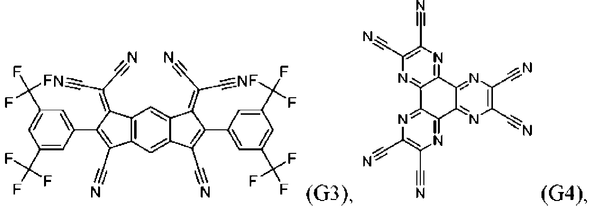 et

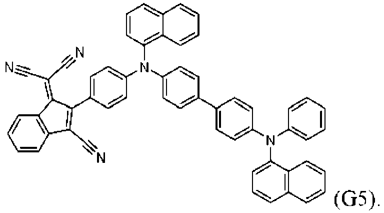

14. Écran OLED à matrice active selon l'une quelconque des revendications 1 à 13 précédentes, dans lequel au moins un R¹ et au moins un R² sont indépendamment choisis dans un groupe comprenant CN, OCF₃, CF₃, F, un alkyle perfluoré en C₁ à C₈, un aryle substitué en C₆ à C₂₄, le substituant étant F, CF₃, CN, un alkylène substitué en C₁ à C₈.

15. Écran OLED à matrice active selon les revendications 1 à 14, dans lequel la couche d'injection de trous commune (130) consiste en le dopant p organique ou la couche de transport de trous commune (140) comprend le dopant p organique et un matériau de transport de trous.

16. Écran OLED à matrice active selon les revendications 1 à 15, dans lequel la première couche semi-conductrice commune comprend au moins un dopant p organique en contact direct avec la couche anodique (120), la deuxième couche semi-conductrice commune étant disposée entre la première couche semi-conductrice et la couche d'émission.

17. Écran OLED à matrice active selon l'une quelconque des revendications 1 à 16 précédentes, dans lequel l'empilement commun de couches organiques comprend en outre une couche organique commune choisie dans le groupe comprenant une couche d'injection d'électrons commune, une couche de blocage de trous commune et/ou une couche de transport d'électrons (160), la couche d'injection d'électrons commune étant de préférence en contact direct avec la couche cathodique commune (190).

18. Écran OLED à matrice active selon l'une quelconque des revendications 1 à 17 précédentes, l'écran OLED à matrice active comprend un circuit de commande conçu pour commander séparément les pixels de la pluralité de pixels à diodes électroluminescentes organiques.

19. Écran OLED à matrice active selon l'une quelconque des revendications 1 à 18 précédentes, dans lequel la première couche semi-conductrice commune est partagée par la pluralité de pixels OLED et/ou la deuxième couche semi-conductrice commune est partagée par la pluralité de pixels OLED, de préférence toutes les couches semi-conductrices communes sont partagées par la pluralité de pixels OLED.
